# EUROPEAN PATENT APPLICATION

(11) **EP 3 689 887 A1**
(43) Date of publication of application: **05.08.2020**
(21) Application number: 18861506.6
(22) Date of filing: 19.09.2018
(51) Int. Cl.: C07F 15/00, C09K 11/06, H01L 51/50

(54) **COMPOSITION AND LIGHT-EMITTING DEVICE USING SAME**

(30) Priority: 29.09.2017 JP 2017189921
(71) Applicant: Sumitomo Chemical Company Limited, Tokyo 104-8260 (JP)
(72) Inventor: SASADA, Toshiaki, Tsukuba-shi Ibaraki 300-3294 (JP); ASADA, Kohei, Tsukuba-shi Ibaraki 300-3294 (JP); ABE, Taichi, Tsukuba-shi Ibaraki 300-3294 (JP); YOSHIOKA, Mayu, Tsukuba-shi Ibaraki 300-3294 (JP)
(74) Representative: J A Kemp LLP
(86) International application number: PCT/JP2018/034561
(87) International publication number: WO 2019/065388

(57) **Abstract**

A composition comprising a metal complex represented by the formula (1) and a metal complex represented by the formula (2): 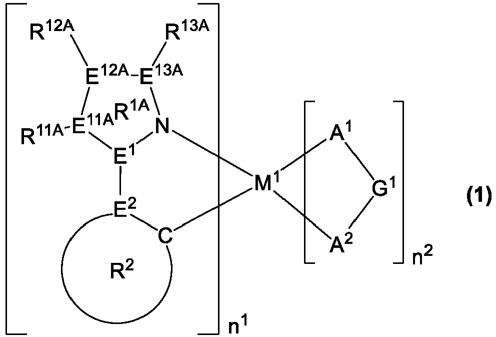 [wherein, M¹ represents an iridium atom and the like; n¹ represents an integer of 1 or more; n² represents an integer of 0 or more; Ring R^{1A} represents a triazole ring and the like; Ring R² represents an aromatic hydrocarbon ring and the like; R^{11A} to R^{13A} are each a hydrogen atom or a substituent; A¹-G¹-A² represents an anionic bidentate ligand. At least one of E^{11A} to E^{13A} is a nitrogen atom, and at least one of R^{11A} to R^{13A} bonding to the nitrogen atom is a group represented by the formula (Ar-1A).] 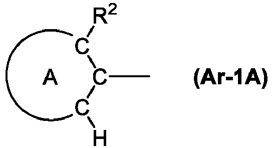 [wherein, Ring A represents an aromatic hydrocarbon ring and the like; R² represents a substituent.] 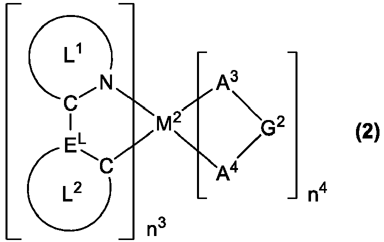 [wherein, M² represents an iridium atom and the like; n³ represents an integer of 1 or more; n⁴ represents an integer of 0 or more; E^{L} represents a carbon atom and the like; Ring L¹ represents a 6-membered aromatic hetero ring; Ring L² represents an aromatic hydrocarbon ring and the like; A³-G²-A⁴ represents an anionic bidentate ligand. At least one of Ring L¹ and Ring L² has a group represented by the formula (1-T).]

**-R^{1T}** **(1-T)**

[wherein, R^{1T} represents a substituent.].

## Description

### Technical Field

The present invention relates to a composition and a light emitting device using the same.

### Background Art

Light emitting devices such as organic electroluminescent devices and the like can be suitably used for display and lighting applications. As a light emitting material used for a light emitting layer of a light emitting device, for example, a composition containing a metal complex BC1 and a metal complex G2 is suggested (Patent Document 1).

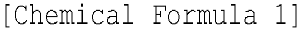

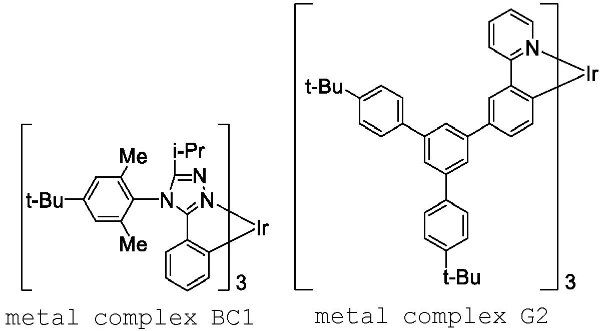

### [Prior Art Document]

### [Patent Document]

[Patent Document 1]International Publication WO 2016/185183

### Summary of the Invention

### Problem to be Solved by the Invention

However, a light emitting device produced by using this composition was not necessarily sufficient in luminance life.

Then, the present invention has an object of providing a composition which is useful for production of a light emitting device excellent in luminance life.

### Means for Solving the Problem

The present invention provides the following [1] to [15] .
[1] A composition comprising a metal complex represented by the formula (1) and a metal complex represented by the formula (2): 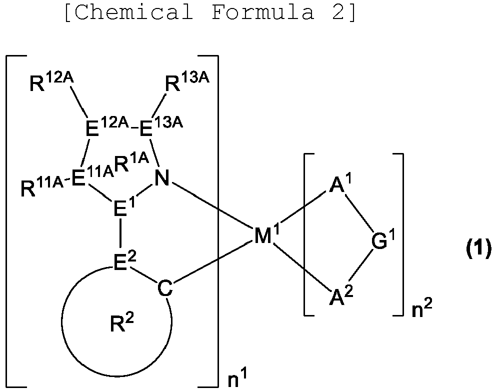 [wherein,
   M¹ represents a rhodium atom, a palladium atom, an iridium atom or a platinum atom.
   n¹ represents an integer of 1 or more and n² represents an integer of 0 or more, provided that n¹ + n² is 3 when M¹ is a rhodium atom or an iridium atom, while n¹ + n² = 2 when M¹ is a palladium atom or a platinum atom.
   Ring R^{1A} represents a diazole ring, a triazole ring or a tetrazole ring.
   Ring R² represents an aromatic hydrocarbon ring or an aromatic hetero ring, and the foregoing rings optionally have a substituent. When a plurality of the above-described substituents are present, they may be combined together to form a ring together with atoms to which they are attached. When a plurality of Ring R² are present, they may be the same or different.
   E¹, E², E^{11A}, E^{12A} and E^{13A} each independently represent a nitrogen atom or a carbon atom. When a plurality of E¹, E², E^{11A}, E^{12A} and E^{13A} are present, they may be the same or different at each occurrence. At least one of E¹ and E² is a carbon atom.
   R^{11A}, R^{12A} and R^{13A} each independently represent a hydrogen atom, an alkyl group, a cycloalkyl group, an alkoxy group, a cycloalkoxy group, an aryl group, an aryloxy group, a monovalent hetero ring group, a substituted amino group or a halogen atom, and the foregoing groups optionally have a substituent. When a plurality of R^{11A}, R^{12A} and R^{13A} are present, they may be the same or different at each occurrence.
   At least one of E^{11A}, E^{12A} and E^{13A} is a nitrogen atom, and at least one of R^{11A}, R^{12A} and R^{13A} bonding to the nitrogen atom is a group represented by the formula (Ar-1A) .
   R^{11A} and R^{12A} may be combined together to form a ring together with atoms to which they are attached. R^{12A} and R^{13A} may be combined together to form a ring together with atoms to which they are attached. The substituent which Ring R² optionally has and R^{11A} may be combined together to form a ring together with atoms to which they are attached.
   When E^{11A} is a nitrogen atom, R^{11A} may be present or absent. When E^{12A} is a nitrogen atom, R^{12A} may be present or absent. When E^{13A} is a nitrogen atom, R^{13A} may be present or absent.
   A¹-G¹-A² represents an anionic bidentate ligand. A¹ and A² each independently represent a carbon atom, an oxygen atom or a nitrogen atom, and these atoms may be ring-constituent atoms. G¹ represents a single bond or an atomic group constituting a bidentate ligand together with A¹ and A². When a plurality of A¹-G¹-A² are present, they may be the same or different.] 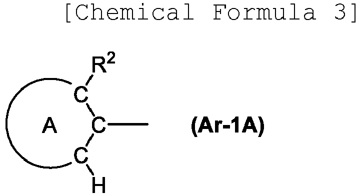
   [wherein,
   Ring A represents an aromatic hydrocarbon ring or an aromatic hetero ring, and the foregoing rings optionally have a substituent. When a plurality of the above-described substituents are present, they may be combined together to form a ring together with atoms to which they are attached.
   R² represents an alkyl group, a cycloalkyl group, an alkoxy group, a cycloalkoxy group, an aryl group, an aryloxy group, a monovalent hetero ring group, a substituted amino group or a halogen atom, and the foregoing groups optionally have a substituent.] 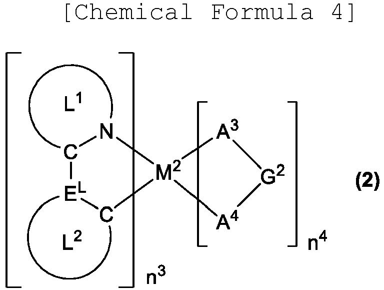
   [wherein,
   M² represents a rhodium atom, a palladium atom, an iridium atom or a platinum atom.
   n³ represents an integer of 1 or more and n⁴ represents an integer of 0 or more, provided that n³ + n⁴ = 3 when M² is a rhodium atom or an iridium atom, while n³ + n⁴ is 2 when M² is a palladium atom or a platinum atom.
   E^{L} represents a carbon atom or a nitrogen atom. When a plurality of E^{L} are present, they may be the same or different at each occurrence.
   Ring L¹ represents a 6-membered aromatic hetero ring, and this ring optionally has a substituent. When a plurality of the above-described substituents are present, they may be combined together to form a ring together with atoms to which they are attached. When a plurality of Ring L¹ are present, they may be the same or different.
   Ring L² represents an aromatic hydrocarbon ring or an aromatic hetero ring, and the foregoing rings optionally have a substituent. When a plurality of the above-described substituents are present, they may be combined together to form a ring together with atoms to which they are attached. When a plurality of Ring L² are present, they may be the same or different.
   The substituent which Ring L¹ optionally has and the substituent which Ring L² optionally has may be combined together to form a ring together with atoms to which they are attached.
   At least one of Ring L¹ and Ring L² has a group represented by the formula (1-T). When a plurality of the groups represented by the formula (1-T) are present, they may be the same or different.
   A³-G²-A⁴ represents an anionic bidentate ligand. A³ and A⁴ each independently represent a carbon atom, an oxygen atom or a nitrogen atom, and these atoms may be ring-constituent atoms. G² represents a single bond or an atomic group constituting a bidentate ligand together with A³ and A⁴. When a plurality of A³-G²-A⁴ are present, they may be the same or different.]

   [Chemical Formula 5] **-R^{1T} (1-T)**

   [wherein, R^{1T} represents an alkyl group, a cycloalkyl group, an alkoxy group, a cycloalkoxy group, an aryloxy group, an aryl group, a monovalent hetero ring group, a substituted amino group or a halogen atom, and the foregoing groups optionally have a substituent.].
[2] The composition according to [1], wherein
   the above-described metal complex represented by the formula (1) is a metal complex represented by the formula (1-A1) or the formula (1-A2): 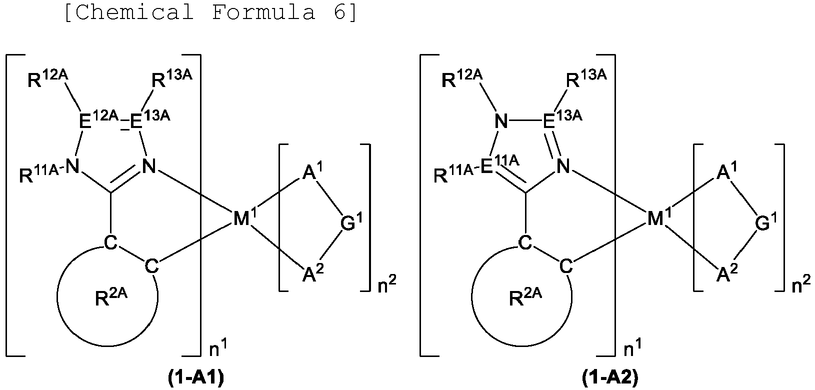
   [wherein, M¹, n¹, n², R^{11A}, R^{12A}, R^{13A}, E^{11A}, E^{12A}, E^{13A} and A¹-G¹-A² represent the same meaning as described above.
   Ring R^{2A} represents a benzene ring, a fluorene ring, a spirobifluorene ring, a dihydrophenanthrene ring, a pyridine ring, a diazabenzene ring, a carbazole ring, a dibenzofuran ring or a dibenzothiophene ring, and the foregoing rings optionally have a substituent. When a plurality of the above-described substituents are present, they may be combined together to form a ring together with atoms to which they are attached. When a plurality of Ring R^{2A} are present, they may be the same or different.
   The substituent which Ring R^{2A} optionally has and R^{11A} may be combined together to form a ring together with atoms to which they are attached.
   In the formula (1-A1), at least one of R^{11A} is the above-described group represented by the formula (Ar-1A), and in the formula (1-A2), at least one of R^{12A} is the above-described group represented by the formula (Ar-1A).].
[3] The composition according to [2], wherein
   the above-described metal complex represented by the formula (1-A1) is a metal complex represented by the formula (1-A1-1), the formula (1-A1-2) or the formula (1-A1-3) : 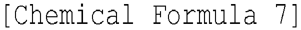 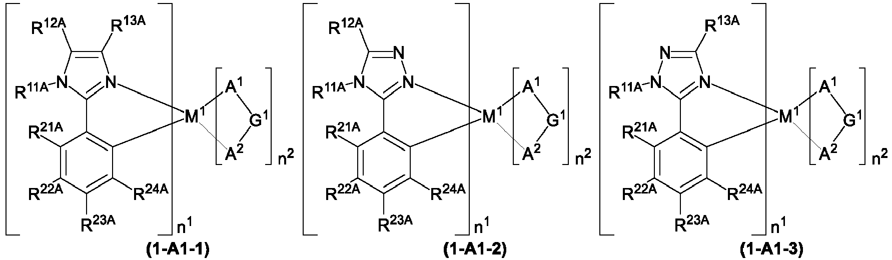
   [wherein, M¹ , n¹, n², R^{11A}, R^{12A}, R^{13A} and A¹-G¹-A² represent the same meaning as described above.
   R^{21A}, R^{22A}, R^{23A} and R^{24A} each independently represent a hydrogen atom, an alkyl group, a cycloalkyl group, an alkoxy group, a cycloalkoxy group, an aryl group, an aryloxy group, a monovalent hetero ring group, a substituted amino group or a halogen atom, and the foregoing groups optionally have a substituent. When a plurality of R^{21A}, R^{22A}, R^{23A} and R^{24A} are present, they may be the same or different at each occurrence. R^{21A} and R^{22A}, R^{22A} and R^{23A}, R^{23A} and R^{24A}, and, R^{11A} and R^{21A} each may be combined together to form a ring together with atoms to which they are attached.].
[4] The composition according to [2], wherein
   the above-described metal complex represented by the formula (1-A2) is a metal complex represented by the formula (1-A2-1) or the formula (1-A2-2): 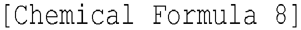 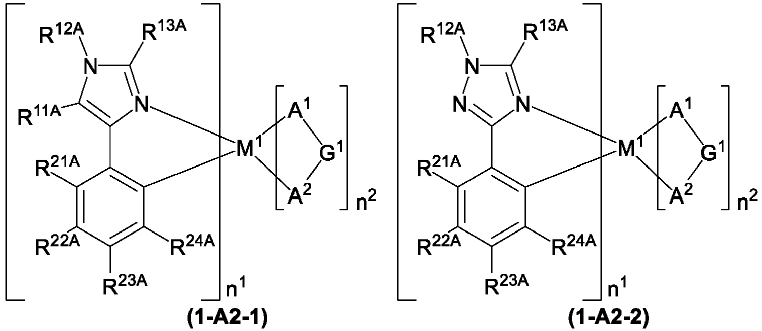
   [wherein, M¹, n¹, n², R^{11A}, R^{12A}, R^{13A} and A¹-G¹-A² represent the same meaning as described above.
   R^{21A}, R^{22A}, R^{23A} and R^{24A} each independently represent a hydrogen atom, an alkyl group, a cycloalkyl group, an alkoxy group, a cycloalkoxy group, an aryl group, an aryloxy group, a monovalent hetero ring group, a substituted amino group or a halogen atom, and the foregoing groups optionally have a substituent. When a plurality of R^{21A}, R^{22A}, R^{23A} and R^{24A} are present, they may be the same or different at each occurrence. R^{21A} and R^{22A}, R^{22A} and R^{23A}, R^{23A} and R^{24A}, and, R^{11A} and R^{21A} each may be combined together to form a ring together with atoms to which they are attached.].
[5] The light emitting device according to any one of [1] to [4], wherein
   the above-described group represented by formula (Ar-1A) is a group represented by the formula (Ar-2A): 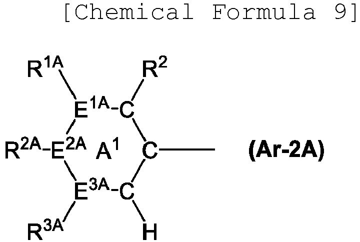
   [wherein, R² represents the same meaning as described above.
   Ring A¹ represents a benzene ring, a pyridine ring or a diazabenzene ring.
   E^{1A}, E^{2A} and E^{3A} each independently represent a nitrogen atom or a carbon atom. When E^{1A} is a nitrogen atom, R^{1A} is absent. When E^{2A} is a nitrogen atom, R^{2A} is absent. When E^{3A} is a nitrogen atom, R^{3A} is absent.
   R^{1A}, R^{2A} and R^{3A} each independently represent a hydrogen atom, an alkyl group, a cycloalkyl group, an alkoxy group, a cycloalkoxy group, an aryl group, an aryloxy group, a monovalent hetero ring group, a substituted amino group or a halogen atom, and the foregoing groups optionally have a substituent.
   R^{1A} and R^{2A}, and, R^{2A} and R^{3A} each may be combined together to form a ring together with atoms to which they are attached.].
[6] The light emitting device according to [5], wherein
   the above-described group represented by formula (Ar-2A) is a group represented by the formula (Ar-3A): 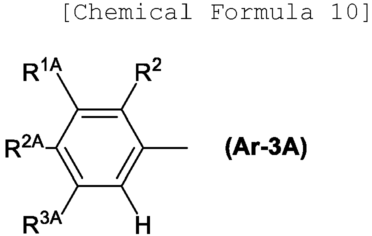 [wherein, R², R^{1A}, R^{2A} and R^{3A} represent the same meaning as described above.].
[7] The composition according to any one of [1] to [6], wherein
   the above-described metal complex represented by the formula (2) is a metal complex represented by the formula (2-B) : 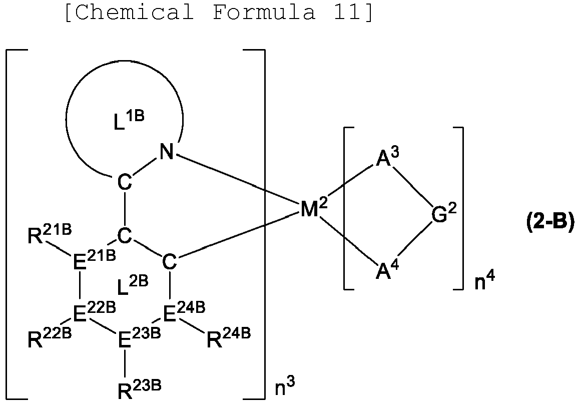 [wherein,
   M², n³, n⁴ and A³-G²-A⁴ represent the same meaning as described above.
   Ring L^{1B} represents a pyridine ring, a diazabenzene ring, an azanaphthalene ring or a diazanaphthalene ring, and the foregoing rings optionally have a substituent. When a plurality of the above-described substituents are present, they may be combined together to form a ring together with atoms to which they are attached. When a plurality of Ring L^{1B} are present, they may be the same or different.
   E^{21B}, E^{22B}, E^{23B} and E^{24B} each independently represent a nitrogen atom or a carbon atom. When a plurality of E^{21B}, E^{22B}, E^{23B} and E^{24B} are present, they may be the same or different at each occurrence. When E^{21B} is a nitrogen atom, R^{21B} is absent. When E^{22B} is a nitrogen atom, R^{22B} is absent. When E^{23B} is a nitrogen atom, R^{23B} is absent. When E^{24B} is a nitrogen atom, R^{24B} is absent.
   R^{21B}, R^{22B}, R^{23B} and R^{24B} each independently represent a hydrogen atom or the above-described group represented by the formula (1-T). When a plurality of R^{21B}, R^{22B}, R^{23B} and R^{24B} are present, they may be the same or different at each occurrence. R^{21B} and R^{22B}, R^{22B} and R^{23B}, R^{23B} and R^{24B}, and ,a substituent which Ring L^{1B} optionally has and R^{21B} each may be combined together to form a ring together with atoms to which they are attached. At least one of Ring L^{1B} has the group represented by the formula (1-T), or at least one of R^{21B}, R^{22B}, R^{23B} and R^{24B} is the above-described group represented by the formula (1-T).
   Ring L^{2B} represents a benzene ring, a pyridine ring or a diazabenzene ring.].
[8] The composition according to [7], wherein
   the above-described metal complex represented by the formula (2-B) is a metal complex represented by the formula (2-B1), the formula (2-B2), the formula (2-B3), the formula (2-B4) or the formula (2-B5): 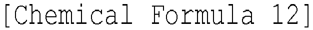 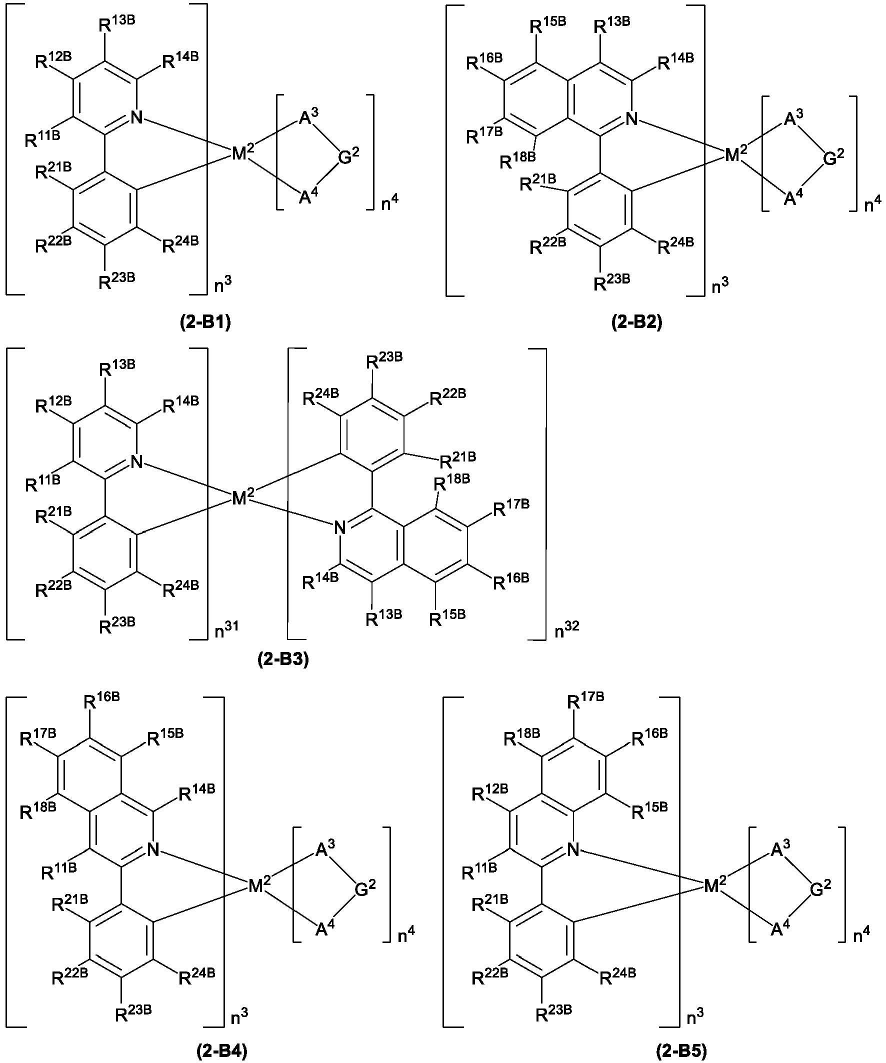 [wherein,
   M², n³, n⁴, R^{21B}, R^{22B}, R^{23B}, R^{24B} and A³-G²-A⁴ represent the same meaning as described above.
   n³¹ and n³² each independently represent an integer of 1 or more, provided that n³¹+n³² is 3 when M² is a rhodium atom or an iridium atom, while n³¹+n³² is 2 when M² is a palladium atom or a platinum atom.
   R^{11B}, R^{12B}, R^{13B}, R^{14B}, R^{15B}, R^{16B}, R^{17B} and R^{18B} each independently represent a hydrogen atom or the above-described group represented by the formula (1-T). When a plurality of R^{11B}, R^{12B}, R^{13B}, R^{14B}, R^{15B}, R^{16B}, R^{17B} and R^{18B} are present, they may be the same or different at each occurrence. At least one of R^{11B}, R^{12B}, R^{13B}, R^{14B}, R^{15B}, R^{16B}, R^{17B}, R^{18B}, R^{21B}, R^{22B}, R^{23B} and R^{24B} is the above-described group represented by the formula (1-T).
   In the formula (2-B1) and the formula (2-B3), R^{11B} and R^{12B}, R^{12B} and R^{13B}, R^{13B} and R^{14B}, and, R^{11B} and R^{21B} each may be combined together to form a ring together with atoms to which they are attached. In the formula (2-B2) and the formula (2-B3), R^{13B} and R^{14B}, R^{13B} and R^{15B}, R^{15B} and R^{16B}, R^{16B} and R^{17B}, R^{17B} and R^{18B}, and, R^{18B} and R^{21B} each may be combined together to form a ring together with atoms to which they are attached. In the formula (2-B4), R^{11B} and R^{18B}, R^{14B} and R^{15B}, R^{15B} and R^{16B}, R^{16B} and R^{17B}, R^{17B} and R^{18B}, and, R^{11B} and R^{21B} each may be combined together to form a ring together with atoms to which they are attached. In the formula (2-B5), R^{11B} and R^{12B}, R^{12B} and R^{18B}, R^{15B} and R^{16B}, R^{16B} and R^{17B}, R^{17B} and R^{18B}, and R^{11B} and R^{21B} each may be combined together to form a ring together with atoms to which they are attached.].
[9] The composition according to any one of [1] to [8], wherein
   the above-described R^{1T} is an alkyl group optionally having a substituent, a cycloalkyl group optionally having a substituent, a group represented by the formula (D-A), a group represented by the formula (D-B) or a group represented by the formula (D-C): 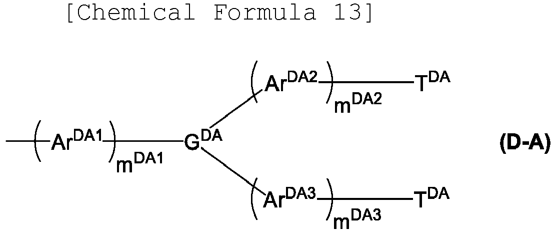 [wherein,
   m^{DA1}, m^{DA2} and m^{DA3} each independently represent an integer of 0 or more.
   G^{DA} represents a nitrogen atom, an aromatic hydrocarbon group or a hetero ring group, and the foregoing groups optionally have a substituent.
   Ar^{DA1}, Ar^{DA2} and Ar^{DA3} each independently represent an arylene group or a divalent hetero ring group, and the foregoing groups optionally have a substituent. When a plurality of Ar^{DA1}, Ar^{DA2} and Ar^{DA3} are present, they may be the same or different at each occurrence.
   T^{DA} represents an aryl group or a monovalent hetero ring group, and the foregoing groups optionally have a substituent. A plurality of T^{DA} may be the same or different.] 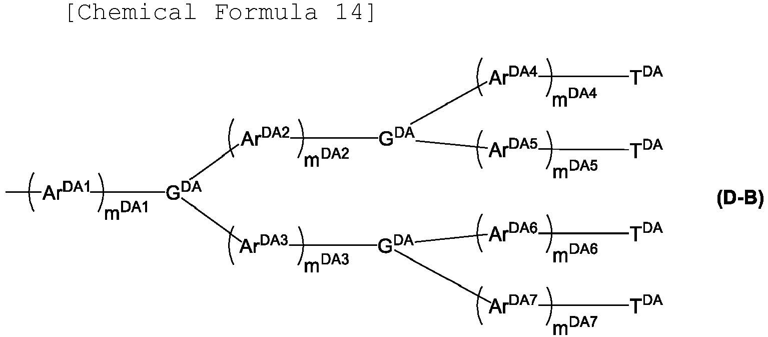
   [wherein,
   m^{DA1}, m^{DA2}, m^{DA3}, m^{DA4}, m^{DA5}, m^{DA6} and m^{DA7} each independently represent an integer of 0 or more.
   G^{DA} represents a nitrogen atom, an aromatic hydrocarbon group or a hetero ring group, and the foregoing groups optionally have a substituent. A plurality of G^{DA} may be the same or different.
   Ar^{DA1}, Ar^{DA2}, Ar^{DA3}, Ar^{DA4}, Ar^{DA5}, Ar^{DA6} and Ar^{DA7} each independently represent an arylene group or a divalent hetero ring group, and the foregoing groups optionally have a substituent. When a plurality of Ar^{DA1}, Ar^{DA2}, Ar^{DA3}, Ar^{DA4}, Ar^{DA5}, Ar^{DA6} and Ar^{DA7} are present, they may be the same or different at each occurrence.
   T^{DA} represents an aryl group or a monovalent hetero ring group, and the foregoing groups optionally have a substituent. A plurality of T^{DA} may be the same or different.] 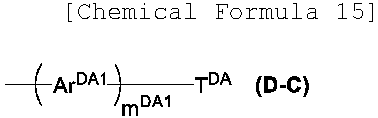
   [wherein,
   m^{DA1} represents an integer of 0 or more.
   Ar^{DA1} represents an arylene group or a divalent hetero ring group, and the foregoing groups optionally have a substituent. When a plurality of Ar^{DA1} are present, they may be the same or different.
   T^{DA} represents an aryl group or a monovalent hetero ring group, and the foregoing groups optionally have a substituent.].
[10] The composition according to any one of [1] to [9], wherein
   the maximum peak wavelength of the emission spectrum of the above-described metal complex represented by the formula (1) is 380 nm or more and less than 495 nm, and the maximum peak wavelength of the emission spectrum of the above-described metal complex represented by the formula (2) is 495 nm or more and less than 750 nm.
[11] The composition according to any one of [1] to [10], comprising two or more of the above-described metal complexes represented by the formula (2).
[12] The composition according to any one of [1] to [11], wherein
   the total content of the above-described metal complexes represented by the formula (2) is 0.01 part by mass or more and 50 parts by mass or less when the total content of the above-described metal complexes represented by the formula (1) is taken as 100 parts by mass.
[13] The composition according to any one of [1] to [12], further comprising a compound represented by the formula (H-1): 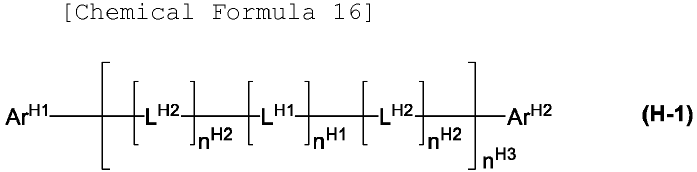 [wherein,
   Ar^{H1} and Ar^{H2} each independently represent an aryl group or a monovalent hetero ring group, and the foregoing groups optionally have a substituent.
   n^{H1} and n^{H2} each independently represent 0 or 1. When a plurality of n^{H1} are present, they may be the same or different. A plurality of n^{H2} may be the same or different.
   n^{H3} represents an integer of 0 or more and 10 or less.
   L^{H1} represents an arylene group, a divalent hetero ring group or a group represented by -[C(R^{H11})₂]n^{H11}-, and the foregoing groups optionally have a substituent. When a plurality of L^{H1} are present, they may be the same or different. n^{H11} represents an integer of 1 or more and 10 or less. R^{H11} represents a hydrogen atom, an alkyl group, a cycloalkyl group, an alkoxy group, a cycloalkoxy group, an aryl group or a monovalent hetero ring group, and the foregoing groups optionally have a substituent. A plurality of R^{H11} may be the same or different, and they may be combined together to form a ring together with carbon atoms to which they are attached.
   L^{H2} represents a group represented by -N (-L^{H21}-R^{H21})-. When a plurality of L^{H2} are present, they may be the same or different. L^{H21} represents a single bond, an arylene group or a divalent hetero ring group, and the foregoing groups optionally have a substituent. R^{H21} represents a hydrogen atom, an alkyl group, a cycloalkyl group, an aryl group or a monovalent hetero ring group, and the foregoing groups optionally have a substituent.].
[14] The composition according to any one of [1] to [13], further comprising at least one selected from group consisting of a hole transporting material, a hole injection material, an electron transporting material, electron an injection material, a light emitting material, an antioxidant and a solvent.
[15] A light emitting device comprising the composition according to any one of [1] to [13].

### Effect of the Invention

According to the present invention, a composition which is useful for production of a light emitting device excellent in luminance life can be provided. Further, according to the present invention, a light emitting device comprising this composition can be provided.

### Modes for Carrying Out the Invention

Suitable embodiments of the present invention will be illustrated in detail below.

### <Explanation of common terms>

Terms commonly used in the present specification have the following meanings unless otherwise stated.

Me represents a methyl group, Et represents an ethyl group, Bu represents a butyl group, i-Pr represents an isopropyl group and t-Bu represents a tert-butyl group.

A hydrogen atom may be a heavy hydrogen atom or a light hydrogen atom.

In the formula representing a metal complex, the solid line representing a bond with a metal means an ionic bond, a covalent bond or a coordination bond.

"Polymer compound" means a polymer having molecular weight distribution and having a polystyrene-equivalent number-average molecular weight of 1×10³ to 1×10⁸.

"Low molecular compound" means a compound having no molecular weight distribution and having a molecular weight of 1×10⁴ or less.

"Constitutional unit" means a unit occurring once or more times in the polymer compound.

"Alkyl group" may be any of linear and branched. The number of carbon atoms of the linear alkyl group, not including the number of carbon atoms of the substituent, is usually 1 to 50, preferably 3 to 30, more preferably 4 to 20. The number of carbon atoms of the branched alkyl group, not including the number of carbon atoms of the substituent, is usually 3 to 50, preferably 3 to 30, more preferably 4 to 20.

The alkyl group optionally has a substituent and examples thereof include, for example, a methyl group, an ethyl group, a propyl group, an isopropyl group, a butyl group, a 2-butyl group, an isobutyl group, a tert-butyl group, a pentyl group, an isoamyl group, a 2-ethylbutyl group, a hexyl group, a heptyl group, an octyl group, a 2-ethylhexyl group, a 3-propylheptyl group, a decyl group, a 3,7-dimethyloctyl group, a 2-ethyloctyl group, a 2-hexyldecyl group and a dodecyl group, and groups obtained by substituting a hydrogen atom in these groups with a cycloalkyl group, an alkoxy group, a cycloalkoxy group, an aryl group, a fluorine atom and the like (for example, a trifluoromethyl group, a pentafluoroethyl group, a perfluorobutyl group, a perfluorohexyl group, a perfluorooctyl group, a 3-phenylpropyl group, a 3 (4-methylphenyl)propyl group, a 3 (3,5-di-hexylphenyl)propyl group, a 6-ethyloxyhexyl group).

The number of carbon atoms of "cycloalkyl group", not including the number of carbon atoms of the substituent, is usually 3 to 50, preferably 3 to 30, more preferably 4 to 20.

The cycloalkyl group optionally has a substituent and examples thereof include a cyclohexyl group, a cyclohexylmethyl group and a cyclohexylethyl group.

"Aryl group" means an atomic group remaining after removing from an aromatic hydrocarbon one hydrogen atom bonding directly to a carbon atom constituting the ring. The number of carbon atoms of the aryl group, not including the number of carbon atoms of the substituent, is usually 6 to 60, preferably 6 to 20, more preferably 6 to 10.

The aryl group optionally has a substituent and examples thereof include a phenyl group, a 1-naphthyl group, a 2-naphthyl group, a 1-anthracenyl group, a 2-anthracenyl group, a 9-anthracenyl group, a 1-pyrenyl group, a 2-pyrenyl group, a 4-pyrenyl group, a 2-fluorenyl group, a 3-fluorenyl group, a 4-fluorenyl group, a 2-phenylphenyl group, a 3-phenylphenyl group and a 4-phenylphenyl group, and groups obtained by substituting a hydrogen atom in these groups with an alkyl group, a cycloalkyl group, an alkoxy group, a cycloalkoxy group, an aryl group, a fluorine atom and the like.

"Alkoxy group" may be any of linear and branched. The number of carbon atoms of the linear alkoxy group, not including the number of carbon atoms of the substituent, is usually 1 to 40, preferably 4 to 10. The number of carbon atoms of the branched alkoxy group, not including the number of carbon atoms of the substituent, is usually 3 to 40, preferably 4 to 10.

The alkoxy group optionally has a substituent and examples thereof include a methoxy group, an ethoxy group, a propyloxy group, an isopropyloxy group, a butyloxy group, an isobutyloxy group, a tert-butyloxy group, a pentyloxy group, a hexyloxy group, a heptyloxy group, an octyloxy group, a 2-ethylhexyloxy group, a nonyloxy group, a decyloxy group, a 3,7-dimethyloctyloxy group and a lauryloxy group, and groups obtained by substituting a hydrogen atom in these groups with a cycloalkyl group, an alkoxy group, a cycloalkoxy group, an aryl group, a fluorine atom or the like.

The number of carbon atoms of the "cycloalkoxy group", not including the number of carbon atoms of the substituent, is usually 3 to 40, preferably 4 to 10.

The cycloalkoxy group optionally has a substituent and examples thereof include a cyclohexyloxy group.

The number of carbon atoms of the "aryloxy group", not including the number of carbon atoms of the substituent, is usually 6 to 60, preferably 6 to 48.

The aryloxy group optionally has a substituent and examples thereof include a phenoxy group, a 1-naphthyloxy group, a 2-naphthyloxy group, a 1-anthracenyloxy group, a 9-anthracenyloxy group and a 1-pyrenyloxy group, and groups obtained by substituting a hydrogen atom in these groups with an alkyl group, a cycloalkyl group, an alkoxy group, a cycloalkoxy group, a fluorine atom or the like.

"p-valent hetero ring group" (p represents an integer of 1 or more) means an atomic group remaining after removing from a heterocyclic compound p hydrogen atoms among hydrogen atoms bonding directly to carbon atoms or hetero atoms constituting the ring. Of the p-valent hetero ring groups, "p-valent aromatic hetero ring group" as an atomic group remaining after removing from an aromatic heterocyclic compound p hydrogen atoms among hydrogen atoms bonding directly to carbon atoms or hetero atoms constituting the ring is preferable.

"Aromatic heterocyclic compound " means a compound in which the hetero ring itself shows aromaticity such as oxadiazole, thiadiazole, thiazole, oxazole, thiophene, pyrrole, phosphole, furan, pyridine, pyrazine, pyrimidine, triazine, pyridazine, quinoline, isoquinoline, carbazole, dibenzophosphole and the like, and a compound in which an aromatic ring is condensed to the hetero ring even if the hetero ring itself shows no aromaticity such as phenoxazine, phenothiazine, dibenzoborole, dibenzosilole, benzopyran and the like.

The number of carbon atoms of the monovalent hetero ring group, not including the number of carbon atoms of the substituent, is usually 2 to 60, preferably 4 to 20.

The monovalent hetero ring group optionally has a substituent and examples thereof include a thienyl group, a pyrrolyl group, a furyl group, a pyridinyl group, a piperidinyl group, a quinolinyl group, an isoquinolinyl group, a pyrimidinyl group and a triazinyl group, and groups obtained by substituting a hydrogen atom in these groups with an alkyl group, a cycloalkyl group, an alkoxy group, a cycloalkoxy group or the like.

"Halogen atom" denotes a fluorine atom, a chlorine atom, a bromine atom or an iodine atom.

"Amino group" optionally has a substituent, and a substituted amino group is preferred. The substituent which the amino group has is preferably an alkyl group, a cycloalkyl group, an aryl group or a monovalent hetero ring group.

The substituted amino group includes, for example, a dialkylamino group, a dicycloalkylamino group and a diarylamino group.

The amino group includes, for example, a dimethylamino group, a diethylamino group, a diphenylamino group, a bis(4-methylphenyl)amino group, a bis(4-tert-butylphenyl)amino group and a bis(3,5-di-tert-butylphenyl)amino group.

"Alkenyl group" may be any of linear and branched. The number of carbon atoms of the linear alkenyl group, not including the number of carbon atoms of the substituent, is usually 2 to 30, preferably 3 to 20. The number of carbon atoms of the branched alkenyl group, not including the number of carbon atoms of the substituent, is usually 3 to 30, preferably 4 to 20.

The number of carbon atoms of the "cycloalkenyl group", not including the number of carbon atoms of the substituent, is usually 3 to 30, preferably 4 to 20.

The alkenyl group and the cycloalkenyl group optionally have a substituent and examples thereof include a vinyl group, a 1-propenyl group, a 2-propenyl group, a 2-butenyl group, a 3-butenyl group, a 3-pentenyl group, a 4-pentenyl group, a 1-hexenyl group, a 5-hexenyl group and a 7-octenyl group, and these groups having a substituent.

"Alkynyl group" may be any of linear and branched. The number of carbon atoms of the alkynyl group, not including the number of carbon atoms of the substituent, is usually 2 to 20, preferably 3 to 20. The number of carbon atoms of the branched alkynyl group, not including the number of carbon atoms of the substituent, is usually 4 to 30, preferably 4 to 20.

The number of carbon atoms of the "cycloalkynyl group", not including the number of carbon atoms of the substituent, is usually 4 to 30, preferably 4 to 20.

The alkynyl group and the cycloalkynyl group optionally have a substituent and examples thereof include an ethynyl group, a 1-propynyl group, a 2-propynyl group, a 2-butynyl group, a 3-butynyl group, a 3-pentynyl group, a 4-pentynyl group, a 1-hexynyl group and a 5-hexynyl group, and these groups having a substituent.

"Arylene group" means an atomic group remaining after removing from an aromatic hydrocarbon two hydrogen atoms bonding directly to carbon atoms constituting the ring. The number of carbon atoms of the arylene group, not including the number of carbon atoms of the substituent, is usually 6 to 60, preferably 6 to 30, more preferably 6 to 18.

The arylene group optionally has a substituent and examples thereof include a phenylene group, a naphthalenediyl group, an anthracenediyl group, a phenanthrenedilyl group, a dihydrophenanthrenedilyl group, a naphthacenediyl group, a fluorenediyl group, a pyrenediyl group, a perylenediyl group and a chrysenediyl group, and these groups having a substituent, and groups represented by the formula (A-1) to the formula (A-20) are preferable. The arylene group includes groups obtained by bonding a plurality of these groups. 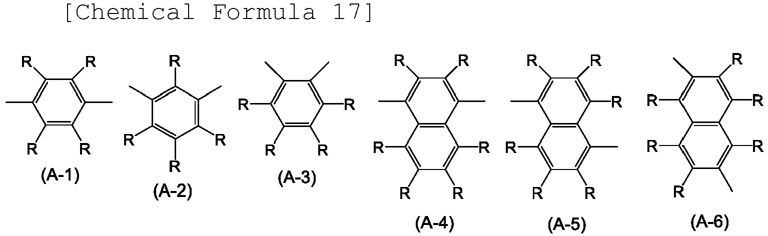 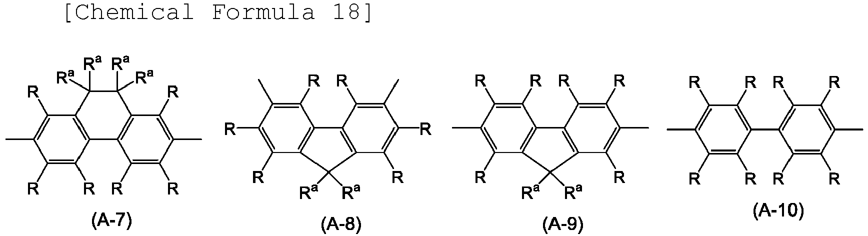 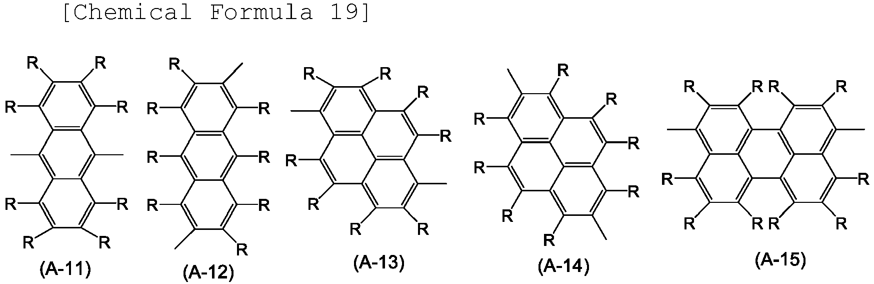 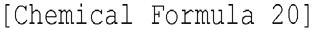 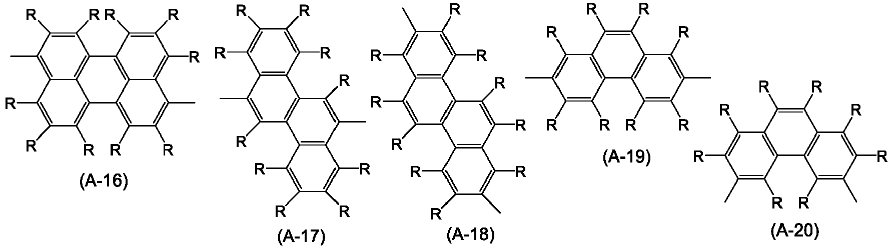 [wherein, R and R^{a} each independently represent a hydrogen atom, an alkyl group, a cycloalkyl group, an aryl group or a monovalent hetero ring group. A plurality of R and R^{a} each may be the same or different, and the plurality of R^{a} may be combined together to form a ring together with atoms to which they are attached.]

The number of carbon atoms of the divalent hetero ring group, not including the number of carbon atoms of the substituent, is usually 2 to 60, preferably 3 to 20, more preferably 4 to 15.

The divalent hetero ring group optionally has a substituent and examples thereof include divalent groups obtained by removing from pyridine, diazabenzene, triazine, azanaphthalene, diazanaphthalene, carbazole, dibenzofuran, dibenzothiophene, dibenzosilole, phenoxazine, phenothiazine, acridine, dihydroacridine, furan, thiophene, azole, diazole and triazole two hydrogen atoms among hydrogen atoms bonding directly to carbon atoms or hetero atoms constituting the ring, preferably groups represented by the formula (AA-1) to the formula (AA-34). The divalent hetero ring group includes groups obtained by bonding a plurality of these groups. 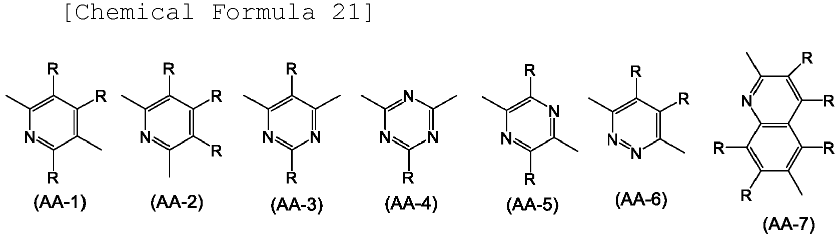 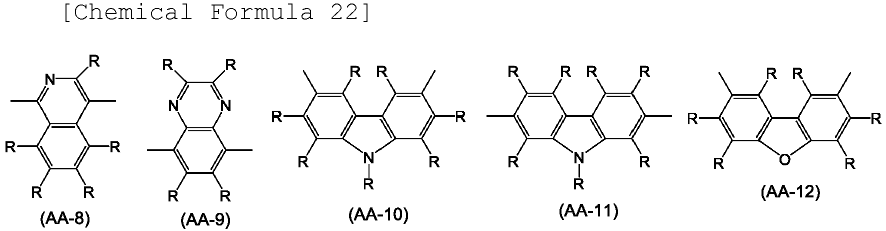 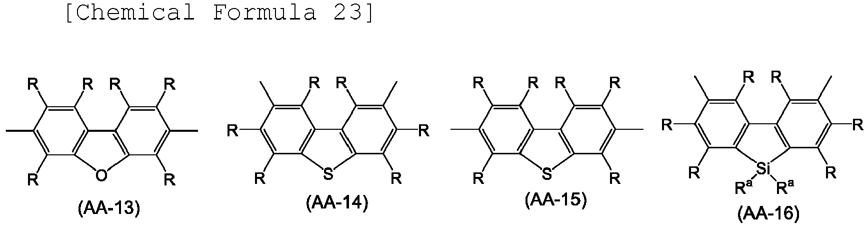 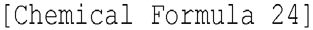 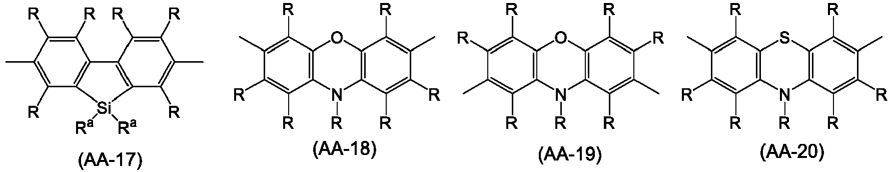 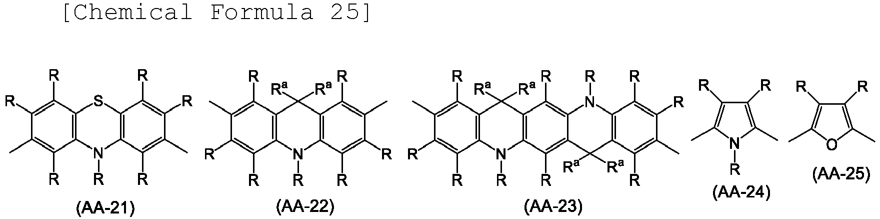 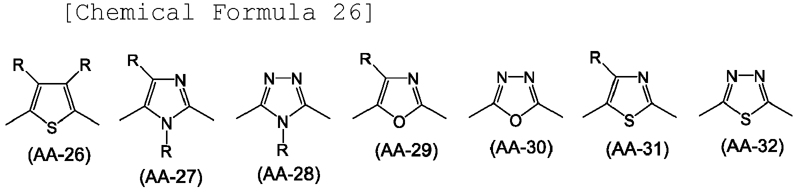 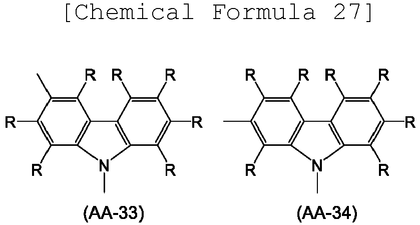 [wherein, R and R^{a} represent the same meaning as described above.]

"Crosslinking group" refers to a group capable of generating a new bond by being subjected to a heating treatment, an ultraviolet irradiation treatment, a near-ultraviolet irradiation treatment, a visible light irradiation treatment, an infrared irradiation treatment, a radical reaction and the like, and is preferably a group represented by any of the formula (B-1) to the formula (B-17). The foregoing groups optionally have a substituent.

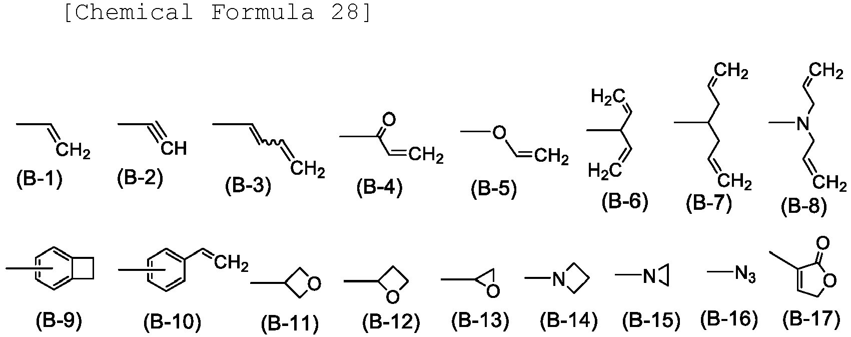

"Substituent" denotes a halogen atom, a cyano group, an alkyl group, a cycloalkyl group, an aryl group, a monovalent hetero ring group, an alkoxy group, a cycloalkoxy group, an aryloxy group, an amino group, a substituted amino group, an alkenyl group, a cycloalkenyl group, an alkynyl group or a cycloalkynyl group. The substituent may also be a crosslinking group.

### <Metal complex represented by the formula (1)>

The metal complex represented by the formula (1) is usually a metal complex showing phosphorescence at room temperature (25°C), preferably a metal complex showing light emission from triplet excited state at room temperature.

M¹ is preferably an iridium atom or a platinum atom, more preferably an iridium atom, since a light emitting device containing the composition of the present invention (hereinafter, referred to as "the light emitting device of the present invention") is more excellent in luminance life.

When M¹ is a rhodium atom or an iridium atom, n¹ is preferably 2 or 3, more preferably 3.

When M¹ is a palladium atom or a platinum atom, n¹ is preferably 2.

E¹ and E² are each preferably a carbon atom.

When Ring R^{1A} is a diazole ring, Ring R^{1A} is preferably an imidazole ring in which E^{11A} is a nitrogen atom, or an imidazole ring in which E^{12A} is a nitrogen atom, more preferably an imidazole ring in which E^{11A} is a nitrogen atom.

When Ring R^{1A} is a triazole ring, Ring R^{1A} is preferably a triazole ring in which E^{11A} and E^{12A} are each a nitrogen atom, or a triazole ring in which E^{11A} and E^{13A} are each a nitrogen atom, more preferably a triazole ring in which E^{11A} and E^{13A} are each a nitrogen atom.

When Ring R^{1A} is a tetrazole ring, Ring R^{1A} is preferably a tetrazole ring in which E^{11A} to E^{13A} are each a nitrogen atom.

Ring R^{1A} is preferably a diazole ring or a triazole ring, more preferably a triazole ring, since the light emitting device of the present invention is more excellent in luminance life.

When E^{11A} is a nitrogen atom and R^{11A} is present, R^{11A} is preferably an alkyl group, a cycloalkyl group, an aryl group or a monovalent hetero ring group, more preferably an aryl group or a monovalent hetero ring group, further preferably an aryl group, and the foregoing groups optionally have a substituent.

When E^{11A} is a carbon atom, R^{11A} is preferably a hydrogen atom, an alkyl group, a cycloalkyl group, an aryl group, a monovalent hetero ring group or a substituted amino group, more preferably a hydrogen atom, an alkyl group, a cycloalkyl group or an aryl group, further preferably a hydrogen atom or an alkyl group, and the foregoing groups optionally have a substituent.

When E^{12A} is a nitrogen atom and R^{12A} is present, R^{12A} is preferably an alkyl group, a cycloalkyl group, an aryl group or a monovalent hetero ring group, more preferably an aryl group or a monovalent hetero ring group, further preferably an aryl group, and the foregoing groups optionally have a substituent.

When E^{12A} is a carbon atom, R^{12A} is preferably a hydrogen atom, an alkyl group, a cycloalkyl group, an aryl group, a monovalent hetero ring group or a substituted amino group, more preferably a hydrogen atom, an alkyl group, a cycloalkyl group or an aryl group, further preferably a hydrogen atom or an alkyl group, and the foregoing groups optionally have a substituent.

When E^{13a} is a nitrogen atom and R^{13A} is present, R^{13A} is preferably an alkyl group, a cycloalkyl group, an aryl group or a monovalent hetero ring group, more preferably an aryl group or a monovalent hetero ring group, further preferably an aryl group, and the foregoing groups optionally have a substituent.

When E^{13a} is a carbon atom, R^{13A} is preferably a hydrogen atom, an alkyl group, a cycloalkyl group, an aryl group, a monovalent hetero ring group or a substituted amino group, more preferably a hydrogen atom, an alkyl group, a cycloalkyl group or an aryl group, further preferably a hydrogen atom or an alkyl group, and the foregoing groups optionally have a substituent.

The aryl group represented by R^{11A} to R^{13A} is preferably a phenyl group, a naphthyl group, a phenanthrenyl group, a dihydrophenanthrenyl group, a fluorenyl group or a spirobifluorenyl group, more preferably a phenyl group, a fluorenyl group or a spirobifluorenyl group, further preferably a phenyl group, and the foregoing groups optionally have a substituent.

The monovalent hetero ring group represented by R^{11A} to R^{13A} is preferably a pyridyl group, a pyrimidinyl group, a triazinyl group, a quinolinyl group, an isoquinolinyl group, a dibenzofuranyl group, a dibenzothienyl group, a carbazolyl group, an azacarbazolyl group, a diazacarbazolyl group, a phenoxazinyl group or a phenothiazinyl group, more preferably a pyridyl group, a pyrimidinyl group, a triazinyl group, a dibenzofuranyl group, a dibenzothienyl group or a carbazolyl group, further preferably a pyridyl group, a pyrimidinyl group or a triazinyl group, and the foregoing groups optionally have a substituent.

In the substituted amino group represented by R^{11A} to R^{13A}, the substituent which an amino group has is preferably an aryl group or a monovalent hetero ring group, more preferably an aryl group, and the foregoing groups optionally further have a substituent. The examples and preferable ranges of the aryl group and the monovalent hetero ring group as the substituent which an amino group has are the same as the examples and preferable ranges of the aryl group and the monovalent hetero ring group represented by R^{11A} to R^{13A}.

The substituent which R^{11A} to R^{13A} optionally have is preferably an alkyl group, a cycloalkyl group, an alkoxy group, a cycloalkoxy group, an aryl group, an aryloxy group, a monovalent hetero ring group, a substituted amino group or a halogen atom, more preferably an alkyl group, a cycloalkyl group, an aryl group, a monovalent hetero ring group or a substituted amino group, further preferably an alkyl group, a cycloalkyl group or an aryl group, particularly preferably an alkyl group, and the foregoing groups optionally further have a substituent.

The substituent which the substituent which R^{11A} to R^{13A} optionally have optionally further has is preferably an alkyl group, a cycloalkyl group, an alkoxy group, a cycloalkoxy group, an aryl group, an aryloxy group, a monovalent hetero ring group, a substituted amino group or a halogen atom, more preferably an alkyl group, a cycloalkyl group, an aryl group, a monovalent hetero ring group or a substituted amino group, further preferably an alkyl group or a cycloalkyl group. The foregoing groups optionally further have a substituent, but it is preferable that they do not further have a substituent.

The aryl group, the monovalent hetero ring group or the substituted amino group represented by R^{11A} to R^{13A} is preferably a group represented by the formula (D-A) to the formula (D-C), more preferably a group represented by the formula (D-A) or the formula (D-C), further preferably a group represented by the formula (D-C), since the light emitting device of the present invention is more excellent in luminance life.

### [Groups represented by the formula (D-A) to the formula (D-C)]

m^{DA1} to m^{DA7} are each usually an integer of 10 or less, preferably an integer of 5 or less, more preferably an integer of 2 or less, further preferably 0 or 1. It is preferable that m^{DA2} to m^{DA7} represent the same integer, it is more preferable that m^{DA1} to m^{DA7} represent the same integer.

G^{DA} is preferably an aromatic hydrocarbon group or a hetero ring group, more preferably a group obtained by removing from a benzene ring, a pyridine ring, a pyrimidine ring, a triazine ring or a carbazole ring three hydrogen atoms directly bonding to carbon atoms or nitrogen atoms constituting the ring, and the foregoing groups optionally have a substituent.

The substituent which G^{DA} optionally has is preferably an alkyl group, a cycloalkyl group, an alkoxy group, a cycloalkoxy group, an aryl group or a monovalent hetero ring group, more preferably an alkyl group, a cycloalkyl group, an alkoxy group or a cycloalkoxy group, further preferably an alkyl group or a cycloalkyl group. The foregoing groups optionally further have a substituent, but it is preferable that they do not further have a substituent.

G^{DA} is preferably a group represented by the formula (GDA-11) to the formula (GDA-15), more preferably a group represented by the formula (GDA-11) to the formula (GDA-14), further preferably a group represented by the formula (GDA-11) or the formula (GDA-14), particularly a group represented by the formula (GDA-11). 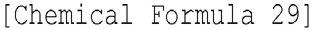 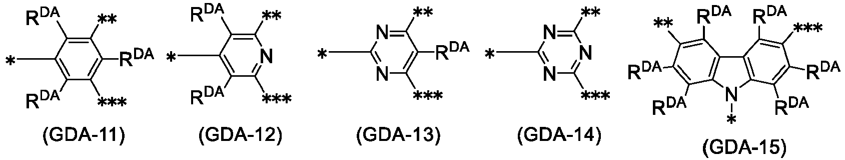 [wherein,
* represents a bond to Ar^{DA1} in the formula (D-A), to Ar^{DA1} in the formula (D-B), to Ar^{DA2} in the formula (D-B) or to Ar^{DA3} in the formula (D-B) .
** represents a bond to Ar^{DA2} in the formula (D-A), to Ar^{DA2} in the formula (D-B), to Ar^{DA4} in the formula (D-B) or to Ar^{DA6} in the formula (D-B) .
*** represents a bond to Ar^{DA3} in the formula (D-A), to Ar^{DA3} in the formula (D-B), to Ar^{DA5} in the formula (D-B) or to Ar^{DA7} in the formula (D-B).
R^{DA} represents a hydrogen atom, an alkyl group, a cycloalkyl group, an alkoxy group, a cycloalkoxy group, an aryl group or a monovalent hetero ring group, and the foregoing groups optionally further have a substituent. When a plurality of R^{DA} are present, they may be the same or different.]

R^{DA} is preferably a hydrogen atom, an alkyl group, a cycloalkyl group, an alkoxy group or a cycloalkoxy group, more preferably a hydrogen atom, an alkyl group or a cycloalkyl group, and the foregoing groups optionally have a substituent.

Ar^{DA1} to Ar^{DA7} are each preferably a phenylene group, a fluorenediyl group or a carbazolediyl group, more preferably a group represented by the formula (ArDA-1) to the formula (ArDA-6), further preferably a group represented by the formula (ArDA-1) to the formula (ArDA-3), particularly preferably a group represented by the formula (ArDA-1), and the foregoing groups optionally have a substituent. 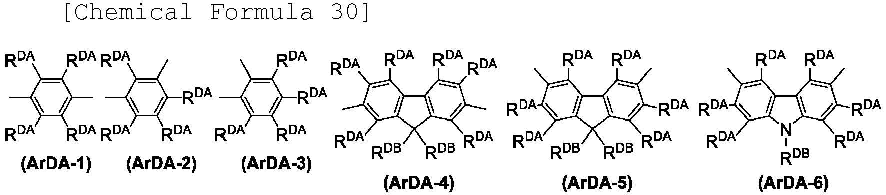 [wherein,
R^{DA} represents the same meaning as described above.
R^{DB} represents a hydrogen atom, an alkyl group, a cycloalkyl group, an aryl group or a monovalent hetero ring group, and the foregoing groups optionally have a substituent. When a plurality of R^{DB} are present, they may be the same or different, and they may be combined together to form a ring together with carbon atoms to which they are attached.]

R^{DB} is preferably an alkyl group, a cycloalkyl group, an aryl group or a monovalent hetero ring group, more preferably an aryl group or a monovalent hetero ring group, further preferably an aryl group, and the foregoing groups optionally have a substituent.

The examples and preferable ranges of the substituent which Ar^{DA1} to Ar^{DA7}, R^{DA} and R^{DB} optionally have are the same as the examples and preferable ranges of the substituent which G^{DA} optionally has.

T^{DA} is preferably a group represented by the formula (TDA-1) to the formula (TDA-4), more preferably a group represented by the formula (TDA-1) or the formula (TDA-3), further preferably a group represented by the formula (TDA-1) . 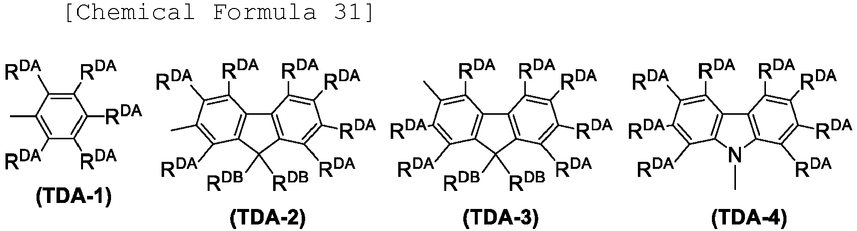 [wherein, R^{DA} and R^{DB} represent the same meaning as described above.]

The group represented by the formula (D-A) is preferably a group represented by the formula (D-A1) to the formula (D-A5), more preferably a group represented by the formula (D-A1), the formula (D-A3) or the formula (D-A5), further preferably a group represented by the formula (D-A1). 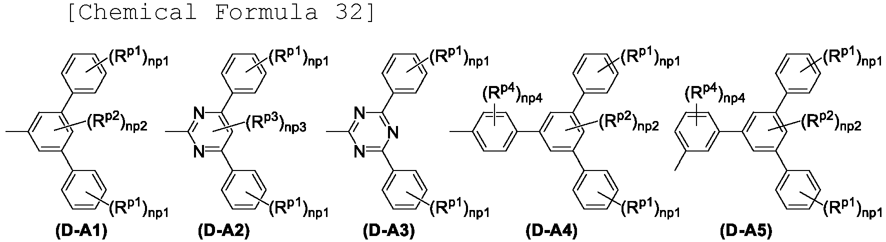 [wherein,
R^{p1} to R^{p4} each independently represent an alkyl group, a cycloalkyl group, an alkoxy group, a cycloalkoxy group or a halogen atom. When a plurality of R^{p1}, R^{p2} and R^{p4} are present, they may be the same or different at each occurrence.
np1 represents an integer of 0 to 5, np2 represents an integer of 0 to 3, np3 represents 0 or 1 and np4 represents an integer of 0 to 4. A plurality of np1 may be the same or different.]

The group represented by the formula (D-B) is preferably a group represented by the formula (D-B1) to the formula (D-B3), more preferably a group represented by the formula (D-B1). 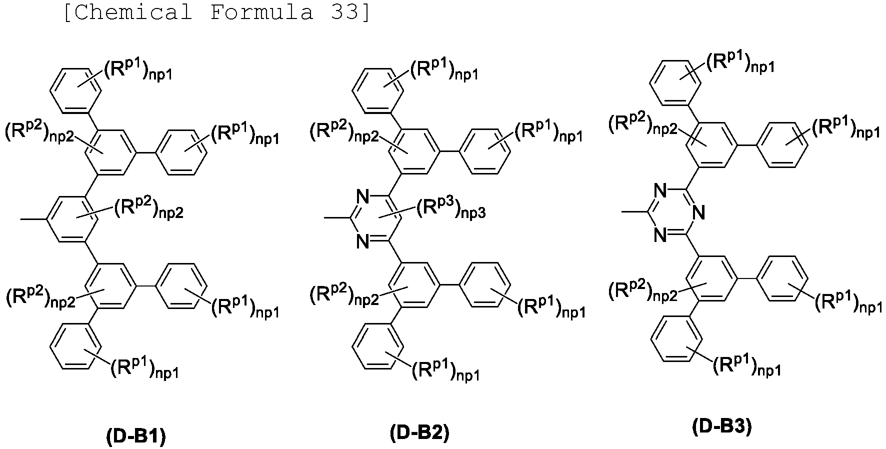 [wherein,
R^{p1} to RP3 each independently represent an alkyl group, a cycloalkyl group, an alkoxy group, a cycloalkoxy group or a halogen atom. When a plurality of R^{p1} and R^{p2} are present, they may be the same or different at each occurrence.
np1 represents an integer of 0 to 5, np2 represents an integer of 0 to 3, np3 represents 0 or 1. When a plurality of np1 and np2 are present, they may be the same or different at each occurrence.]

The group represented by the formula (D-C) is preferably a group represented by the formula (D-C1) to the formula (D-C4), more preferably a group represented by the formula (D-C1) to the formula (D-C3), further preferably a group represented by the formula (D-C1) or the formula (D-C2), particularly preferably a group represented by the formula (D-C1). 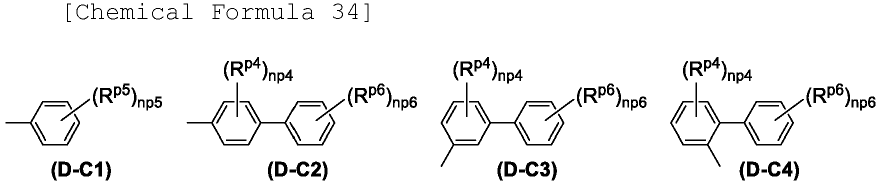 [wherein,
R^{p4} to R^{p6} each independently represent an alkyl group, a cycloalkyl group, an alkoxy group, a cycloalkoxy group or a halogen atom. When a plurality of R^{p4} to R^{p6} are present, they may be the same or different at each occurrence.
np4 represents an integer of 0 to 4, np5 represents an integer of 0 to 5 and np6 represents an integer of 0 to 5.]

np1 is preferably 0 or 1. np2 is preferably 0 or 1, more preferably 0. np3 is preferably 0. np4 is preferably an integer of 0 to 2. np5 is preferably an integer of 1 to 3. np6 is preferably an integer of 0 to 2.

R^{p1} to R^{p6} are each preferably an alkyl group or a cycloalkyl group, more preferably a methyl group, an ethyl group, an isopropyl group, a tert-butyl group, a hexyl group, a 2-ethylhexyl group, a cyclohexyl group or a tert-octyl group, further preferably a methyl group, an ethyl group, an isopropyl group, a tert-butyl group, a hexyl group, a 2-ethylhexyl group or a tert-octyl group.

In Ring R^{1A}, it is preferable that at least one of E^{11A} and E^{12A} is a nitrogen atom and at least one of R^{11A} and R^{12A} bonding to the nitrogen atom is a group represented by the formula (Ar-1A), it is more preferable that E^{11A} is a nitrogen atom and R^{11A} bonding to the nitrogen atom is a group represented by the formula (Ar-1A), since the light emitting device of the present invention is more excellent in luminance life.

When a plurality of Ring R^{1A} are present, it may be permissible that at least one of E^{11A} to E^{13A} is a nitrogen atom and at least one of R^{11A} to R^{13A} bonding to the nitrogen atom is a group represented by the formula (Ar-1A), in at least one of the plurality of Ring R^{1A}, and since synthesis of a metal complex represented by the formula (1) is easy, it is preferable that at least one of E^{11A} to E^{13A} is a nitrogen atom and at least one of R^{11A} to R^{13A} bonding to the nitrogen atom is a group represented by the formula (Ar-1A), in at least two of the plurality of Ring R^{1A}, it is more preferable that at least one of E^{11A} to E^{13A} is a nitrogen atom and at least one of R^{11A} to R^{13A} bonding to the nitrogen atom is a group represented by the formula (Ar-1A), in all of the plurality of Ring R^{1A}.

The number of carbon atoms of the aromatic hydrocarbon ring as Ring R², not including the number of carbon atoms of the substituent, is usually 6 to 60, preferably 6 to 30, more preferably 6 to 18. The aromatic hydrocarbon ring as Ring R² includes, for example, a benzene ring, a naphthalene ring, an indene ring, a fluorene ring, a spirobifluorene ring, a phenanthrene ring and a dihydrophenanthrene ring, and rings obtained by condensation of one or more and five or less of these rings, and since the light emitting device of the present invention is more excellent in luminance life, it is preferably a benzene ring, a naphthalene ring, a fluorene ring, a spirobifluorene ring, a phenanthrene ring or a dihydrophenanthrene ring, more preferably a benzene ring, a fluorene ring, a spirobifluorene ring or a dihydrophenanthrene ring, further preferably a benzene ring or a fluorene ring, particularly preferably a benzene ring, and the foregoing rings optionally have a substituent.

The number of carbon atoms of the aromatic hetero ring as Ring R², not including the number of carbon atoms of the substituent, is usually 2 to 60, preferably 3 to 30, more preferably 4 to 15. The aromatic hetero ring as Ring R² includes, for example, a pyrrole ring, a diazole ring, a furan ring, a thiophene ring, a pyridine ring and a diazabenzene ring, and rings obtained by condensation of one or more and five or less aromatic rings to these rings, and since the light emitting device of the present invention is more excellent in luminance life, it is preferably a pyridine ring, a diazabenzene ring, an azanaphthalene ring, a diazanaphthalene ring, an indole ring, a benzofuran ring, a benzothiophene ring, a carbazole ring, an azacarbazole ring, a diazacarbazole ring, a dibenzofuran ring or a dibenzothiophene ring, more preferably a pyridine ring, a diazabenzene ring, a carbazole ring, a dibenzofuran ring or a dibenzothiophene ring, further preferably a carbazole ring, a dibenzofuran ring or a dibenzothiophene ring, particularly preferably a dibenzofuran ring, and the foregoing rings optionally have a substituent. When Ring R² is a 6-membered aromatic hetero ring, E² is preferably a carbon atom.

Ring R² is preferably a benzene ring, a fluorene ring, a spirobifluorene ring, a dihydrophenanthrene ring, a pyridine ring, a diazabenzene ring, a carbazole ring, a dibenzofuran ring or a dibenzothiophene ring, more preferably a benzene ring, a fluorene ring, a carbazole ring, a dibenzofuran ring or a dibenzothiophene ring, further preferably a benzene ring or a dibenzofuran ring, particularly preferably a benzene ring, and the foregoing rings optionally have a substituent, since the light emitting device of the present invention is further excellent in luminance life.

The substituent which Ring R² optionally has is preferably an alkyl group, a cycloalkyl group, an alkoxy group, a cycloalkoxy group, an aryl group, an aryloxy group, a monovalent hetero ring group, a substituted amino group or a halogen atom, more preferably an alkyl group, a cycloalkyl group, an aryl group, a monovalent hetero ring group or a substituted amino group, further preferably an alkyl group or an aryl group, and the foregoing groups optionally further have a substituent.

The examples and preferable ranges of the aryl group, the monovalent hetero ring group and the substituted amino group as the substituent which Ring R² optionally has are the same as the examples and preferable ranges of the aryl group, the monovalent hetero ring group and the substituted amino group represented by R^{11A} to R^{13A}, respectively.

The examples and preferable ranges of the substituent which the substituent which Ring R² optionally has optionally further has are the same as the examples and preferable ranges of the substituent which R^{11A} to R^{13A} optionally have.

It is preferable that R^{11A} and R^{12A}, R^{12A} and R^{13A}, and a substituent which Ring R² optionally has and R^{11A} are each not combined together to form a ring together with atoms to which they are attached, since synthesis of a metal complex represented by the formula (1) is easy.

### [Group represented by the formula (Ar-1A)]

The examples and preferable ranges of the aromatic hydrocarbon ring as Ring A are the same as the examples and preferable ranges of the aromatic hydrocarbon ring as Ring R². The examples and preferable ranges of the aromatic hetero ring as Ring A are the same as the examples and preferable ranges of the aromatic hetero ring as Ring R².

Ring A is preferably a benzene ring, a fluorene ring, a spirobifluorene ring, a dihydrophenanthrene ring, a pyridine ring, a diazabenzene ring, a carbazole ring, a dibenzofuran ring or a dibenzothiophene ring, more preferably a benzene ring, a pyridine ring or a diazabenzene ring, further preferably a benzene ring, and the foregoing rings optionally have a substituent, since the light emitting device of the present invention is more excellent in luminance life.

The examples and preferable ranges of the substituent which Ring A optionally has are the same as the examples and preferable ranges of the substituent which Ring R² optionally has.

When a plurality of the substituents which Ring A optionally has are present, it is preferable that they are not combined together to form a ring together with atoms to which they are attached, since synthesis of a metal complex represented by the formula (1) is easy.

R² is preferably an alkyl group, a cycloalkyl group, an aryl group, a monovalent hetero ring group or a substituted amino group, more preferably an alkyl group, a cycloalkyl group or an aryl group, further preferably an alkyl group, and the foregoing groups optionally further have a substituent, since the light emitting device of the present invention is more excellent in luminance life.

The examples and preferable ranges of the aryl group, the monovalent hetero ring group and the substituted amino group represented by R² are the same as the examples and preferable ranges of the aryl group, the monovalent hetero ring group and the substituted amino group represented by R^{11A} to R^{13A}.

The examples and preferable ranges of the substituent which R² optionally has are the same as the examples and preferable ranges of the substituent which R^{11A} to R^{13A} optionally have.

The group represented by the formula (Ar-1A) is preferably a group represented by the formula (Ar-2A), since the light emitting device of the present invention is more excellent in luminance life.

E^{1A} to E^{3A} are each preferably a carbon atom.

When Ring A¹ is a pyridine ring, a pyridine ring in which E^{1A} is a nitrogen atom is preferable.

When Ring A¹ is a diazabenzene ring, a pyrimidine ring in which E^{1A} and E^{3A} are each a nitrogen atom is preferable.

Ring A¹ is preferably a benzene ring.

R^{1A} to R^{3A} are each preferably a hydrogen atom, an alkyl group, a cycloalkyl group, an aryl group, a monovalent hetero ring group or a substituted amino group, more preferably a hydrogen atom, an alkyl group or an aryl group, and the foregoing groups optionally have a substituent, since the light emitting device of the present invention is more excellent in luminance life.

R^{1A} and R^{3A} are each further preferably a hydrogen atom.

R^{2A} is further preferably an alkyl group or an aryl group, particularly preferably an alkyl group, and the foregoing groups optionally have a substituent.

The examples and preferable ranges of the aryl group, the monovalent hetero ring group and the substituted amino group represented by R^{1A} to R^{3A} are the same as the examples and preferable ranges of the aryl group, the monovalent hetero ring group and the substituted amino group represented by R^{11A} to R^{13A}, respectively.

The examples and preferable ranges of the substituent which R^{1A} to R^{3A} optionally have are the same as the examples and preferable ranges of the substituent which R^{11A} to R^{13A} optionally have.

R^{1A} and R^{2A}, and, R^{2A} and R^{3A} each may be combined together to form a ring together with atoms to which they are attached, since synthesis of a metal complex represented by the formula (1) is easy, however, it is preferable that they are not combined to form a ring.

The group represented by the formula (Ar-2A) is preferably a group represented by the formula (Ar-3A), since the light emitting device of the present invention is more excellent in luminance life.

### [Anionic bidentate ligand]

The anionic bidentate ligand represented by A¹-G¹-A² includes, for example, ligands represented by the following formulae. However, the anionic bidentate ligand represented by A¹-G¹-A² is different from a ligand of which number is defined by subscript n¹. 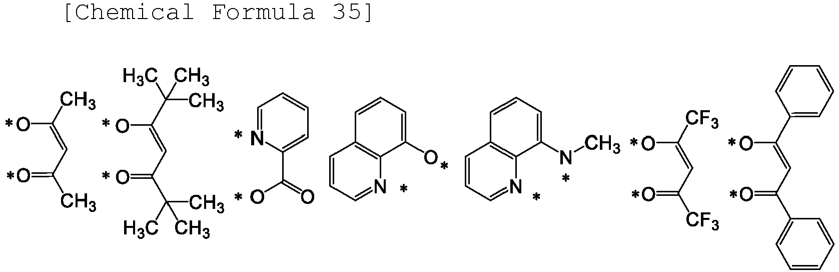 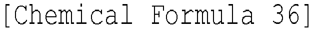 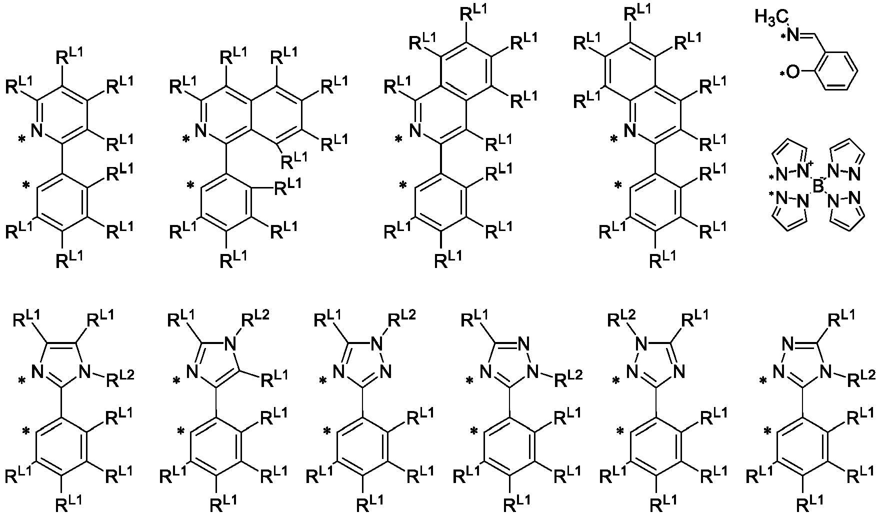 [wherein,
* represents a site binding to M¹.
R^{L1} represents a hydrogen atom, an alkyl group, a cycloalkyl group or a halogen atom, and the foregoing groups optionally have a substituent. A plurality of R^{L1} may be the same or different.
R^{L2} represents an alkyl group, a cycloalkyl group, an aryl group, a monovalent hetero ring group or a halogen atom, and the foregoing groups optionally have a substituent.]

R^{L1} is preferably a hydrogen atom, an alkyl group, a cycloalkyl group or a fluorene atom, more preferably a hydrogen atom or an alkyl group, and the foregoing groups optionally have a substituent.

R^{L2} is preferably an alkyl group, a cycloalkyl group, an aryl group or a monovalent hetero ring group, more preferably an aryl group, and the foregoing groups optionally have a substituent.

The metal complex represented by the formula (1) is preferably a metal complex represented by the formula (1-A1) or the formula (1-A2), more preferably a metal complex represented by the formula (1-A1), since the light emitting device of the present invention is more excellent in luminance life.

Ring R^{2A} is preferably a benzene ring, a fluorene ring, a carbazole ring, a dibenzofuran ring or a dibenzothiophene ring, more preferably a benzene ring or a dibenzofuran ring, further preferably a benzene ring, and the foregoing rings optionally have a substituent.

The examples and preferable ranges of the substituent which Ring R^{2A} optionally has are the same as the examples and preferable ranges of the substituent which Ring R² optionally has.

When a plurality of the substituents which Ring R^{2A} optionally has are present, it is preferable that they are not combined together to form a ring together with atoms to which they are attached, since synthesis of a metal complex represented by the formula (1-A1) or the formula (1-A2) is easy.

It is preferable that the substituent which Ring R^{2A} optionally has and R^{11A} are not combined together to form a ring together with atoms to which they are attached, since synthesis of a metal complex represented by the formula (1-A1) or the formula (1-A2) is easy.

When a plurality of R^{11A} are present in the formula (1-A1), it is preferable that at least two of R^{11A} represent a group represented by the formula (Ar-1A), it is more preferable that all of R^{11A} represent a group represented by the formula (Ar-1A), since synthesis of a metal complex represented by the formula (1-A1) is easy.

In the formula (1-A1), E^{12A} is preferably a carbon atom.

In the formula (1-A1), it is preferable that E^{13A} is a nitrogen atom and R^{13A} is absent.

When a plurality of R^{12A} are present in the formula (1-A2), it is preferable that at least two of R^{12A} represent a group represented by the formula (Ar-1A), it is more preferable that all of R^{12A} represent a group represented by the formula (Ar-1A), since synthesis of a metal complex represented by the formula (1-A2) is easy.

In the formula (1-A2), E^{13A} is preferably a carbon atom.

In the formula (1-A2), it is preferable that E^{11A} is a nitrogen atom and R^{11A} is absent.

The metal complex represented by the formula (1-A1) is preferably a metal complex represented by the formula (1-A1-1) to the formula (1-A1-3), more preferably a metal complex represented by the formula (1-A1-1) or the formula (1-A1-2), further preferably a metal complex represented by the formula (1-A1-2), since the light emitting device of the present invention is more excellent in luminance life.

The metal complex represented by the formula (1-A2) is preferably a metal complex represented by the formula (1-A2-1) or the formula (1-A2-2), more preferably a metal complex represented by the formula (1-A2-2), since the light emitting device of the present invention is more excellent in luminance life.

R^{21A} to R^{24A} are each preferably a hydrogen atom, an alkyl group, a cycloalkyl group, an aryl group, a monovalent hetero ring group or a substituted amino group, more preferably a hydrogen atom, an alkyl group or an aryl group, further preferably a hydrogen atom, and the foregoing groups optionally have a substituent.

The examples and preferable ranges of the aryl group, the monovalent hetero ring group and the substituted amino group represented by R^{21A} to R^{24A} are the same as the examples and preferable ranges of the aryl group, the monovalent hetero ring group and the substituted amino group as the substituent which Ring R² optionally has, respectively.

It is preferable that R^{11A} and R^{21A} are not combined together to form a ring together with atoms to which they are attached, since synthesis of a metal complex represented by the formula (1) is easy.

When R^{21A} and R^{22A}, R^{22A} and R^{23A}, or R^{23A} and R^{24A} are combined together to form a ring together with atoms to which they are attached, the ring to be formed includes, for example, aromatic hydrocarbon rings or aromatic hetero rings, and it is preferably a benzene ring, an indene ring, a pyridine ring, a diazabenzene ring, a benzofuran ring, a benzothiophene ring or an indole ring, more preferably an indene ring, a benzofuran ring, a benzothiophene ring or an indole ring, further preferably a benzofuran ring or a benzothiophene ring, particularly preferably a benzofuran ring, and the foregoing rings optionally have a substituent.

When R^{21A} and R^{22A}, R^{22A} and R^{23A}, or R^{23A} and R^{24A} are combined together to form a ring together with atoms to which they are attached, it is preferable that R^{21A} and R^{22A}, or R^{22A} and R^{23A} are combined together to form a ring together with atoms to which they are attached, it is more preferable that R^{22A} and R^{23A} are combined together to form a ring together with atoms to which they are attached.

The examples and preferable ranges of the substituent which R^{21A} to R^{24A} optionally have are the same as the examples and preferable ranges of the substituent which the substituent which Ring R² optionally has optionally further has.

The metal complex represented by the formula (1) includes, for example, metal complexes represented by the following formulae. 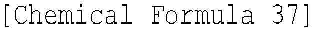 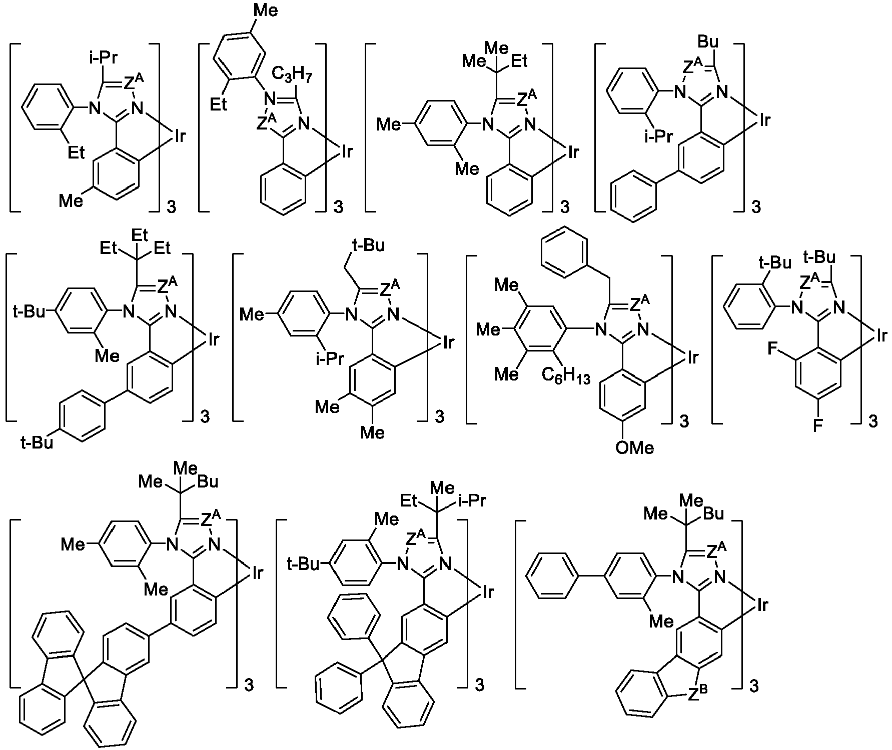 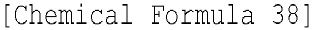 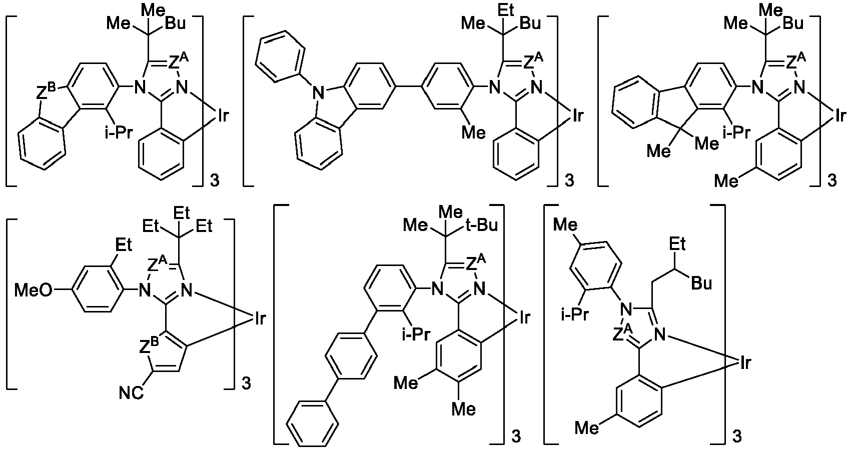 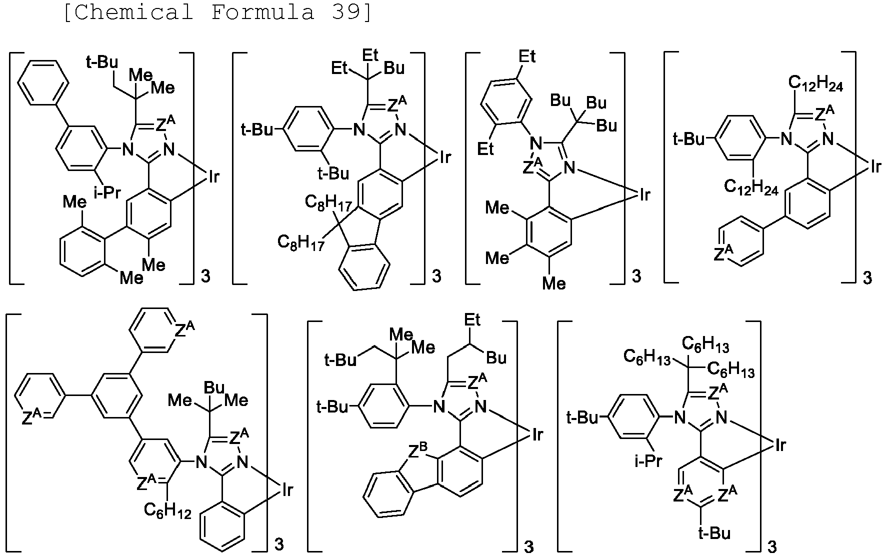 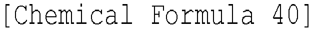 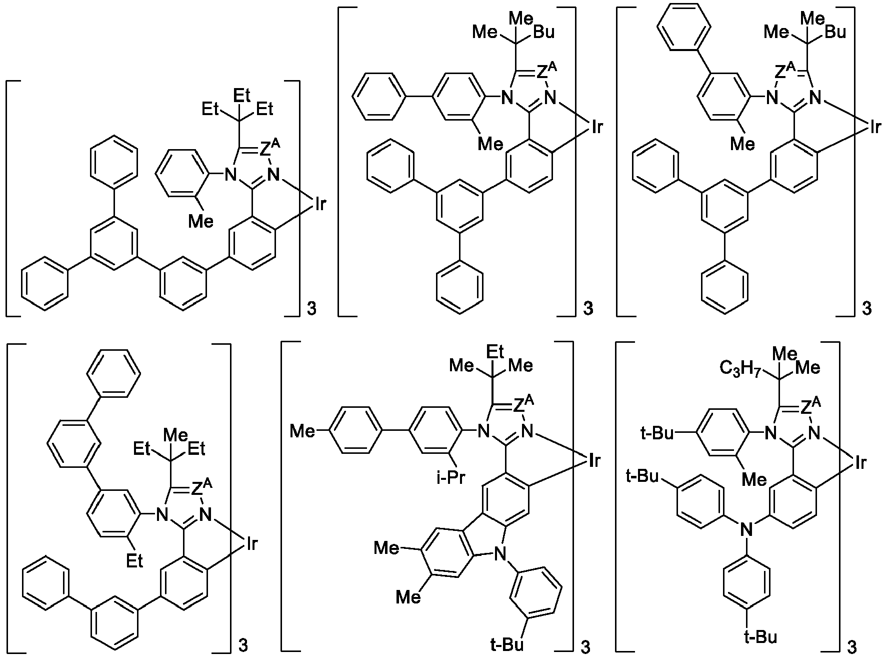 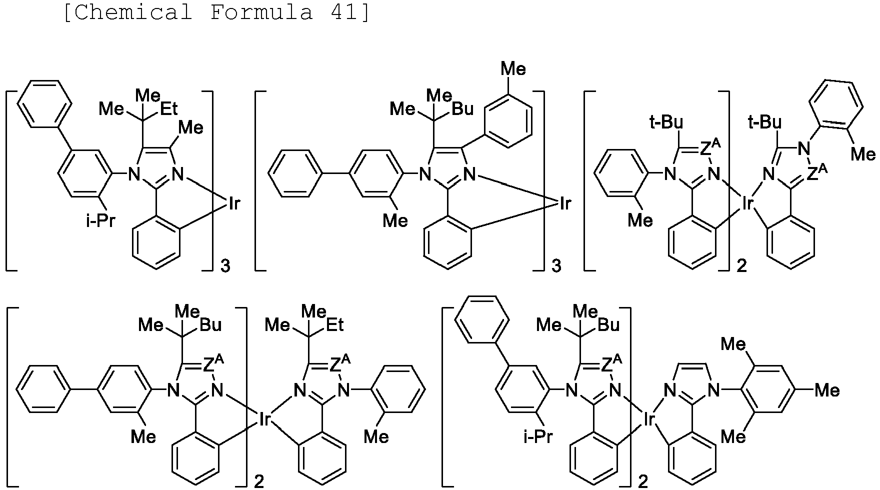 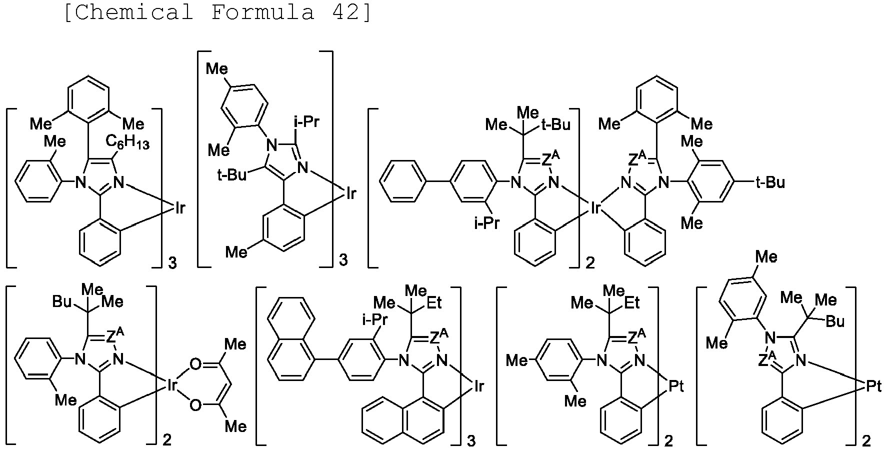 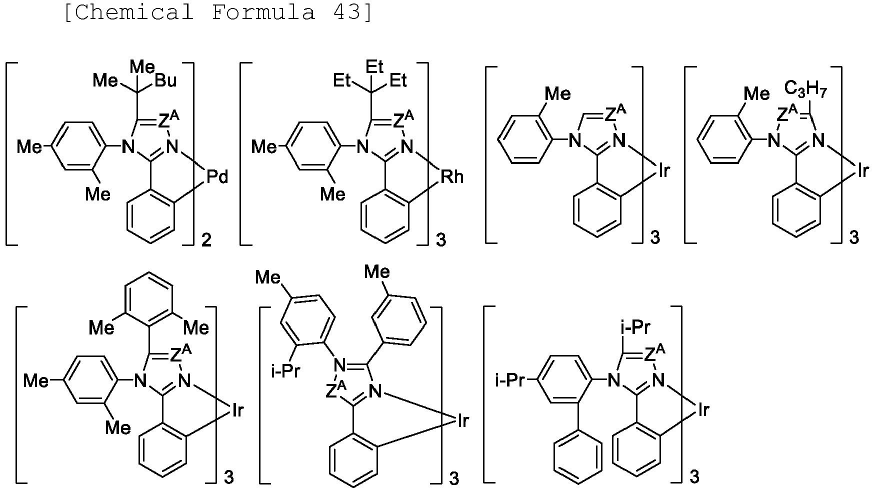 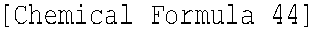 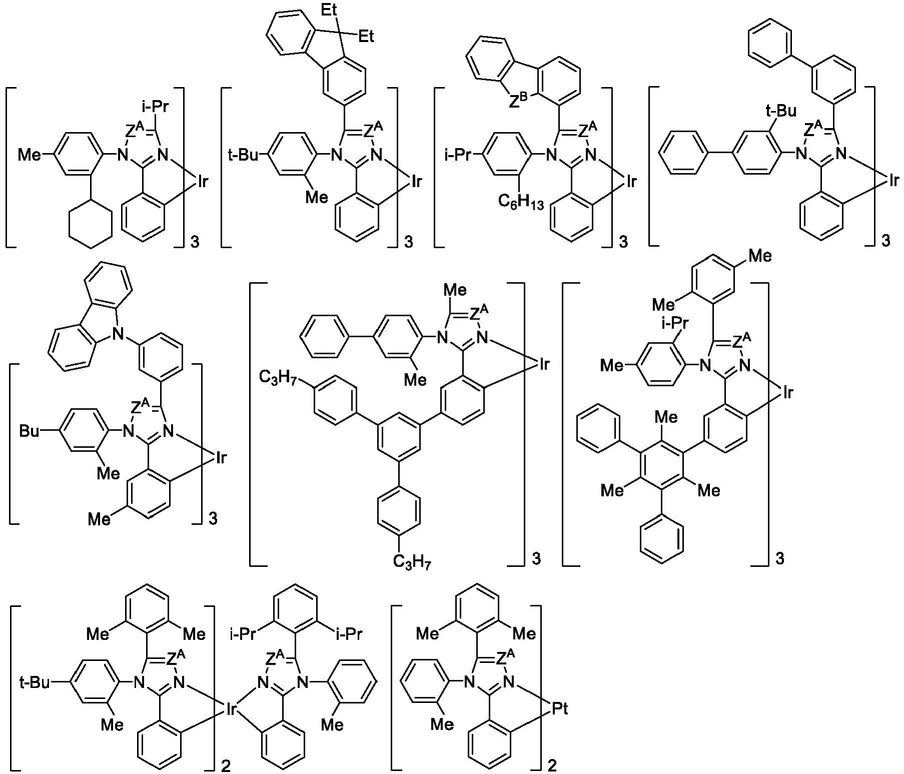 [wherein,
Z^{A} represents a group represented by -CH= or a group represented by -N=. When a plurality of Z^{A} are present, they may be the same or different.
Z^{B} represents a group represented by -O- or a group represented by -S-. When a plurality of Z^{B} are present, they may be the same or different.]

Z^{A} is preferably a group represented by -N=. Z^{B} is preferably a group represented by -O-.

### <Production method of metal complex represented by the formula (1)>

The metal complex represented by the formula (1) can be produced, for example, by a method of reacting a compound as a ligand and a metal complex. If necessary, ligands of a metal complex may be subjected to a functional group transformation reaction.

The metal complex represented by the formula (1) can be produced, for example, by a method comprising Step A of reacting a compound represented by the formula (M-1) with a metal compound or its hydrate. 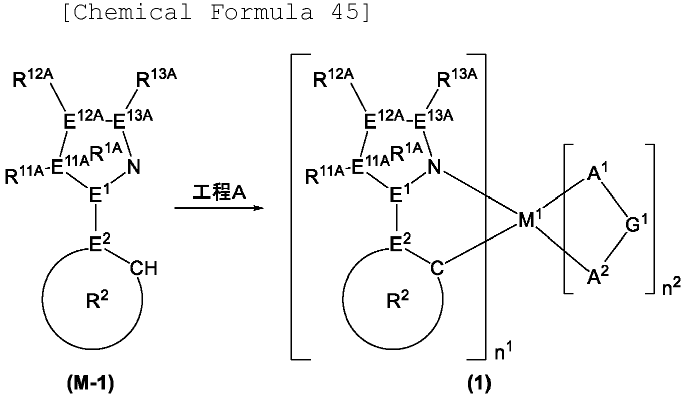 [wherein, M¹, n¹, n², Ring R^{1A}, Ring R², R^{11A} to R^{13A}, E¹, E², E^{11A} to E^{13A} and A¹-G¹-A² represent the same meaning as described above.]

In Step A, the metal compound includes, for example, iridium compounds such as iridium chloride, tris(acetylacetonato)iridium(III), chloro(cyclooctadiene)iridium(I) dimer, iridium(III) acetate and the like; platinum compounds such as potassium chloroplatinate and the like; palladium compounds such as palladium chloride, palladium acetate and the like; and rhodium compounds such as rhodium chloride and the like. The metal compound hydrate includes, for example, iridium chloride trihydrate and rhodium chloride trihydrate.

In Step A, the amount of the compound represented by the formula (M-1) is usually 2 to 20 mol with respect to 1 mol of a metal compound or its hydrate.

Step A is carried out usually in a solvent. The solvent includes alcohol solvents such as methanol, ethanol, propanol, ethylene glycol, glycerin, 2-methoxyethanol, 2-ethoxyethanol and the like; ether solvents such as diethyl ether, tetrahydrofuran (THF), dioxane, cyclopentyl methyl ether, diglyme and the like; halogen solvents such as methylene chloride, chloroform and the like; nitrile solvents such as acetonitrile, benzonitrile and the like; hydrocarbon solvents such as hexane, decalin, toluene, xylene, mesitylene and the like; amide solvents such as N,N-dimethylformamide, N,N-dimethylacetamide and the like; acetone, dimethyl sulfoxide, water and the like.

In Step A, the reaction time is usually 30 minutes to 200 hours, and the reaction temperature is usually between the melting point and the boiling point of a solvent present in the reaction system.

The compound, the catalyst and the solvent used in the reaction explained in <Production method of metal complex represented by the formula (1)> each may be used singly or in combination of two or more kinds thereof.

### <Metal complex represented by the formula (2)>

The metal complex represented by the formula (2) is usually a metal complex showing phosphorescence at room temperature (25°C), preferably a metal complex showing light emission from triplet excited state at room temperature.

M² is preferably an iridium atom or a platinum atom, more preferably an iridium atom, since the light emitting device of the present invention is more excellent in luminance life.

When M² is a rhodium atom or an iridium atom, n³ is preferably 2 or 3, more preferably 3.

When M² is a palladium atom or a platinum atom, n³ is preferably 2.

E^{L} is preferably a carbon atom.

The number of carbon atoms of the aromatic hetero ring as Ring L¹, not including the number of carbon atoms of the substituent, is usually 2 to 60, preferably 3 to 30, more preferably 4 to 15. Ring L¹ is preferably a 6-membered aromatic hetero ring having one or more and four or less nitrogen atoms as a constituent atom, more preferably a 6-membered aromatic hetero ring having one or more and two or less nitrogen atoms as a constituent atom, and the foregoing rings optionally have a substituent.

Ring L¹ includes, for example, a pyridine ring, a diazabenzene ring, a triazine ring, an azanaphthalene ring, a diazaphthalene ring and a triazanaphthalene ring, and it is preferably a pyridine ring, a diazabenzene ring, an azanaphthalene ring or a diazanaphthalene ring, more preferably a pyridine ring, a pyrimidine ring, a quinoline ring or an isoquinoline ring, further preferably a pyridine ring or an isoquinoline ring, and the foregoing rings optionally have a substituent.

The examples and preferable ranges of the aromatic hydrocarbon ring as Ring L² are the same as the examples and preferable ranges of the aromatic hydrocarbon ring as Ring R².

The number of carbon atoms of the aromatic hetero ring as Ring L², not including the number of carbon atoms of the substituent, is usually 2 to 60, preferably 3 to 30, more preferably 4 to 15. The aromatic hetero ring as Ring L² includes a pyrrole ring, a diazole ring, a furan ring, a thiophene ring, a pyridine ring and a diazabenzene ring, and rings obtained by condensing one or more and five or less aromatic rings to these rings, and since the light emitting device of the present invention is more excellent in luminance life, it is preferably a pyridine ring, a diazabenzene ring, an azanaphthalene ring, a diazanaphthalene ring, an indole ring, a benzofuran ring, a benzothiophene ring, a carbazole ring, an azacarbazole ring, a diazacarbazole ring, a dibenzofuran ring or a dibenzothiophene ring, more preferably a pyridine ring, a diazabenzene ring, a carbazole ring, a dibenzofuran ring or a dibenzothiophene ring, further preferably a pyridine ring or a diazabenzene ring, and the foregoing rings optionally have a substituent. When Ring L² is a 6-membered aromatic hetero ring, E^{L} is preferably a carbon atom.

Ring L² is preferably a benzene ring, a fluorene ring, a dihydrophenanthrene ring, a pyridine ring, a diazabenzene ring, a carbazole ring, a dibenzofuran ring or a dibenzothiophene ring, more preferably a benzene ring, a pyridine ring or a diazabenzene ring, further preferably a benzene ring, and the foregoing rings optionally have a substituent, since the light emitting device of the present invention is further excellent in luminance life.

"At least one of Ring L¹ and Ring L² has a group represented by the formula (1-T)" means that a group represented by the formula (1-T) is bonded directly to at least one of atoms (preferably, carbon atoms or nitrogen atoms) constituting Ring L¹ and Ring L². When a plurality of Ring L¹ and Ring L² are present in the metal complex represented by the formula (2), at least one of the plurality of Ring L¹ and Ring L² may have a group represented by the formula (1-T), however, it is preferable that all of a plurality of Ring L¹, all of a plurality of Ring L² or all of a plurality of Ring L¹ and Ring L² have a group represented by the formula (1-T), it is more preferable that all of a plurality of Ring L¹ or all of a plurality of Ring L² have a group represented by the formula (1-T), since the light emitting device of the present invention is more excellent in luminance life.

The number of the group represented by the formula (1-T) which at least one of Ring L¹ and Ring L² has in the metal complex represented by the formula (2) is usually 1 to 5, and since the metal complex represented by the formula (2) can be synthesized easily, it is preferably 1 to 3, more preferably 1 to 2, further preferably 1.

When M² is a rhodium atom or an iridium atom in the metal complex represented by the formula (2), the total number of the group represented by the formula (1-T) which Ring L¹ and Ring L² have is usually 1 to 30, and since the light emitting device of the present invention is more excellent in luminance life, it is preferably 1 to 18, more preferably 2 to 12, further preferably 3 to 6.

When M² is a palladium atom or a platinum atom in the metal complex represented by the formula (2), the total number of the group represented by the formula (1-T) which Ring L¹ and Ring L² have is usually 1 to 20, and since the light emitting device of the present invention is more excellent in luminance life, it is preferably 1 to 12, more preferably 1 to 8, further preferably 2 to 4.

The substituent which Ring L¹ and Ring L² optionally have other than the group represented by the formula (1-T) is preferably a cyano group, an alkenyl group or a cycloalkenyl group, and the foregoing groups optionally further have a substituent.

When a plurality of substituents which Ring L¹ optionally has are present, it is preferable that they are not combined together to form a ring together with atoms to which they are attached.

When a plurality of substituents which Ring L² optionally has are present, it is preferable that they are not combined together to form a ring together with atoms to which they are attached.

It is preferable that a substituent which Ring L¹ optionally has and a substituent which Ring L² optionally has are not combined together to form a ring together with atoms to which they are attached.

The examples and preferable ranges of the anionic bidentate ligand represented by A³-G²-A⁴ are the same as the examples and preferable ranges of the anionic bidentate ligand represented by A¹-G¹-A². In the anionic bidentate ligand represented by A³-G²-A⁴, * in the above-described formula represents a site binding to M². However, the anionic bidentate ligand represented by A³-G²-A⁴ is different from a ligand of which number is defined by subscript n³.

### [Group represented by the formula (1-T)]

The examples and preferable ranges of the aryl group, the monovalent hetero ring group and the substituted amino group represented by R^{1T} are the same as the examples and preferable ranges of the aryl group, the monovalent hetero ring group and the substituted amino group represented by R^{11A} to R^{13A}, respectively.

The examples and preferable ranges of the substituent which R^{1T} optionally has are the same as the examples and preferable ranges of the substituent which R^{11A} to R^{13A} optionally have.

R^{1T} is preferably an alkyl group, a cycloalkyl group, an aryl group, a monovalent hetero ring group or a substituted amino group, more preferably an alkyl group, a cycloalkyl group or a group represented by the formula (D-A) to the formula (D-C), further preferably an alkyl group or a group represented by the formula (D-A) or by the formula (D-C), particularly preferably a group represented by the formula (D-A), and the foregoing groups optionally have a substituent, since the light emitting device of the present invention is more excellent in luminance life.

### (Metal complex represented by the formula (2-B))

The metal complex represented by the formula (2) is preferably a metal complex represented by the formula (2-B), since the light emitting device of the present invention is more excellent in luminance life.

Ring L^{1B} is preferably a pyridine ring, a pyrimidine ring, a quinoline ring or an isoquinoline ring, more preferably a pyridine ring or an isoquinoline ring, and the foregoing rings optionally have a substituent.

The examples and preferable ranges of the substituent which Ring L^{1B} optionally has (substituent other than the group represented by the formula (1-T), the same shall apply hereinafter) are the same as the examples and preferable ranges of the substituent which Ring L¹ and Ring L² optionally have.

When a plurality of substituents which Ring L^{1B} optionally has are present, it is preferable that they are not combined together to form a ring together with atoms to which they are attached.

When Ring L^{2B} is a pyridine ring, a pyridine ring in which E^{21B} is a nitrogen atom, a pyridine ring in which E^{22B} is a nitrogen atom or a pyridine ring in which E^{23B} is a nitrogen atom is preferable, a pyridine ring in which E^{22B} is a nitrogen atom is more preferable.

When Ring L^{2B} is a diazabenzene ring, a pyrimidine ring in which E^{21B} and E^{23B} are each a nitrogen atom or a pyrimidine ring in which E^{22B} and E^{24B} are each a nitrogen atom is preferable, a pyrimidine ring in which E^{22B} and E^{24B} are each a nitrogen atom is more preferable.

E^{21B} to E^{24B} are each preferably a carbon atom.

Ring L^{2B} is preferably a benzene ring.

When at least one of Ring L^{1B} has a group represented by the formula (1-T), a group represented by the formula (1-T) may be bonded directly to at least one of atoms (preferably, carbon atoms or nitrogen atoms) constituting Ring L^{1B}. When at least one of Ring L^{1B} has a group represented by the formula (1-T) and when a plurality of Ring L^{1B} are present, at least one of the plurality of Ring L^{1B} may have a group represented by the formula (1-T), and since the light emitting device of the present invention is more excellent in luminance life, it is preferable that at least two of the plurality of Ring L^{1B} have a group represented by the formula (1-T), it is more preferable that all of the plurality of Ring L^{1B} have a group represented by the formula (1-T).

When at least one of R^{21B} to R^{24B} is a group represented by the formula (1-T), it is preferable that at least one of R^{22B} and R^{23B} is a group represented by the formula (1-T), it is more preferable that at least one of R^{22B} is a group represented by the formula (1-T), since the light emitting device of the present invention is more excellent in luminance life.

It is preferable that at least one of R^{21B} to R^{24B} is a group represented by the formula (1-T), it is more preferable that at least one of R^{22B} and R^{23B} is a group represented by the formula (1-T), it is further preferable that R^{22B} or R^{23B} is a group represented by the formula (1-T), it is particularly preferable that R^{22B} is a group represented by the formula (1-T), since the light emitting device of the present invention is further excellent in luminance life.

It is preferable that at least one of R^{21B} and R^{24B} is a hydrogen atom, it is more preferable that R^{21B} or R^{24B} is a hydrogen atom, it is further preferable that R^{21B} and R^{24B} are each a hydrogen atom, since a metal complex represented by the formula (2-B) can be synthesized easily.

The total number of the group represented by the formula (1-T) which a metal complex represented by the formula (2-B) has is the same as the total number of the group represented by the formula (1-T) which Ring L¹ and Ring L² have in a metal complex represented by the formula (2) .

It is preferable that R^{21B} and R^{22B}, R^{22B} and R^{23B}, R^{23B} and R^{24B}, and a substituent which Ring L^{1B} optionally has and R^{21B} are each not combined together to form a ring together with atoms to which they are attached.

The metal complex represented by the formula (2-B) is preferably a metal complex represented by the formula (2-B1) to the formula (2-B5), more preferably a metal complex represented by the formula (2-B1) to the formula (2-B3), further preferably a metal complex represented by the formula (2-B1) or the formula (2-B2), since the light emitting device of the present invention is more excellent in luminance life.

When at least one of R^{11B} to R^{14B} is a group represented by the formula (1-T) in the formula (2-B1), it is preferable that at least one of R^{12B} and R^{13B} is a group represented by the formula (1-T), it is more preferable that R^{12B} or R^{13B} is a group represented by the formula (1-T), it is further preferable that R^{13B} is a group represented by the formula (1-T), since the light emitting device of the present invention is more excellent in luminance life. In the formula (2-B1), it is preferable that at least one of R^{12B}, R^{13B}, R^{22B} and R23B is a group represented by the formula (1-T), it is more preferable that at least one of R^{13B}, R^{22B} and R^{23B} is a group represented by the formula (1-T), it is further preferable that at least one of R^{22B} and R^{23B} is a group represented by the formula (1-T), it is particularly preferable that R^{22B} or R^{23B} is a group represented by the formula (1-T), since the light emitting device of the present invention is further excellent in luminance life.

In the formula (2-B2), it is preferable that at least one of R^{13B}, R^{22B} and R^{23B} is a group represented by the formula (1-T), it is more preferable that at least one of R^{22B} and R^{23B} is a group represented by the formula (1-T), since the light emitting device of the present invention is more excellent in luminance life.

In the formula (2-B3), it is preferable that at least one of R^{12B}, R^{13B}, R^{22B} and R^{23B} is a group represented by the formula (1-T), it is more preferable that at least one of R^{13B}, R^{22B} and R^{23B} is a group represented by the formula (1-T), it is further preferable that at least one of R^{22B} and R^{23B} is a group represented by the formula (1-T), it is particularly preferable that R^{22B} or R^{23B} is a group represented by the formula (1-T), since the light emitting device of the present invention is further excellent in luminance life.

In the formula (2-B4), it is preferable that at least one of R^{22B} and R^{23B} is a group represented by the formula (1-T), since the light emitting device of the present invention is more excellent in luminance life.

In the formula (2-B5), it is preferable that at least one of R^{22B} and R^{23B} is a group represented by the formula (1-T), since the light emitting device of the present invention is more excellent in luminance life.

In the formula (2-B1) and the formula (2-B3), it is preferable that R^{11B} and R^{12B}, R^{12B} and R^{13B}, R^{13B} and R^{14B}, and R^{11B} and R^{21B} are each not combined together to form a ring together with atoms to which they are attached. In the formula (2-B2) and the formula (2-B3), it is preferable that R^{13B} and R^{14B}, R^{13B} and R^{15B}, R^{15B} and R^{16B}, R^{16B} and R^{17B}, R^{17B} and R^{18B}, and R^{18B} and R^{21B} are each not combined together to form a ring together with atoms to which they are attached. In the formula (2-B4), it is preferable that R^{11B} and R^{18B}, R^{14B} and R^{15B}, R^{15B} and R^{16B}, R^{16B} and R^{17B}, R^{17B} and R^{18B}, and R^{11B} and R^{21B} are each not combined together to form a ring together with atoms to which they are attached. In the formula (2-B5), it is preferable that R^{11B} and R^{12B}, R^{12B} and R^{18B}, R^{15B} and R^{16B}, R^{16B} and R^{17B}, R^{17B} and R^{18B}, and R^{11B} and R^{21B} are each not combined together to form a ring together with atoms to which they are attached.

The total number of the group represented by the formula (1-T) which each of metal complexes represented by the formula (2-B1) to the formula (2-B5) has is the same as the total number of the group represented by the formula (1-T) which Ring L¹ and Ring L² have in a metal complex represented by the formula (2).

The metal complex represented by the formula (2) includes, for example, metal complexes represented by the following formulae, and metal complexes G1 to G5 and R1 to R5 described later.

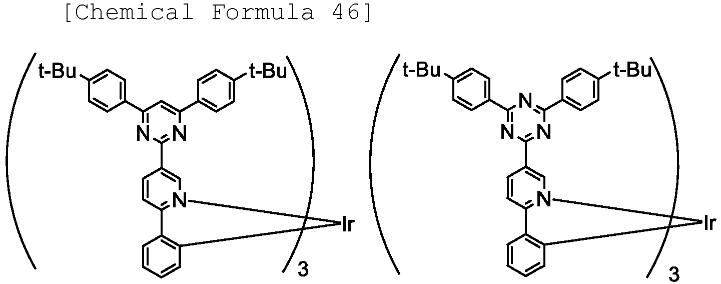

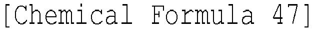

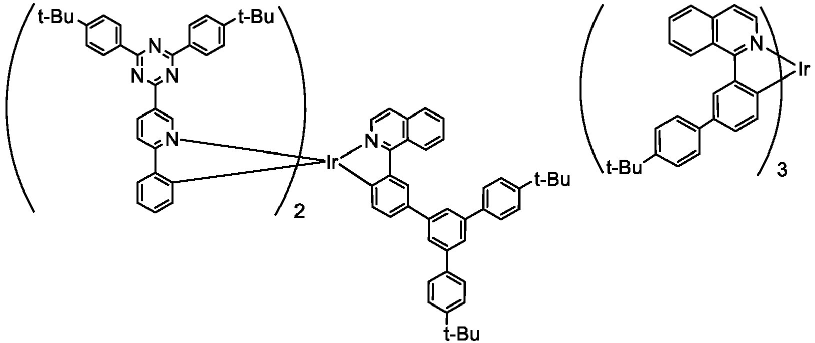

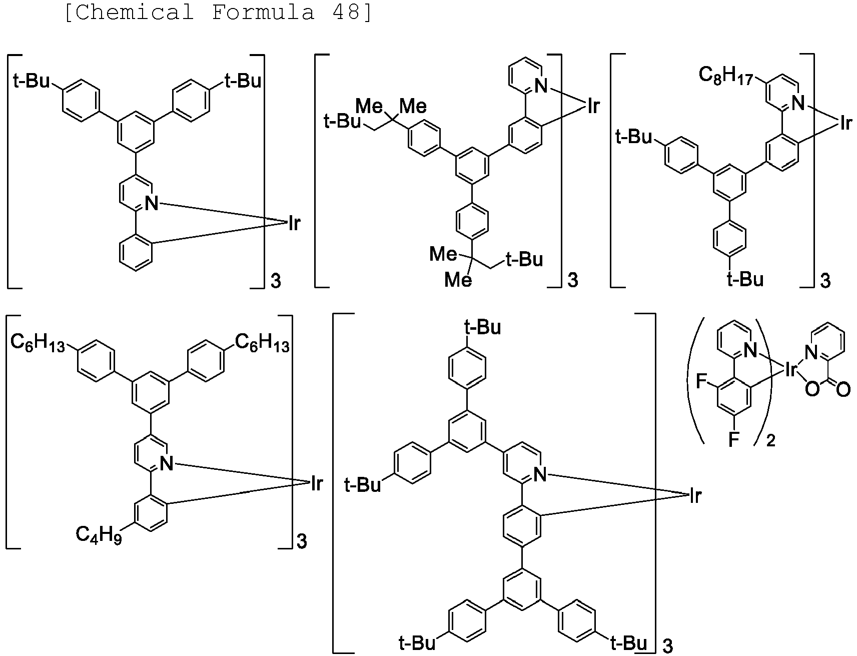

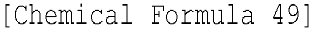

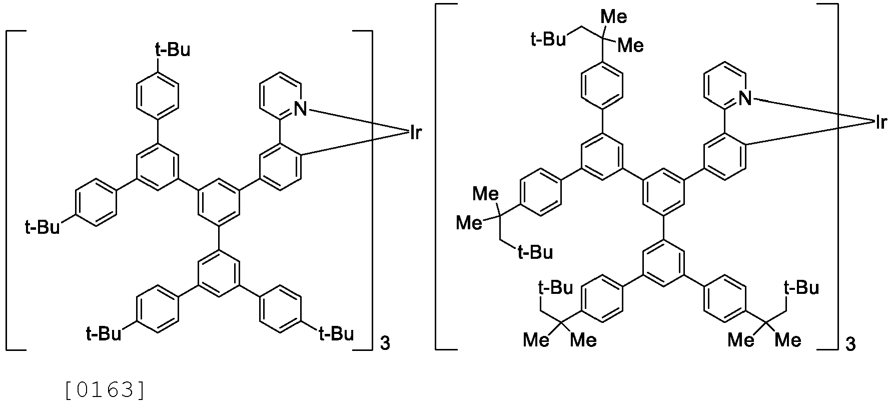

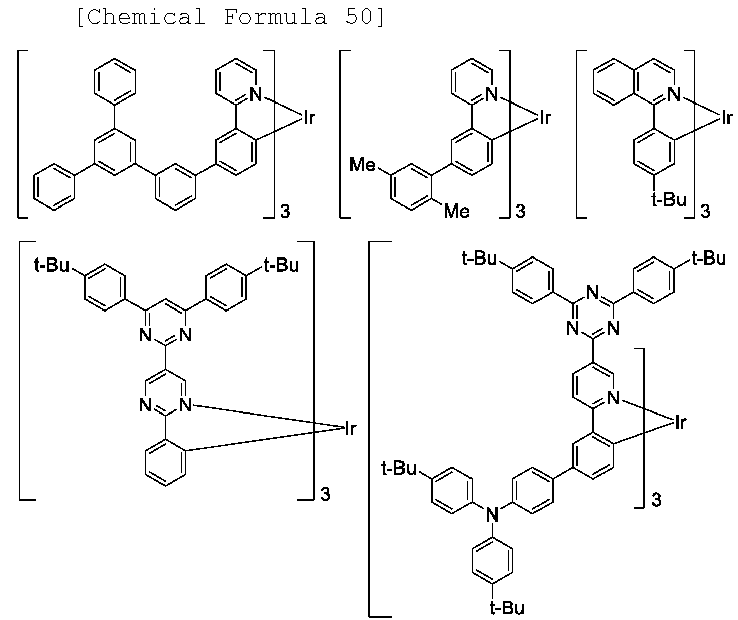

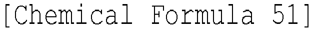

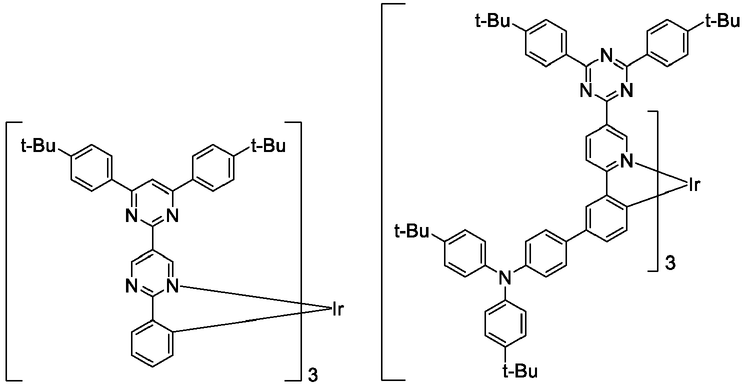

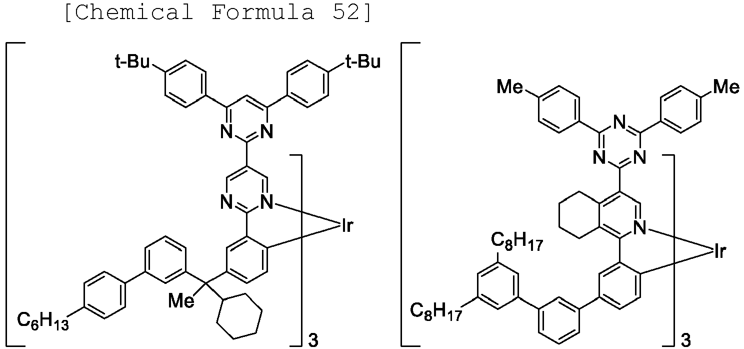

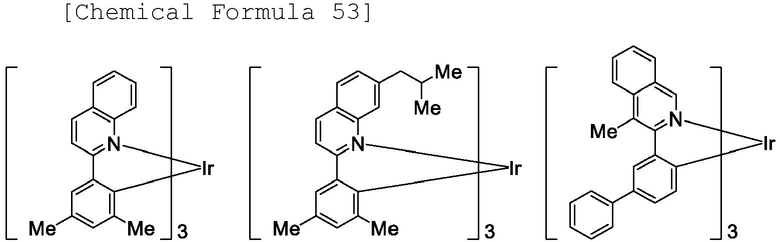

The metal complex represented by the formula (2) is available from Aldrich, Luminescence Technology Corp., American Dye Source and the like. Additionally, the metal complex can be synthesized according to methods described in, for example, "Journal of the American Chemical Society, Vol. 107, 1431-1432 (1985)", "Journal of the American Chemical Society, Vol. 106, 6647-6653 (1984)", Japanese Translation of PCT International Application Publication (JP-T) No. 2004-530254, Japanese Unexamined Patent Application Publication (JP-A) No. 2008-179617, JP-A No. 2011-105701, JP-T No. 2007-504272, International Publication WO 2006/121811.

### <Composition>

The composition of the present invention contains a metal complex represented by the formula (1) and a metal complex represented by the formula (2).

In the composition of the present invention, the metal complex represented by the formula (1) and the metal complex represented by the formula (2) each may be contained singly or in combination of two or more kinds thereof, and it is preferable that the metal complex represented by the formula (2) is contained in combination of two or more kinds thereof.

The emission color of the light emitting device of the present invention can be adjusted by controlling the ratio of the content of the metal complex represented by the formula (1) and the content of the metal complex represented by the formula (2) in the composition of the present invention, and it is also possible to adjust the emission color to white.

The emission color of a light emitting device can be confirmed by determining the chromaticity coordinate (CIE chromaticity coordinate) by measuring the emission chromaticity of the light emitting device. For white emission color, for example, it is preferable that X of chromaticity coordinate is in a range of 0.20 to 0.55 and Y of chromaticity coordinate is in a range of 0.20 to 0.55, it is more preferable that X of chromaticity coordinate is in a range of 0.25 to 0.50 and Y of chromaticity coordinate is in a range of 0.25 to 0.50.

From the standpoint of adjusting the emission color of the light emitting device of the present invention (particularly, adjusting the emission color to white), the maximum peak wavelength of the emission spectrum of the metal complex represented by the formula (1) is usually 380 nm or more and less than 495 nm, preferably 420 nm or more and less than 495 nm, more preferably 440 nm or more and 490 nm or less.

From the standpoint of adjusting the emission color of the light emitting device of the present invention (particularly, adjusting the emission color to white), the maximum peak wavelength of the emission spectrum of the metal complex represented by the formula (2) is usually 495 nm or more and less than 750 nm, preferably 500 nm or more and 680 nm or less, more preferably 505 nm or more and 640 nm or less.

When two or more of the metal complexes represented by the formula (2) are contained in the composition of the present invention, it is preferable that the maximum peak wavelengths of the emission spectra of at least two kinds of the metal complexes represented by the formula (2) are mutually different, and its difference is preferably 10 to 200 nm, more preferably 20 to 150 nm, further preferably 40 to 130 nm, from the standpoint of adjusting the emission color of the light emitting device of the present invention (particularly, adjusting the emission color to white).

When two or more kinds of the metal complexes represented by the formula (2) are contained in the composition of the present invention and when the maximum peak wavelengths of the emission spectra of at least two kinds of the metal complexes represented by the formula (2) are different, the maximum peak wavelength of the emission spectrum of the metal complex represented by the formula (2) at the shorter wavelength side is preferably 500 nm or more and less than 570 nm, more preferably 505 nm or more and 550 nm or less, from the standpoint of adjusting the emission color of the light emitting device of the present invention (particularly, adjusting the emission color to white). In contrast, the maximum peak wavelength of the emission spectrum of the metal complex represented by the formula (2) at the longer wavelength side is preferably 570 nm or more and 680 nm or less, more preferably 590 nm or more and 640 nm or less.

The maximum peak wavelength of the emission spectrum of the metal complex can be evaluated by dissolving the metal complex in an organic solvent such as xylene, toluene, chloroform, tetrahydrofuran and the like to prepare a dilute solution (1×10⁻⁶ to 1×1⁻³% by mass) and measuring the PL spectrum of the dilute solution at room temperature. The organic solvent for dissolving the metal complex is preferably xylene.

The total content of the metal complex represented by the formula (2) is preferably 0.01 to 50 parts by mass, more preferably 0.1 to 20 parts by mass, further preferably 1 to 10 parts by mass when the total content of the metal complex represented by the formula (1) is taken as 100 parts by mass, from the standpoint of adjusting the emission color of the light emitting device of the present invention (particularly, adjusting the emission color to white).

When two or more kinds of the metal complexes represented by the formula (2) are contained in the composition of the present invention and when the maximum peak wavelengths of the emission spectra of at least two kinds of the metal complexes represented by the formula (2) are different, the content of the metal complex represented by the formula (2) having the maximum peak wavelength of the emission spectrum at the longer wavelength side, among two kinds of metal complexes, is usually 1 to 10000 parts by mass when the amount of the metal complex represented by the formula (2) having the maximum peak wavelength of the emission spectrum at the shorter wavelength side is taken as 100 parts by mass, and since the light emitting device of the present invention is excellent in color reproducibility, it is preferably 0.5 to 1000 parts by mass, more preferably 1 to 100 parts by mass, further preferably 5 to 50 parts by mass.

When two or more kinds of the metal complexes represented by the formula (2) are contained in the composition of the present invention, at least one kind of the metal complex represented by the formula (2) is preferably a metal complex represented by the formula (2-B1) to the formula (2-B5), more preferably a metal complex represented by the formula (2-B1) to the formula (2-B3), further preferably a metal complex represented by the formula (2-B1) or the formula (2-B2), since the light emitting device of the present invention is more excellent in luminance life.

When two or more kinds of the metal complexes represented by the formula (2) are contained in the composition of the present invention, the combination of at least two kinds of the metal complexes represented by the formula (2) is preferably a combination of two kinds selected from metal complexes represented by the formula (2-B1) to the formula (2-B5), more preferably a combination of two kinds of metal complexes represented by the formula (2-B1) or a combination of a metal complex represented by the formula (2-B1) with one kind selected from metal complexes represented by the formula (2-B2) to the formula (2-B5), further preferably a combination of two kinds of metal complexes represented by the formula (2-B1) or a combination of a metal complex represented by the formula (2-B1) with a metal complex represented by the formula (2-B2) or the formula (2-B3), particularly preferably a combination of a metal complex represented by the formula (2-B1) with a metal complex represented by the formula (2-B2), since the light emitting device of the present invention is more excellent in luminance life.

### [Other component]

The composition of the present invention may further contain at least one selected from the group consisting of a hole transporting material, a hole injection material, an electron transporting material, an electron injection material, a light emitting material (differing from a metal complex represented by the formula (1) and a metal complex represented by the formula (2)), an antioxidant and a solvent.

### [Host material]

It is preferable that the composition of the present invention further contains a host material having at least one function selected from hole injectability, hole transportability, electron injectability and electron transportability, since the light emitting device of the present invention is more excellent in luminance life. The composition of the present invention may contain one kind of the host material singly or may contain two or more kinds of the host materials.

When the composition of the present invention further contains the host material, the content of the host material is usually 1 to 99 parts by mass, preferably 10 to 90 parts by mass, more preferably 30 to 85 parts by mass, further preferably 50 to 80 parts by mass when the sum of the metal complex represented by the formula (1), the metal complex represented by the formula (2) and the host material is taken as 100 parts by mass.

It is preferable that the lowest excited triplet state (T₁) of the host material has higher energy level than the lowest excited triplet state (T₁) of the metal complex represented by the formula (1), since the light emitting device of the present invention is more excellent in luminance life.

The host material is preferably one showing solubility in a solvent which is capable of dissolving the metal complex represented by the formula (1) and the metal complex represented by the formula (2), since the light emitting device of the present invention can be fabricated by a wet method.

The host material is classified into a low molecular compound (low molecular host) and a polymer compound (polymer host), and the composition of the present invention may contain any host material. As the host material which may be contained in the composition of the present invention, low molecular compounds are preferable, and compounds represented by the formula (H-1) are more preferable.

Ar^{H1} and Ar^{H2} are each preferably a phenyl group, a fluorenyl group, a spirobifluorenyl group, a pyridyl group, a pyrimidinyl group, a triazinyl group, a quinolinyl group, an isoquinolinyl group, a thienyl group, a benzothienyl group, a dibenzothienyl group, a furyl group, a benzofuryl group, a dibenzofuryl group, a pyrrolyl group, an indolyl group, an azaindolyl group, a carbazolyl group, an azacarbazolyl group, a diazacarbazolyl group, a phenoxazinyl group or a phenothiazinyl group, more preferably a phenyl group, a fluorenyl group, a spirobifluorenyl group, a pyridyl group, a pyrimidinyl group, a triazinyl group, a dibenzothienyl group, a dibenzofuryl group, a carbazolyl group or an azacarbazolyl group, further preferably a fluorenyl group, a spirobifluorenyl group, a dibenzothienyl group, a dibenzofuryl group or a carbazolyl group, particularly preferably a group represented by the formula (TDA-3), and the foregoing groups optionally have a substituent.

The substituent which Ar^{H1} and Ar^{H2} optionally have is preferably a halogen atom, an alkyl group, a cycloalkyl group, an alkoxy group, a cycloalkoxy group, an aryl group or a monovalent hetero ring group, more preferably an alkyl group, a cycloalkoxy group, an alkoxy group or a cycloalkoxy group, further preferably an alkyl group or a cycloalkoxy group, and the foregoing groups optionally further have a substituent.

n^{H1} is preferably 1. n^{H2} is preferably 0.

n^{H3} is usually an integer of 0 or more and 10 or less, preferably an integer of 0 or more and 5 or less, further preferably an integer of 1 or more and 3 or less, particularly preferably 1.

n^{H11} is preferably an integer of 1 or more and 5 or less, more preferably an integer of 1 or more and 3 or less, further preferably 1.

R^{H11} is preferably a hydrogen atom, an alkyl group, a cycloalkyl group, an aryl group or a monovalent hetero ring group, more preferably a hydrogen atom, an alkyl group or a cycloalkyl group, further preferably a hydrogen atom or an alkyl group, and the foregoing groups optionally have a substituent.

L^{H1} is preferably an arylene group or a divalent hetero ring group, and the foregoing groups optionally further have a substituent.

L^{H1} is preferably a group represented by the formula (A-1) to the formula (A-3), the formula (A-8) to the formula (A-10), the formula (AA-1) to the formula (AA-6), the formula (AA-10) to the formula (AA-21) or the formula (AA-24) to the formula (AA-34), more preferably a group represented by the formula (A-1), the formula (A-2), the formula (A-8), the formula (A-9), the formula (AA-1) to the formula (AA-4), the formula (AA-10) to the formula (AA-15), the formula (AA-33) or the formula (AA-34), further preferably a group represented by the formula (A-1), the formula (A-2), the formula (A-8), the formula (AA-2), the formula (AA-4), the formula (AA-10), the formula (AA-12), the formula (AA-14) or (AA-33), particularly preferably a group represented by the formula (A-8), the formula (AA-10), the formula (AA-12) or the formula (AA-14), especially preferably a group represented by the formula (AA-14).

The substituent which L^{H1} optionally has is preferably a halogen atom, an alkyl group, a cycloalkyl group, an alkoxy group, a cycloalkoxy group, an aryl group or a monovalent hetero ring group, more preferably an alkyl group, an alkoxy group, an aryl group or a monovalent hetero ring group, further preferably an alkyl group, an aryl group or a monovalent hetero ring group, particularly preferably a monovalent hetero ring group, and the foregoing groups optionally further have a substituent.

L^{H21} is preferably a single bond or an arylene group, more preferably a single bond, and this arylene group optionally has a substituent.

The definitions and examples of the arylene group or the divalent hetero ring group represented by L^{H21} are the same as the definitions and examples of the arylene group or the divalent hetero ring group represented by L^{H1}.

R^{H21} is preferably an aryl group or a monovalent hetero ring group, and the foregoing groups optionally have a substituent.

The definitions and examples of the aryl group and the monovalent hetero ring group represented by R^{H21} are the same as the definitions and examples of the aryl group and the monovalent hetero ring group represented by Ar^{H1} and Ar^{H2}.

The definitions and examples of the substituent which R^{H21} optionally has are the same as the definitions and examples of the substituent which Ar^{H1} and Ar^{H2} optionally have.

The compound represented by the formula (H-1) is preferably a compound represented by the formula (H-2). 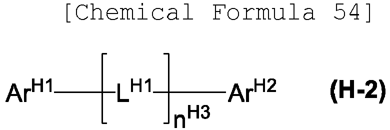 [wherein, Ar^{H1}, Ar^{H2}, n^{H3} and L^{H1} represent the same meaning as described above.]

As the compound represented by the formula (H-1), compounds represented by the following formulae and a low molecular compound HM-1 described later are exemplified.

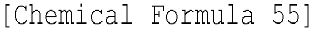

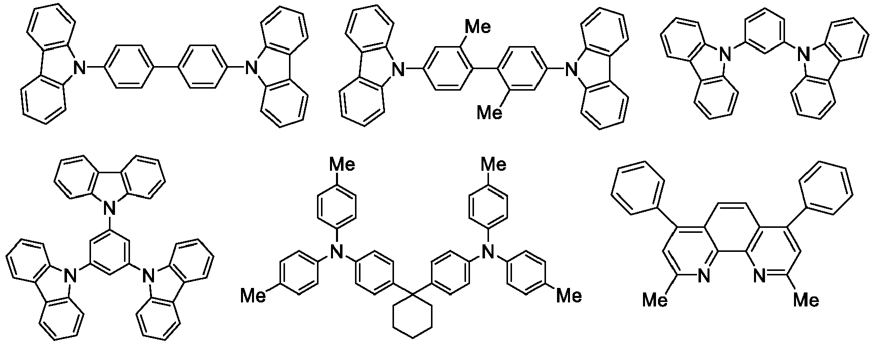

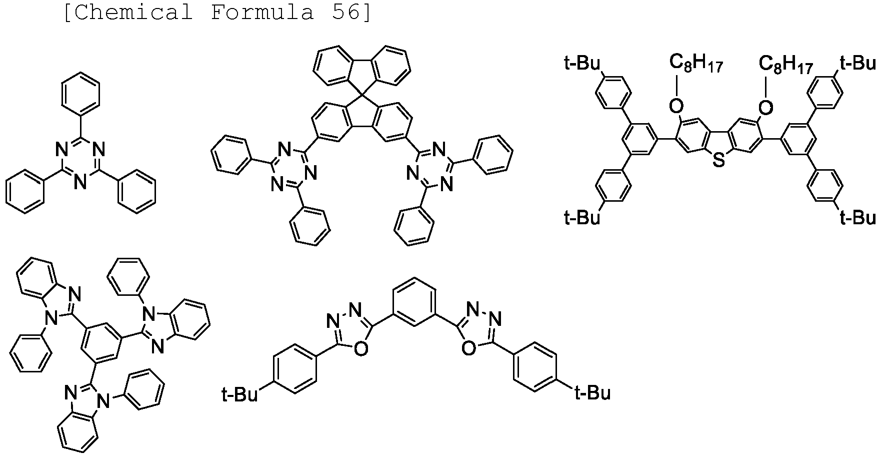

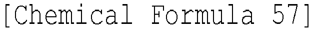

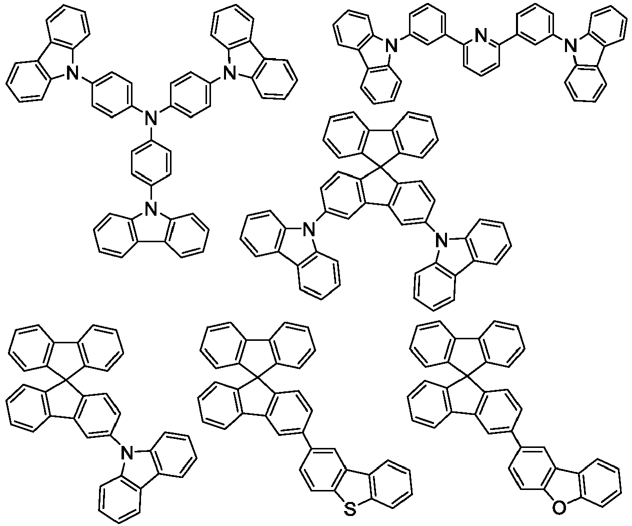

The polymer compound used for the host material includes, for example, polymer compounds as the hole transporting material described later and polymer compounds as the electron transporting material described later.

### [Hole transporting material]

The hole transporting material is classified into a low molecular compound and a polymer compound, and a polymer compound having a crosslinking group is preferable.

The low molecular compound includes, for example, aromatic amine compounds such as triphenylamine and derivatives thereof, N,N'-di-1-naphthyl-N,N'-diphenylbenzidine (a-NPD), N,N'-diphenyl-N,N'-di(m-tolyl)benzidine (TPD) and the like.

The polymer compound includes, for example, polyvinylcarbazole and derivatives thereof; and polyarylnene having an aromatic amine structure in the side chain or main chain and derivatives thereof. The polymer compound may also be a compound having an electron accepting site bound such as fullerene, tetrafluorotetracyanoquinodimethane, tetracyanoethylene and trinitrofluorenone and the like.

In the composition of the present invention, the compounding amount of the hole transporting material is usually 1 to 400 parts by mass when the sum of the metal complex represented by the formula (1) and the metal complex represented by the formula (2) is taken as 100 parts by mass.

The hole transporting material may be used singly or in combination of two or more kinds thereof.

### [Electron transporting material]

The electron transporting material is classified into a low molecular compound and a polymer compound. The electron transporting material may have a crosslinking group.

The low molecular compound includes, for example, a metal complex having 8-hydroxyquinoline as a ligand, oxadiazole, anthraquinodimethane, benzoquinone, naphthoquinone, anthraquinone, tetracyanoanthraquinodimethane, fluorenone, diphenyldicyanoethylene and diphenoquinone, and derivatives thereof.

The polymer compound includes, for example, polyphenylene, polyfluorene, and derivatives thereof. The polymer compound may be doped with a metal.

In the composition of the present invention, the compounding amount of the electron transporting material is, when the sum of the metal complex represented by the formula (1) and the metal complex represented by the formula (2) is taken as 100 parts by mass, usually 1 to 400 parts by mass.

The electron transporting material may be used singly or in combination of two or more kinds thereof.

### [Hole injection material and electron injection material]

The hole injection material and the electron injection material are each classified into a low molecular compound and a polymer compound. The hole injection material and the electron injection material may have a crosslinking group.

The low molecular compound includes, for example, metal phthalocyanines such as copper phthalocyanine and the like; carbon; oxides of metals such as molybdenum, tungsten and the like; metal fluorides such as lithium fluoride, sodium fluoride, cesium fluoride, potassium fluoride and the like.

The polymer compound includes, for example, polyaniline, polythiophene, polypyrrole, polyphenylenevinylene, polythienylenevinylene, polyquinoline and polyquinoxaline, and derivatives thereof; electrically conductive polymers such as a polymer containing an aromatic amine structure in the main chain or side chain, and the like.

In the composition of the present invention, the compounding amounts of the hole injection material and the electron injection material are each usually 1 to 400 parts by mass, when the sum of the metal complex represented by the formula (1) and the metal complex represented by the formula (2) is taken as 100 parts by mass.

The hole injection material and the electron injection material each may be used singly or in combination of two or more kinds thereof.

### [Ion doping]

When the hole injection material or the electron injection material contains an electrically conductive polymer, the electric conductivity of the electrically conductive polymer is preferably 1x10⁻⁵ S/cm to 1×10³ S/cm. For adjusting the electric conductivity of the electrically conductive polymer within such a range, the electrically conductive polymer can be doped with an appropriate amount of ions. The kind of the ion to be doped is an anion for the hole injection material and a cation for the electron injection material. The anion includes, for example, a polystyrenesulfonic ion, an alkylbenzenesulfonic ion and a camphor sulfonic ion. The cation includes, for example, a lithium ion, a sodium ion, a potassium ion and a tetrabutylammonium ion.

The ion to be doped may be used singly or in combination of two or more kinds thereof.

### [Light emitting material]

The light emitting material is classified into a low molecular compound and a polymer compound. The light emitting material may have a crosslinking group.

The low molecular compound includes, for example, naphthalene and derivatives thereof, anthracene and derivatives thereof, perylene and derivatives thereof, and triplet light emitting complexes containing iridium, platinum or europium as the central metal.

The triplet light emitting complex includes, for example, metal complexes shown below.

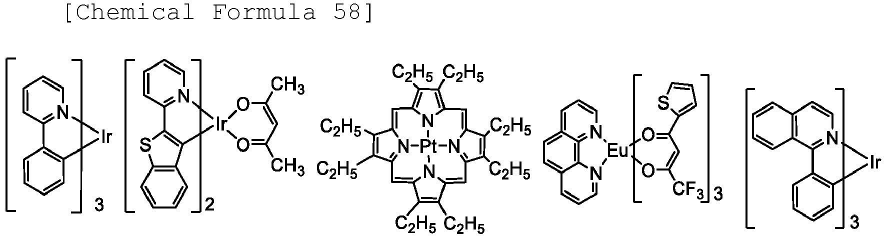

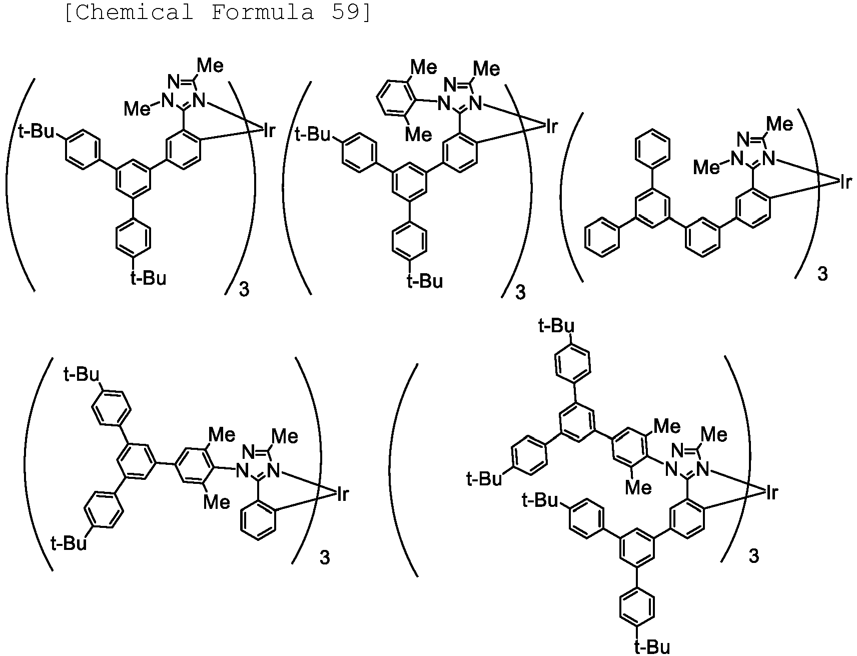

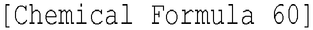

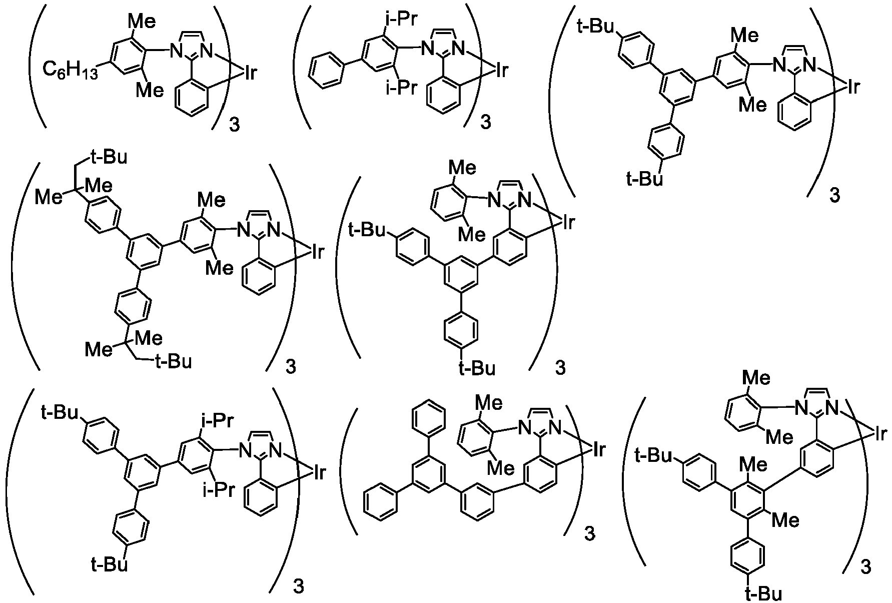

The polymer compound includes polymer compounds containing, for example, an arylene group such as a phenylene group, a naphthalenediyl group, a fluorenediyl group, a phenanthrenediyl group, a dihydrophenanthrenediyl group, an anthracenediyl group, a pyrenediyl group and the like; an aromatic amine residue such as a group obtained by removing from an aromatic amine two hydrogen atoms, and the like; and a divalent hetero ring group such as a carbazolediyl group, a phenoxazinediyl group, a phenothiazinediyl group and the like.

The light emitting material is preferably a triplet light emitting complex or a polymer compound.

In the composition of the present invention, the content of the light emitting material is usually 0.1 to 400 parts by mass, when the sum of the metal complex represented by the formula (1) and the metal complex represented by the formula (2) is taken as 100 parts by mass.

The light emitting material may be used singly or in combination of two or more kinds thereof.

### [Antioxidant]

The antioxidant may be a compound which is soluble in a solvent which is the same as the solvent for the metal complex represented by the formula (1) and the metal complex represented by the formula (2) and does not inhibit light emission and charge transportation, and includes, for example, phenol type antioxidants and phosphorus-based antioxidants.

In the composition of the present invention, the compounding amount of the antioxidant is usually 0.001 to 10 parts by mass, when the sum of the metal complex represented by the formula (1) and the metal complex represented by the formula (2) is taken as 100 parts by mass.

The antioxidant may be used singly or in combination of two or more kinds thereof.

### [Ink]

The composition containing the metal complex represented by the formula (1) and the metal complex represented by the formula (2) and a solvent (hereinafter, referred to as "ink") is suitable for fabrication of a light emitting device using a wet method such as an inkjet print method, a nozzle print method and the like. The viscosity of the ink may be adjusted according to the type of the wet method, and is preferably 1 to 20 mPa•s at 25°C.

The solvent contained in the ink is preferably a solvent capable of dissolving or uniformly dispersing solid components in the ink. The solvent includes, for example, chlorine-based solvents, ether type solvents, aromatic hydrocarbon type solvents, aliphatic hydrocarbon type solvents, ketone type solvents, ester type solvents, polyhydric alcohol type solvents, alcohol type solvents, sulfoxide type solvents and amide type solvents.

In the ink, the compounding amount of the solvent is usually 1000 to 100000 parts by mass, when the sum of the metal complex represented by the formula (1) and the metal complex represented by the formula (2) is taken as 100 parts by mass.

The solvent may be used singly or in combination of two or more kinds thereof.

### <Film>

The film contains the composition of the present invention, and is suitable as a light emitting layer in a light emitting device.

The film can be fabricated by a wet method such as, for example, a spin coat method, a casting method, a micro gravure coat method, a gravure coat method, a bar coat method, a roll coat method, a wire bar coat method, a dip coat method, a spray coat method, a screen printing method, a flexo printing method, an offset printing method, an ink jet method, a capillary coat method, a nozzle coat method and the like, using an ink.

The thickness of the film is usually 1 nm to 10 µm.

### <Light emitting device>

The light emitting device of the present invention contains the composition of the present invention.

The constitution of the light emitting device of the present invention has, for example, electrodes consisting of an anode and a cathode, and a layer containing the composition of the present invention disposed between the electrodes.

### [Layer constitution]

The layer containing the composition of the present invention is usually at least one layer selected from a light emitting layer, a hole transporting layer, a hole injection layer, an electron transporting layer and an electron injection layer, and is preferably a light emitting layer. These layers contain a light emitting material, a hole transporting material, a hole injection material, an electron transporting material and an electron injection material, respectively. These layers can be formed by dissolving a light emitting material, a hole transporting material, a hole injection material, an electron transporting material and an electron injection material in the solvent described above to prepare an ink and by using the same method as for fabrication of the film described above, using the prepared ink.

The light emitting device has a light emitting layer between an anode and a cathode. The light emitting device of the present invention preferably has at least one of a hole injection layer and a hole transporting layer between an anode and a light emitting layer from the standpoint of hole injectability and hole transportability, and preferably has at least one of an electron injection layer and an electron transporting layer between a cathode and a light emitting layer from the standpoint of electron injectability and electron transportability.

As the materials of the hole transporting layer, the electron transporting layer, the light emitting layer, the hole injection layer and the electron injection layer, hole transporting materials, electron transporting materials, light emitting materials, hole injection materials and electron injection materials described above and the like are mentioned, respectively, in addition to the materials in the composition of the present invention.

When the material of the hole transporting layer, the material of the electron transporting layer and the material of the light emitting layer are dissolved in a solvent used in forming a layer adjacent to the hole transporting layer, the electron transporting layer and the light emitting layer in fabrication of a light emitting device, it is preferable that the materials have a crosslinking group to avoid dissolving of the materials in the solvent. After forming each layer using the material having a crosslinking group, the crosslinking group can be cross-linked to insolubilize the layer.

The method for forming each of the light emitting layer, the hole transporting layer, the electron transporting layer, the hole injection layer, the electron injection layer and the like in the light emitting device of the present invention includes, when a low molecular compound is used, for example, a method of vacuum vapor deposition from a powder and a method of forming a film from a solution or melted state, and when a polymer compound is used, for example, a method of forming a film from a solution or melted state.

The order, the number and the thickness of layers to be laminated are adjusted in consideration of the external quantum efficiency and luminance life.

### [Substrate/electrode]

The substrate in the light emitting device may advantageously be a substrate on which an electrode can be formed and which does not change chemically in forming an organic layer, and is, for example, a substrate made of a material such as glass, plastic, silicon and the like. When an opaque substrate is used, it is preferable that the electrode farthest from the substrate is transparent or semi-transparent.

The material of the anode includes, for example, electrically conductive metal oxides and semi-transparent metals, preferably includes indium oxide, zinc oxide, tin oxide; electrically conductive compounds such as indium-tin-oxide (ITO), indium-zinc-oxide and the like; argentine-palladium-copper (APC) complex; NESA, gold, platinum, silver and copper.

The material of the cathode includes, for example, metals such as lithium, sodium, potassium, rubidium, cesium, beryllium, magnesium, calcium, strontium, barium, aluminum, zinc, indium and the like; alloys composed of two or more of them; alloys composed of at least one of them and at least one of silver, copper, manganese, titanium, cobalt, nickel, tungsten and tin; and graphite and graphite intercalation compounds. The alloy includes, for example, a magnesium-silver alloy, a magnesium-indium alloy, a magnesium-aluminum alloy, an indium-silver alloy, a lithium-aluminum alloy, a lithium-magnesium alloy, a lithium-indium alloy and a calcium-aluminum alloy.

The anode and the cathode each may have a laminated structure composed of two or more layers.

### [Application]

In order to obtain planar light emission using a light emitting device, the planar anode and the planar cathode may be arranged so as to overlap each other. In order to obtain patterned light emission, there are a method of installing a mask having a patterned window on the surface of a planar light emitting device, a method in which a layer to be formed as a non-light emitting part is formed extremely thick so as to cause substantially non light emission and a method of forming an anode or a cathode, or both electrodes in a pattern. A segment type display capable of displaying numerals, letters and the like can be obtained by forming a pattern by any one of these methods and disposing several electrodes so that several electrodes can be turned on and off independently. In order to obtain a dot matrix display, both the anode and the cathode may be formed in a stripe shape and arranged so as to be orthogonal to each other. Partial color display and multicolor display become possible by a method of separately coating plural kinds of polymer compounds having different emission colors or a method using a color filter or a fluorescence conversion filter. The dot matrix display can be driven passively or can be driven actively in combination with a TFT and the like. These displays can be used for displays of computers, televisions, portable terminals, and the like. The planar light emitting device can be suitably used as a planar light source for backlight of a liquid crystal display, or as a planar light source for illumination. If a flexible substrate is used, it can be used as a curved light source and a curved display.

### EXAMPLES

The present invention will be illustrated further in detail by examples below, but the present invention is not limited to these examples.

In examples, the polystyrene-equivalent number-average molecular weight (Mn) and the polystyrene-equivalent weight-average molecular weight (Mw) of a polymer compound were determined by size exclusion chromatography (SEC) described below using tetrahydrofuran as a mobile phase.

A polymer compound to be measured was dissolved at a concentration of about 0.05% by mass in tetrahydrofuran, and 10 µL of the solution was injected into SEC. The mobile phase was run at a flow rate of 1.0 mL/min. As the column, PLgel MIXED-B (manufactured by Polymer Laboratories) was used. As the detector, UV-VIS detector (manufactured by Tosoh Corp., trade name: UV-8320GPC)) was used.

LC-MS was measured by the following method.

A measurement sample was dissolved in chloroform or tetrahydrofucan so as to give a concentration of about 2 mg/mL, and about 1 µL of the solution was injected into LC-MS (manufactured by Agilent, trade name: 1290 Infinity LC and 6230 TOF LC/MS). As the mobile phase for LC-MS, acetonitrile and tetrahydrofuran were used while changing the ratio of them and run at a flow rate of 1.0 mL/min. As the column, SUMIPAX ODS Z-CLUE (manufactured by Sumika Chemical Analysis Service, Ltd., internal diameter: 4.6 mm, length: 250 mm, particle size: 3 µm) was used.

NMR was measured by the following method.

A measurement sample of 5 to 10 mg was dissolved in about 0.5 mL of deuterated chloroform (CDCl₃), deuterated tetrahydrofuran, deuterated dimethyl sulfoxide, deuterated acetone, deuterated N,N-dimethylformamide, deuterated toluene, deuterated methanol, deuterated ethanol, deuterated 2-propanol or deuterated methylene chloride, and NMR was measured using an NMR apparatus (manufactured by JEOL RESONANCE, trade name: JNM-ECZ400S/L1, or manufactured by Bruker, trade name: AVANCE600).

As an indicator of the purity of the compound, the value of high performance liquid chromatography (HPLC) area percentage was used. This value is a value by HPLC (trade name: LC-20A manufactured by Shimadzu Corp.) at UV = 254 nm unless otherwise stated. In this operation, the compound to be measured was dissolved in tetrahydrofuran or chloroform so as to give a concentration of 0.01 to 0.2% by mass, and 1 to 10 µL of the solution was poured into HPLC depending on the concentration. As the mobile phase of HPLC, acetonitrile/tetrahydrofuran were used while changing the ratio thereof from 100/0 to 0/100 (volume ratio), and flowed at a flow rate of 1.0 mL/min. As the column, SUMIPAX ODS Z-CLUE (manufactured by Sumika Chemical Analysis Service, Ltd., internal diameter: 4.6 mm, length: 250 mm, particle size: 3 µm) or an ODS column having the equivalent performance was used. As the detector, a photodiode array detector (trade name: SPD-M20A manufactured by Shimadzu Corp.) was used.

In the present example, the maximum peak wavelength of the emission spectrum of the metal complex was measured by a spectrophotometer (manufactured by JASCO Corp., FP-6500) at room temperature. The compound was dissolved in xylene at a concentration of about 0.8×10⁻⁴% by mass to prepare a xylene solution which was then used as a sample. As the excitation light, UV light having a wavelength of 325 nm was used.

### <Synthesis Example M1> Synthesis of compounds M1 to M5 and metal complex RM1

A compound M1 was synthesized according to a method described in International Publication WO 2015/145871.

A compound M2, a compound M4 and a compound M5 were synthesized according to a method described in International Publication WO 2013/146806.

A compound M3 was synthesized according to a method described in International Publication WO 2005/049546.

A metal complex RM1 was synthesized according to a method described in International Publication WO 2009/157424.

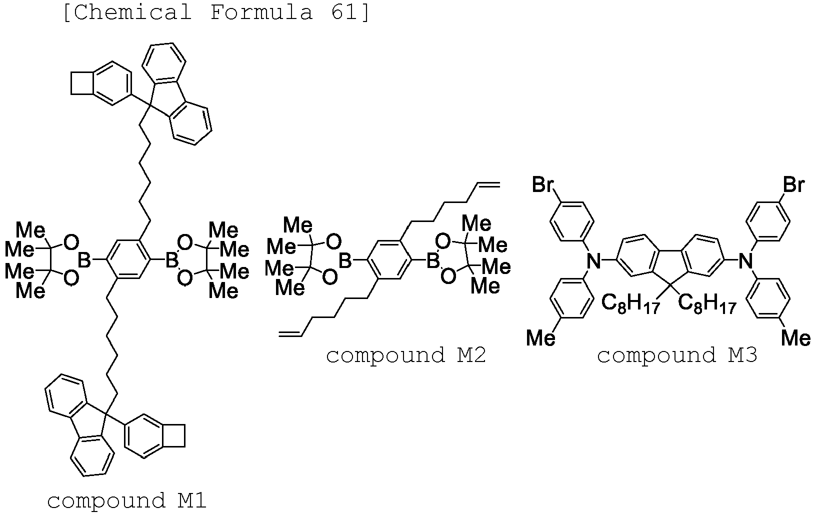

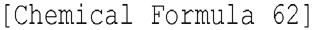

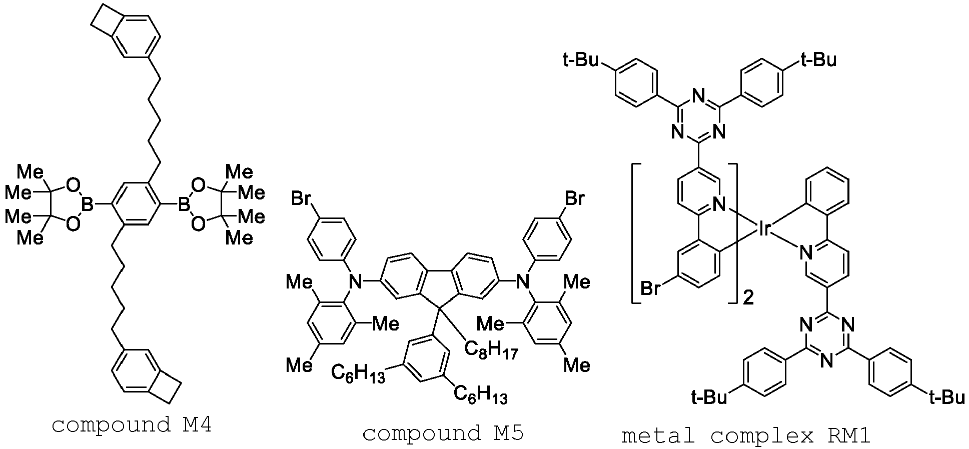

### <Synthesis Example HTL1> Synthesis of polymer compound HTL-1

A polymer compound HTL-1 was synthesized according to a method described in International Publication WO 2015/145871 using the compound M1, the compound M2 and the compound M3. The polymer compound HTL-1 had an Mn of 2.3×10⁴ and an Mw of 1.2×10⁵_{.}

The polymer compound HTL-1 is a copolymer constituted of a constitutional unit derived from the compound M1, a constitutional unit derived from the compound M2, a constitutional unit derived from the compound M3 at a molar ratio of 45:5:50, according to the theoretical values calculated from the amounts of the charged raw materials.

### <Synthesis Example HTL2> Synthesis of polymer compound HTL-2

An inert gas atmosphere was prepared in a reaction vessel, then, the compound M4 (2.52 g), the compound M2 (0.470 g), the compound M5 (4.90 g), the metal complex RM1 (0.530 g), dichlorobis(tris-o-methoxyphenylphosphine)palladium (4.2 mg) and toluene (158 mL) were added, and the mixture was heated at 100°C. A 20% by mass tetraethylammonium hydroxide aqueous solution (16 mL) was dropped into the reaction liquid, and the solution was refluxed for 8 hours. After the reaction, to this were added phenylboronic acid (116 mg) and dichlorobis(tris-o-methoxyphenylphosphine)palladium (4.2 mg), and the solution was refluxed for 15 hours. Thereafter, to this was added a sodium diethyldithiacarbamate aqueous solution, and the mixture was stirred at 85°C for 2 hours. After cooling, the reaction liquid was washed with 3.6% by mass hydrochloric acid, 2.5% by mass ammonia water and water, and the resultant solution was dropped into methanol, to generate a precipitate. The precipitate was dissolved in toluene, and purified by passing through an alumina column and a silica gel column in this order. The resultant solution was dropped into methanol, stirred, then, the resultant precipitate was collected by filtration, and dried, to obtain 6.02 g of a polymer compound HTL-2. The polymer compound HTL-2 had an Mn of 3.8×10⁴ and an Mw of 4.5×10⁵.

The polymer compound HTL-2 is a copolymer constituted of a constitutional unit derived from the compound M4, a constitutional unit derived from the compound M2, a constitutional unit derived from the compound M5, a constitutional unit derived from the metal complex RM1 at a molar ratio of 40:10:47:3, according to the theoretical values calculated from the amounts of the charged raw materials.

### <Synthesis Example ET1> Synthesis of polymer compound ET1

### (Synthesis of polymer compound ET1a)

According to a method described in JP-A No. 2012-33845, a compound ET1-1 and a compound ET1-2 were synthesized, and a polymer compound ET1a was synthesized using the synthesized compounds.

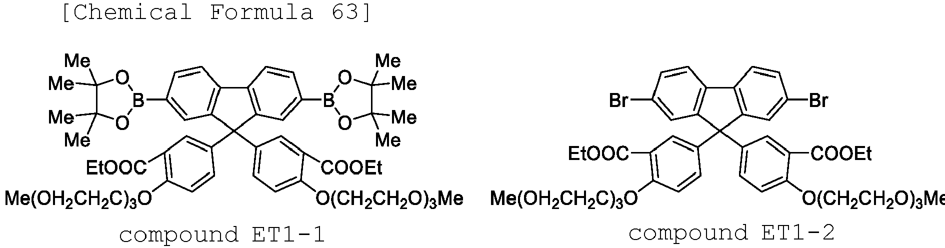

The polymer compound ET1a had an Mn of 5.2×10⁴.

The polymer compound ET1a is a copolymer constituted of a constitutional unit derived from the compound ET1-1, a constitutional unit derived from the compound ET1-2 at a molar ratio of 50:50, according to the theoretical values calculated from the amounts of the charged raw materials.

### (Synthesis of polymer compound ET1)

An inert gas atmosphere was prepared in a reaction vessel, then, the polymer compound ET1a (200 mg), tetrahydrofuran (20 mL) and ethanol (20 mL) were added, and the mixture was heated at 55°C. Thereafter, to this was added cesium hydroxide (200 mg) dissolved in water (2 mL), and the mixture was stirred at 55°C for 6 hours. Thereafter, the solution was cooled down to room temperature, then, concentrated under reduced pressure, to obtain a solid. The resultant solid was washed with water, then, dried under reduced pressure, to obtain a polymer compound ET1 (150 mg, pale yellow solid). According to the NMR spectrum of the resultant polymer compound ET1, it was confirmed that a signal derived from an ethyl group at an ethyl ester portion of the polymer compound ET1a has completely disappeared.

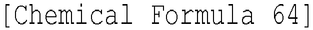

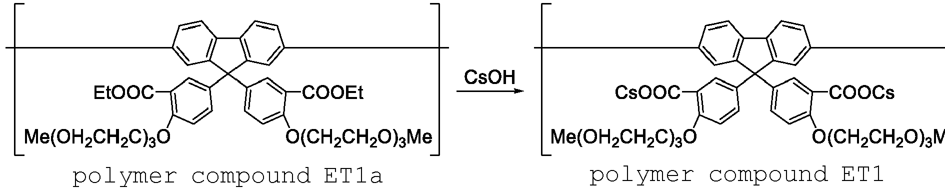

### <Synthesis Example BC1> Synthesis of metal complex BC1

A metal complex BC1 was synthesized according to a method described in International Publication WO 2016/185183.

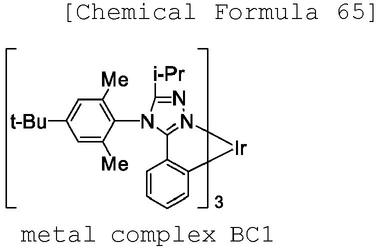

The maximum peak wavelength of the emission spectrum of the metal complex BC1 was 463 nm.

### <Synthesis Example BC2> Synthesis of metal complex BC2

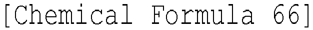

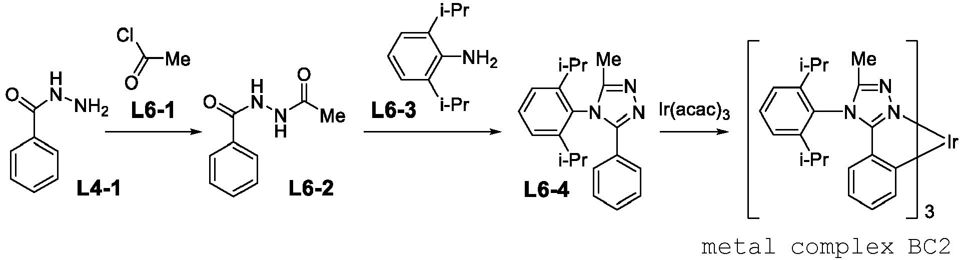

### (Synthesis of compound L6-2)

A nitrogen gas atmosphere was prepared in a reaction vessel, then, the compound L4-1 (100 g), triethylamine (114 mL) and tetrahydrofuran (1.5L) were added, and the mixture was stirred at 0°C. Thereafter, the compound L6-1 (52 mL) was dropped into this, then, the mixture was stirred at room temperature for 16 hours. The resultant reaction liquid was filtrated, then, the resultant filtrate was concentrated, to obtain a coarse product. The resultant coarse product was crystallized using ethyl acetate, then, dried under reduced pressure, to obtain a compound L6-2 (70 g). The HPLC area percentage value of the compound L6-2 was 98.7%.

The analysis results of the compound L6-2 were as described below.

LC-MS (APCI, positive): m/z = 179 [M+H]⁺

¹H-NMR (300 MHz, DMSO-d₆) δ (ppm) = 10.26 (br, 1H), 9.86 (br, 1H), 7.83-7.86 (m, 2H), 7.45-7.56 (m, 3H), 1.90 (s, 3H).

### (Synthesis of compound L6-4)

A nitrogen gas atmosphere was prepared in a reaction vessel, then, the compound L6-2 (70 g) and xylene (700 mL) were added, and the mixture was stirred at room temperature. Thereafter, to this was added phosphorus pentachloride (123 g), and the mixture was stirred at 130°C for 2 hours. The resultant reaction liquid was cooled down to room temperature, the compound L6-3 (70 g) was added, then, the mixture was stirred at 130°C for 8 hours. The resultant reaction liquid was cooled down to room temperature, concentrated under reduced pressure, then, ethyl acetate was added. The resultant organic layer was washed with ion exchanged water, 10% by mass sodium hydrogen carbonate aqueous solution and saturated saline in this order. The resultant organic layer was dried over sodium sulfate, then, filtrated, and the resultant filtrate was concentrated under reduced pressure, to obtain a coarse product. The resultant coarse product was purified by silica gel column chromatography (a mixed solvent of hexane and ethyl acetate), then, crystallized using a mixed solvent of N,N-dimethylformamide and water. The resultant solid was dried under reduced pressure, to obtain a compound L6-4 (70 g, white solid). The HPLC area percentage value of the compound L6-4 was 99.2%.

The analysis results of the compound L6-4 were as described below.

LC-MS (APCI, positive): m/z = 320 [M+H]⁺

¹H-NMR (400 MHz, CDCl₃) δ (ppm) = 7.53-7.58 (m, 1H), 7.48 (d, 2H), 7.33 (d, 2H), 7.28-7.30 (m, 1H), 7.21-7.25 (m, 2H), 2.39 (q, 2H), 2.26 (s, 3H), 1.14 (d, 6H), 0.87 (d, 6H) .

### (Synthesis of metal complex BC2)

A nitrogen gas atmosphere was prepared in a reaction vessel, then, tris(acetylacetonato)iridium(III) (1.2 g), the compound L6-4 (4.0g) and tridecane (1 mL) were added, and the mixture was stirred at 280°C for 18 hours. The resultant reaction liquid was cooled down to room temperature, then, purified by silica gel column chromatography (a mixed solvent of ethyl acetate and methanol), then, crystallized using a mixed solvent of toluene and acetonitrile. The resultant solid was dried under reduced pressure, to obtain a metal complex BC2 (1.7 g, yellow solid). The HPLC area percentage value of the metal complex BC2 was 99.5% or more.

The analysis results of the metal complex BC2 were as described below.

¹H-NMR (600 MHz, THF-ds) δ (ppm) = 7.56 (t, 3H), 7.42 (dd, 3H), 7.40 (dd, 3H), 6.87 (dd, 3H), 6.52 (td, 3H), 6.35 (td, 3H), 6.17 (dd, 3H), 2.83 (hept, 3H), 2.34 (hept, 3H), 2.10 (s, 9H), 1.23 (d, 9H), 0.98 (d, 9H), 0.96 (d, 9H), 0.92 (d, 9H).

The maximum peak wavelength of the emission spectrum of the metal complex BC2 was 464 nm.

### <Synthesis Example B1> Synthesis of metal complex B1

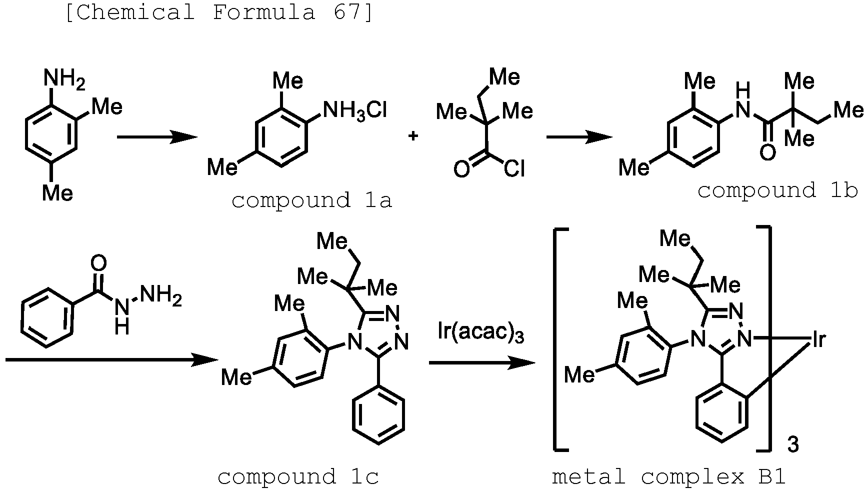

A nitrogen gas atmosphere was prepared in a reaction vessel, then, 2,4-dimethylaniline (200 g) and cyclopentyl methyl ether (400 mL) were added, and the mixture was stirred. Thereafter, the reaction vessel was cooled using an ice bath, then, a 16% by mass hydrogen chloride cyclopentyl methyl ether solution (357 g) was dropped into this. After dropping, stirring at room temperature was continued for 1 hour, the deposited solid was collected by filtration, and the resultant solid was washed with hexane (150 mL) . The resultant solid was crystallized using 2-propanol, and further, dried at room temperature under reduced pressure, to obtain a compound 1a (220 g, pale red solid).

A nitrogen gas atmosphere was prepared in a reaction vessel, then, the compound 1a (140 g), chloroform (2100 mL) and triethylamine (267 mL) were added, and the mixture was stirred. Thereafter, the reaction vessel was cooled using an ice bath, then, 2,2-dimethylbutyryl chloride (113 mL) was dropped into this. After dropping, stirring at room temperature was continued for 1 hour, then, to this was added a saturated sodium carbonate aqueous solution (400 mL), and the mixture was stirred at room temperature. The resultant reaction mixture was liquid-separated, then, the resultant organic layer was washed with a saturated sodium carbonate aqueous solution and ion exchanged water in series. Thereafter, the resultant organic layer was dried over magnesium sulfate, then, filtrated. The resultant filtrate was concentrated, then, to this was added heptane and the mixture was stirred for 1 hour, and the resultant solid was collected by filtration. Thereafter, the resultant solid was dried at 40°C under reduced pressure, to obtain a compound 1b (164 g, white solid). The HPLC area percentage value of the compound 1b was 99.5% or more.

The NMR measurement results of the compound 1b were as described below.

¹H-NMR (CDCl₃, 400 MHz) δ (ppm): 0.94 (3H, t), 1.29 (6H, s), 1.67 (2H, q), 2.21 (3H, s), 2.28 (3H, s), 6.99 (1H, s), 7.00 (1H, d), 7.12 (1H, br), 7.65 (1H, d).

An argon gas atmosphere was prepared in a reaction vessel, then, the compound 1b (60 g), monochlorobenzene (480 mL), 2-fluoropyridine (26 mL) and trifluoromethanesulfonic anhydride (50 mL) were added, and the mixture was stirred at room temperature for 30 minutes. Thereafter, to this was added benzhydrazide (41 g), then, the mixture was stirred at 90°C for 3 hours. Thereafter, the resultant reaction liquid was cooled down to room temperature, then, to this was added a sodium hydrogen carbonate aqueous solution (500 mL), and an organic layer was extracted. The resultant organic layer was washed with ion exchanged water, then, the resultant organic layer was concentrated under reduced pressure, to obtain a solid. The resultant solid was purified by silica gel column chromatography (a mixed solvent of chloroform and tetrahydrofuran), then, crystallized using a mixed solvent of 2-propanol and heptane. Thereafter, the resultant solid was dried at 50°C under reduced pressure, to obtain a compound 1c (70 g, yield 80%) as a white solid. The HPLC area percentage value of the compound 1c was 99.5% or more.

The measurement results of LC-MS and NMR of the compound 1c were as described below.

LC-MS (APCI, positive): m/z = 320 [M+H]⁺

¹H-NMR (600 MHz, CD₂Cl₂) δ (ppm): 7.42-7.37 (m, 2H), 7.35-7.31 (m, 2H), 7.29-7.25 (m, 2H), 7.19 (d, 1H), 7.07 (s, 1H), 2.40 (s, 3H), 1.79-1.72 (m, 4H), 1.57-1.45 (m, 1H), 1.34 (s, 3H), 1.15 (s, 3H), 0.89 (t, 3H).

An argon gas atmosphere was prepared in a reaction vessel, then, trisacetylacetonatoiridium (15.3 g), the compound 1c (40.0 g) and pentadecane (40 mL) were added, and the mixture was stirred for 50 hours under reflux with heating. Thereafter, to this was added toluene and the mixture was filtrated through a filter paved with silica gel, then, from the resultant silica gel, a yellow solution containing a metal complex B1 was extracted using a mixed solvent of toluene and ethyl acetate. The resultant solution was concentrated under reduced pressure, to obtain a solid. The resultant solid was purified by silica gel column chromatography (toluene solvent), then, crystallized using a mixed solvent of toluene and methanol. Thereafter, the resultant solid was dried at 50°C under reduced pressure, to obtain a metal complex B1 (30.5 g). The HPLC area percentage value of the metal complex B1 was 99.3%.

The measurement results of LC-MS of the metal complex B1 were as described below.

LC-MS (APCI, positive): m/z = 1149 [M+H]⁺

The maximum peak wavelength of the emission spectrum of the metal complex B1 was 463 nm.

### <Synthesis Example B2> Synthesis of metal complex B2

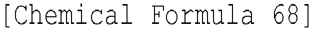

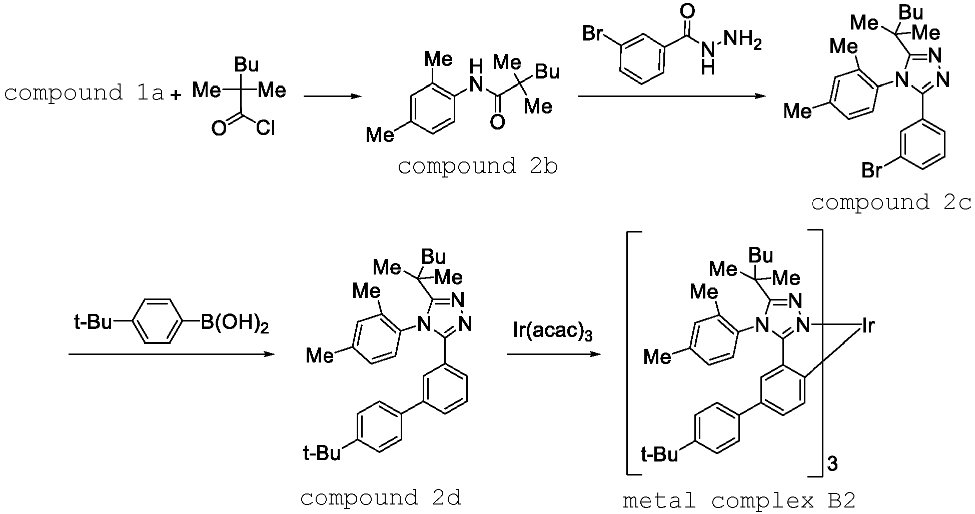

An argon gas atmosphere was prepared in a reaction vessel, then, 2,2'-dimethylhexanoic acid (40 g), chloroform (240 mL), N,N'-dimethylformamide (0.21 mL) and thionyl chloride (20 mL) were added, and the mixture was stirred at 45°C for 3 hours. Thereafter, the reaction vessel was cooled using a water bath, to obtain a reaction liquid containing 2,2'-dimethylhexanoyl chloride.

An argon gas atmosphere was prepared in a reaction vessel separately prepared, then, the compound 1a (41.5 g), chloroform (400 mL) and triethylamine (75 mL) were added, and the reaction vessel was cooled using an ice bath. Thereafter, the reaction liquid containing 2,2'-dimethylhexanoyl chloride obtained above was dropped into this. After dropping, stirring at room temperature was continued for 1 hour, then, to this was added a 2 mol/L sodium carbonate aqueous solution (280 mL), and the mixture was stirred at room temperature. The resultant reaction mixture was liquid-separated, to obtain an organic layer. The resultant organic layer was washed with ion exchanged water (280 mL). Thereafter, the resultant organic layer was dried over anhydrous magnesium sulfate, then, filtrated. The resultant filtrate was concentrated under reduced pressure, to obtain a compound 2b (60 g, yield 88%) as a pale yellow oil. The above-described operation was repeated, to secure a necessary amount of the compound 2b. The HPLC area percentage value of the compound 2b was 99.5% or more.

The measurement results of TLC-MS of the compound 2b were as described below.

TLC/MS (DART, positive): m/z = 248 [M+H]⁺

An argon gas atmosphere was prepared in a reaction vessel, then, the compound 2b (40 g), monochlorobenzene (320 mL), 2-fluoropyridine (14 mL) and trifluoromethanesulfonic anhydride (27 mL) were added, and the mixture was stirred at room temperature for 30 minutes. Thereafter, to this was added 3-bromobenzhydrazide (35 g), then, the mixture was stirred at 90°C for 7 hours. Thereafter, the resultant reaction liquid was cooled down to room temperature, then, to this was added a 2 mol/L sodium hydrogen carbonate aqueous solution (160 mL), the mixture was stirred, then, an organic layer was extracted. The resultant organic layer was washed with ion exchanged water. Thereafter, the resultant organic layer was concentrated under reduced pressure, to obtain an oil. The resultant oil was purified by silica gel column chromatography (a mixed solvent of chloroform and ethanol), to obtain a solid. The resultant solid was crystallized using heptane, then, further, dried at 50°C under reduced pressure, to obtain a compound 2c (48 g, yield 77%) as a white solid. The HPLC area percentage value of the compound 2c was 99.5% or more.

The measurement results of LC-MS and NMR of the compound 2c were as described below.

LC/MS (APPI, positive): m/z = 426 [M+H]⁺
¹H-NMR (400 MHz, CD₂Cl₂) δ (ppm) = 7.60-7.55 (m, 1H), 7.41 (d, 1H), 7.25 (d, 1H), 7.21-7.13 (m, 2H), 7.09-7.03 (m, 2H), 2.36 (s, 3H), 1.76-1.59 (m, 4H), 1.43-1.07 (m, 11H), 0.84 (t, 3H) .

An argon gas atmosphere was prepared in a reaction vessel, then, the compound 2c (2.2 g), 4-tert-butylphenylboronic acid (1.0 g), toluene (22 mL) and (di-tert-butyl(4-dimethylaminophenyl)phosphine)dichloropalladium(II) (18 mg) were added, and the mixture was heated up to 80°C. Thereafter, to this was added a 20% by mass tetrabutylammonium hydroxide aqueous solution (16 mL), then, the mixture was stirred under reflux with heating for 18 hours. Thereafter, the resultant reaction liquid was cooled down to room temperature, then, to this was added toluene, and an organic layer was extracted. The resultant organic layer was washed with ion exchanged water. Thereafter, the resultant organic layer was dried over anhydrous magnesium sulfate, then, filtrated through a filter paved with silica gel and Celite. The resultant filtrate was concentrated under reduced pressure, to obtain a solid. The resultant solid was purified by silica gel column chromatography (a mixed solvent of chloroform and ethanol), then, crystallized using heptane. Thereafter, the resultant solid was dried at 50°C under reduced pressure, to obtain a compound 2d (2.2 g, yield 85%) as a white solid. The HPLC area percentage value of the compound 2d was 99.5% or more.

The measurement results of LC-MS and NMR of the compound 2d were as described below.

LC-MS (APPI, positive): m/z = 480 [M+H]⁺

¹H-NMR (400 MHz, CD₂Cl₂) δ (ppm) = 7.53-7.48 (m, 1H), 7.46-7.39 (m, 2H), 7.40-7.37 (m, 2H), 7.34-7.29 (m, 2H), 7.26-7.19 (m, 3H), 7.07 (s, 1H), 2.40 (s, 3H), 1.74 (s, 3H), 1.70-1.61 (m, 1H), 1.47-1.36 (m, 1H), 1.34-1.30 (m, 12H), 1.29-1.14 (m, 4H), 1.12 (s, 3H), 0.86 (t, 3H)

An argon gas atmosphere was prepared in a reaction vessel, then, trisacetylacetonatoiridium (1.0 g), the compound 2d (2.0 g) and pentadecane (3 mL) were added, and the mixture was stirred under reflux with heating for 46 hours. Thereafter, to this was added toluene and the mixture was filtrated through a filter paved with silica gel, then, from the resultant silica gel, a yellow solution containing a metal complex B2 was extracted using a mixed solvent of toluene and ethyl acetate. The resultant solution was concentrated under reduced pressure, to obtain a solid, then, the resultant solid was washed with acetonitrile and heptane, and further, purified by silica gel column chromatography (a mixed solvent of toluene and ethyl acetate). Thereafter, the resultant solid was crystallized using a mixed solvent of toluene and acetonitrile, then, further, dried at 50°C under reduced pressure, to obtain a metal complex B2 (1.0 g) as a yellow solid. The HPLC area percentage value of the metal complex B2 was 98.8%.

The measurement results of LC-MS and NMR of the metal complex B2 were as described below.

LC-MS (APCI, positive): m/z = 1629 [M+H]⁺

¹H-NMR (400 MHz, CD₂Cl₂) δ (ppm) = 7.41-7.16 (m, 15H), 7.10-6.64 (m, 12H), 6.19-6.04 (m, 3H), 2.54-2.43 (m, 9H), 2.16-1.67 (m, 9H), 1.62-1.03 (m, 63H), 0.85-0.63 (m, 9H).

The maximum peak wavelength of the emission spectrum of the metal complex B2 was 476 nm.

### <Synthesis Example B3> Synthesis of metal complex B3

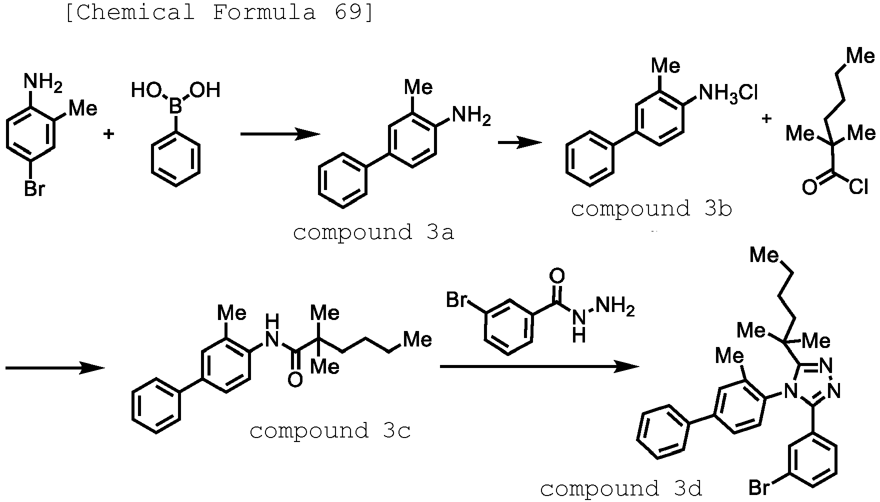

An argon gas atmosphere was prepared in a reaction vessel, then, 2-phenyl-4,4,5,5-tetramethyl-1,3,2-dioxaborolane (50 g), 2-methyl-4-bromoaniline (46 g), tris(dibenzylideneacetone)dipalladium(0) (3 g), 2-dicyclohexylphosphino-2',6'-dimethoxybiphenyl (4 g) and toluene (1 L) were added, and the mixture was stirred at room temperature. Thereafter, a 20% by mass tetraethylammonium hydroxide aqueous solution was dropped into this at room temperature, then, the mixture was stirred at 70°C for 5 hours. The resultant reaction liquid was cooled down to room temperature, then, the resultant reaction liquid was liquid-separated, to obtain an organic layer. The resultant organic layer was washed with ion exchanged water. Thereafter, the resultant organic layer was dried over magnesium sulfate, then, filtrated. The resultant filtrate was concentrated, then, to this were added tetrahydrofuran and activated white earth, and the mixture was stirred at room temperature for 30 minutes, then, an operation of filtrating through a filter paved with Celite was repeated twice. The resultant filtrate was concentrated under reduced pressure, then, to this were added toluene and activated carbon, and the mixture was stirred at room temperature for 30 minutes. Thereafter, the mixture was filtrated through a filter paved with Celite, and the resultant filtrate was concentrated. The above-described operation was repeated, to obtain a compound 3a (92 g, reddish brown oil). The GC area percentage value of the compound 3a was 99.5% or more.

A nitrogen gas atmosphere was prepared in a reaction vessel, then, the compound 3a (92 g) and cyclopentyl methyl ether (214 mL) were added, and the mixture was stirred. Thereafter, the reaction vessel was cooled using an ice bath, then, a 16% by mass hydrogen chloride cyclopentyl methyl ether solution (114 g) was dropped into this, then, heptane (649 mL) was dropped. After dropping, stirring at room temperature was continued for 1 hour, then, the deposited solid was collected by filtration, and the resultant solid was washed with heptane and acetone. The resultant solid was crystallized several times using 2-propanol, methanol, ethanol and heptane, then, the resultant solid was dried at room temperature under reduced pressure, to obtain a compound 3b (37 g, pale red solid). The above-described operation was repeated, to ensure a necessary amount of the compound 3b.

The measurement results of NMR of the compound 3b were as described below.

¹H-NMR (400 MHz, CDCl₃) δ (ppm) = 7.33-7.65 (8H, m), 4.85 (3H, s), 2.46 (3H, s).

An argon atmosphere was prepared in a reaction vessel, then, 2,2'-dimethylhexanoic acid (29 g), chloroform (174 mL) and N,N'-dimethylformamide (0.14 g) were added, and the mixture was stirred at 50°C. Thereafter, thionyl chloride (24 g) was dropped into this, then, the mixture was stirred at 50°C for 4 hours. Thereafter, the reaction vessel was cooled using a water bath, to prepare a reaction liquid containing 2,2'-dimethylhexanoyl chloride.

A nitrogen gas atmosphere was prepared in a reaction vessel separately prepared, then, the compound 3b (39 g), chloroform (290 mL) and triethylamine (47 mL) were added, and the mixture was stirred. Thereafter, the reaction vessel was cooled using an ice bath, then, the reaction liquid containing 2,2'-dimethylhexanoyl chloride prepared above was dropped into this. After dropping, stirring at room temperature was continued for 2 hours, then, to this was added a saturated sodium carbonate aqueous solution (300 mL), and the mixture was stirred at room temperature. The resultant reaction mixture was liquid-separated, to obtain an organic layer. The resultant organic layer was washed with a saturated sodium carbonate aqueous solution and ion exchanged water in series. Thereafter, the resultant organic layer was dried over magnesium sulfate, then, filtrated. The resultant filtrate was concentrated under reduced pressure, then, purified by silica gel column chromatography (a mixed solvent of hexane and ethyl acetate), to obtain an oil. To the resultant oil was added hexane, then, the resultant mixture was stirred for 1 hour while cooling using an acetone bath added with dry ice, to deposit a solid. Thereafter, the resultant solid was collected by filtration, and the resultant solid was dried at 50°C under reduced pressure, to obtain a compound 3c (40 g, white solid). The above-described operation was repeated, to ensure a necessary amount of the compound 3c. The HPLC area percentage value of the compound 3c was 99.5% or more.

The measurement results of NMR of the compound 3c were as described below.

¹H-NMR (400 MHz, CDCl₃) δ (ppm) = 7.98 (1H, d), 7.55 (1H, d), 7.42 (1H, t), 7.41 (4H, m), 7.31 (1H, t), 2.32 (3H, s), 1.62 (2H, s), 1.35 (10H, s), 0.91 (3H, s).

An argon gas atmosphere was prepared in a reaction vessel, then, the compound 3c (30 g), monochlorobenzene (300 mL), 2-fluoropyridine (9 mL) and trifluoromethanesulfonic anhydride (18 mL) were added, and the mixture was stirred at room temperature for 30 minutes. Thereafter, to this was added 2-bromobenzoylhydrazine (23 g), then, the mixture was stirred at 90°C for 3 hours. Thereafter, the resultant reaction liquid was cooled down to room temperature, then, to this was added a sodium hydrogen carbonate aqueous solution (300 mL), and an organic layer was extracted. The resultant organic layer was washed with ion exchanged water. Thereafter, the resultant organic layer was concentrated under reduced pressure, to obtain a solid. The resultant solid was washed with hexane, then, further, crystallized several times using 2-propanol, heptane and acetonitrile. Thereafter, the resultant solid was dried at 50°C under reduced pressure, to obtain a compound 3d (31 g) as a white solid. The HPLC area percentage value of the compound 3d was 99.5% or more.

The measurement results of LC-MS and NMR of the compound 3d were as described below.

LC-MS (APCI, positive): m/z = 488 [M+H]⁺

¹H-NMR (400 MHz, CDCl₃) δ (ppm) = 7.57-7.64 (m, 4H), 7.38-7.49 (m, 6H), 7.28-7.30 (d, 1H), 7.07 (t, 1H), 1.85 (3H, s), 1.67-1.74 (2H, m), 1.42-1.50 (1H, m), 1.39 (3H, s), 1.14-1.36 (3H, m), 1.17 (3H, s), 0.88 (3H, t).

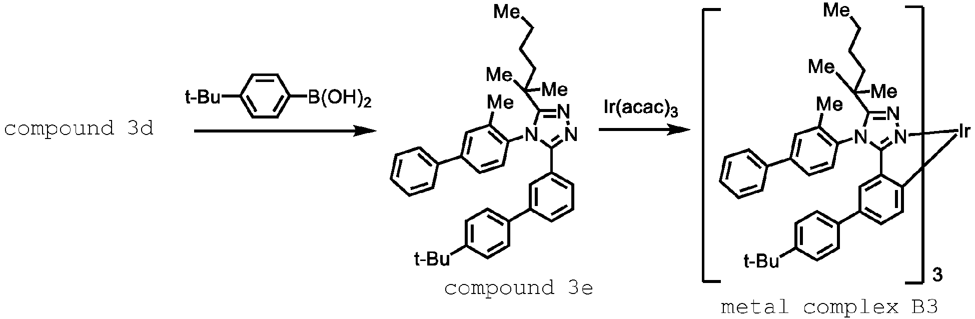

An argon gas atmosphere was prepared in a reaction vessel, then, the compound 3d (10 g), 4-tert-butylphenylboronic acid (4 g) and toluene were added, and the mixture was stirred at room temperature. Thereafter, to this was added bis(di-tert-butyl(4-dimethylaminobiphenyl)phosphine)dichloropalladium (72 mg), then, the mixture was heated to 90°C. Thereafter, a 20% by mass tetrabutylammonium hydroxide aqueous solution (64 g) was dropped into this, then, the mixture was stirred at 90°C for 3 hours. Thereafter, the reaction vessel was cooled down to room temperature, then, the resultant reaction mixture was liquid-separated. The resultant organic layer was washed with ion exchanged water twice. Thereafter, the resultant organic layer was dried over magnesium sulfate, then, filtrated. To the resultant filtrate was added activated carbon, and the mixture was stirred at room temperature for 30 minutes, then, filtrated through a filter paved with Celite. The resultant filtrate was concentrated under reduced pressure, then, to this was added hexane, and a solid was collected by filtration. The resultant solid was crystallized several times using hexane and 2-propanol, then, the resultant solid was dried at 50°C under reduced pressure, to obtain a compound 3e (9 g, white solid). The HPLC area percentage value of the compound 3e was 99.5% or more.

The measurement results of LC-MS and NMR of the compound 3e were as described below.

LC-MS (APCI, positive): m/z = 542 [M+H]⁺

¹H-NMR (400 MHz, CDCl₃) δ (ppm) = 7.63-7.68 (m, 4H), 7.31-7.52 (m, 8H), 7.25 (d, 2H), 7.15-7.17 (d, 2H), 1.88 (s, 3H), 1.43 (s, 3H), 1.28 (s, 9H), 1.21 (s, 3H), 1.45-1.78 (m, 1H), 1.17-1.39 (m, 5H), 0.88 (3H, t)

An argon gas atmosphere was prepared in a reaction vessel, then, trisacetylacetonatoiridium (1.1 g), the compound 3e (5.0g) and pentadecane (13 mL) were added, and the mixture was stirred for 48 hours under reflux with heating. Thereafter, to this was added toluene and the mixture was filtrated through a filter paved with silica gel, then, from the resultant silica gel, a yellow solution containing a metal complex B3 was extracted using a mixed solvent of toluene and ethyl acetate. The resultant solution was concentrated under reduced pressure, to obtain a solid, then, the resultant solid was purified by silica gel column chromatography (a mixed solvent of toluene and ethyl acetate), to obtain a solid. The resultant solid was crystallized using a mixed solvent of toluene and acetonitrile several times, and crystallized using a mixed solvent of toluene and hexane several times, respectively. Thereafter, the resultant solid was dried at 50°C under reduced pressure, to obtain a metal complex B3 (1.7 g, yellow solid). The HPLC area percentage value of the metal complex B3 was 98.3%.

The measurement results of NMR of the metal complex B3 were as described below.

¹H-NMR (400 MHz, CD₂Cl₂) δ (ppm) = 7.42-7.73 (24H, m), 6.97-7.11 (18H, m), 6.13-6.26 (3H, m), 2.23-2.27 (4H, m), 2.01 (1H, s), 1.94 (1H, s), 0.97-1.89 (34H, m), 1.88 (2H, d), 1.56 (3H, s), 1.20 (27H, s), 0.70-0.84 (9H, m).

The maximum peak wavelength of the emission spectrum of the metal complex B3 was 478 nm.

### <Synthesis Example B4> Synthesis of metal complex B4

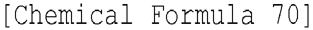

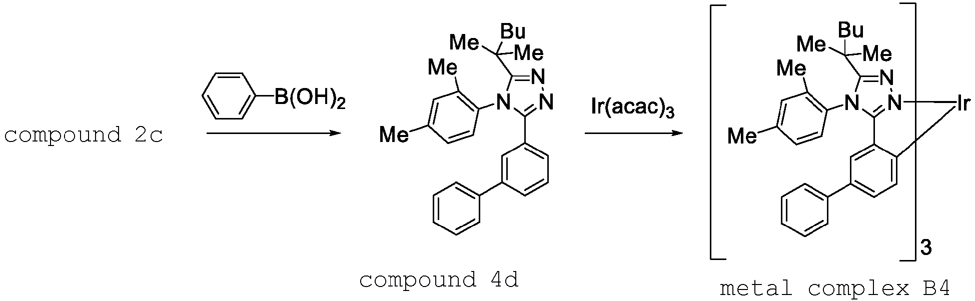

An argon gas atmosphere was prepared in a reaction vessel, then, the compound 2c (7.0g), phenylboronic acid (2.1 g), toluene (70 mL) and (di-tert-butyl(4-dimethylaminophenyl)phosphine)dichloropalladium(II) (58 mg) were added, and the mixture was heated up to 80°C. Thereafter, to this was added a 20% by mass tetrabutylammonium hydroxide aqueous solution (51 g), then, the mixture was stirred for 18 hours under reflux with heating. Thereafter, the resultant reaction liquid was cooled down to room temperature, then, to this was added toluene, and an organic layer was extracted. The resultant organic layer was washed with ion exchanged water, and further, dried over anhydrous magnesium sulfate, then, filtrated through a filter paved with silica gel and Celite. Thereafter, the resultant filtrate was concentrated under reduced pressure, to obtain a coarse product. The resultant coarse product was purified by silica gel column chromatography (a mixed solvent of chloroform and ethanol), then, further, dried at 50°C under reduced pressure, to obtain a compound 4d (4.7 g, yield 48%) as a colorless oil. The HPLC area percentage value of the compound 4d was 99.5% or more.

The measurement results of LC-MS and NMR of the compound 4d were as described below.

LC-MS (APPI, positive): m/z = 480 [M+H]⁺

¹H-NMR (400 MHz, CD₂Cl₂-d₂) δ (ppm) = 7.54-7.46 (m, 2H), 7.43-7.39 (m, 1H), 7.39-7.27 (m, 7H), 7.21 (d, 1H), 7.07 (s, 1H), 2.39 (s, 3H), 1.75 (s, 3H), 1.71-1.62 (m, 1H), 1.46-1.36 (m, 1H), 1.33 (s, 3H), 1.32-1.14 (m, 4H), 1.13 (s, 3H), 0.86 (t, 3H).

An argon gas atmosphere was prepared in a reaction vessel, then, trisacetylacetonatoiridium (1.5 g), the compound 4d (4.5 g) and pentadecane (14 mL) were added, and the mixture was stirred under reflux with heating for 46 hours. Thereafter, to this was added toluene and the mixture was filtrated through a filter paved with silica gel, then, from the resultant silica gel, a yellow solution containing a metal complex B4 was extracted using a mixed solvent of toluene and ethyl acetate. The resultant solution was concentrated under reduced pressure, to obtain a solid, then, the resultant solid was washed with acetonitrile and heptane, then, purified by silica gel column chromatography (a mixed solvent of toluene and ethyl acetate). Thereafter, the resultant solid was crystallized using a mixed solvent of toluene and acetonitrile, then, the resultant solid was dried at 50°C under reduced pressure, to obtain a metal complex B4 (3.2 g) as a yellow solid. The HPLC area percentage value of the metal complex B4 was 96.3%.

The measurement results of LC-MS and NMR of the metal complex B4 were as described below.

LC-MS (APCI, positive): m/z = 1629 [M+H]⁺

¹H-NMR (400 MHz, CD₂Cl₂) δ (ppm) = 7.41-7.17 (m, 15H), 7.15-6.67 (m, 15H), 6.21-6.06 (m, 3H), 2.53-2.43 (m, 9H), 2.16-2.05 (m, 5H), 1.90-1.67 (m, 4H), 1.62-0.99 (m, 36H), 0.83-0.62 (m, 9H) .

The maximum peak wavelength of the emission spectrum of the metal complex B4 was 476 nm.

### <Synthesis Example B5> Synthesis of metal complex B5

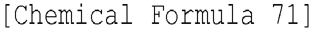

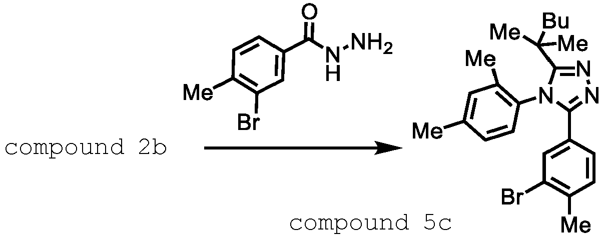

An argon gas atmosphere was prepared in a reaction vessel, then, the compound 2b (25.2 g), 2-fluoropyridine (10.8 g), chlorobenzene (202 mL) and trifluoroacetic anhydride (31.3 g) were added, and the mixture was stirred. Thereafter, the reaction vessel was cooled using a water bath, then, to this was added 2-bromo-3-methylbenzoylhydrazine (25.4 g), and the mixture was stirred at room temperature for 10 minutes. Thereafter, an aliquot of the reaction liquid was taken out, diluted with chloroform, then, HPLC measurement was performed, to confirm that the residual amount of the compound 2b became less than 2% (HPLC area percentage value), then, the reaction liquid was further stirred at 90°C for 7 hours. Thereafter, the reaction vessel was cooled down to room temperature, then, to this was added a sodium hydrogen carbonate aqueous solution (100 mL), and an organic layer was extracted. The resultant organic layer was washed with ion exchanged water. Thereafter, magnesium sulfate was added to the resultant organic layer and the layer was dried. Thereafter, to the dried organic layer was added 12.6 g of activated carbon, and the mixture was stirred, then, filtrated through a filter paved with Celite. The resultant filtrate was concentrated under reduced pressure, to obtain a solid. To the resultant solid were added chloroform and tetrahydrofuran, then, the mixture was filtrated through a filter paved with silica gel and Celite. Thereafter, the resultant filtrate was concentrated under reduced pressure, to obtain a solid. The resultant solid was crystallized using a mixed solvent of toluene and heptane. Thereafter, the resultant solid was dried at 50°C under reduced pressure, to obtain a compound 5c (36.2 g) as a white solid. The HPLC area percentage value of the compound 5c was 99.5% or more.

The measurement results of NMR of the compound 5c were as described below.

¹H-NMR (400 MHz, CD₂Cl₂-d₂) δ (ppm) = 7.61-7.53 (m, 1H), 7.28-7.21 (m, 1H), 7.21-7.12 (m, 1H), 7.12-7.01 (m, 3H), 2.34 (s, 3H), 2.30 (s, 3H), 1.75-1.60 (m, 5H), 1.42-1.08 (m, 10H), 0.85 (t, 3H).

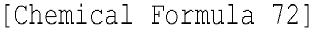

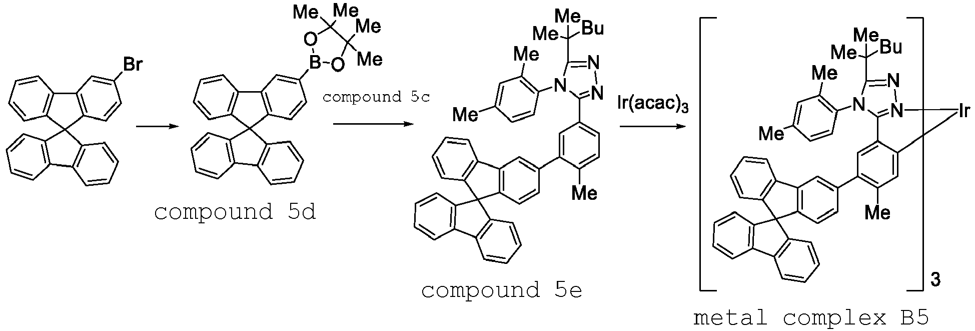

A nitrogen gas atmosphere was prepared in a reaction vessel, then, 3-bromospirofluorene (5.0g), bispinacolatodiboron (4.1 g), potassium acetate (4.9 g) and cyclopentyl methyl ether (125 mL) were added, and the mixture was stirred. Thereafter, to this was added [1,1'-bis(diphenylphosphino)ferrocene]palladium(II) dichloride dichloromethane (0.3 g), then, stirring at 90°C was continued for 16 hours. Thereafter, the reaction vessel was cooled down to room temperature, then, the resultant reaction liquid was liquid-separated. The resultant organic layer was washed with ion exchanged water (50 mL) twice. Thereafter, the resultant organic layer was dried over magnesium sulfate, then, filtrated, and the resultant filtrate was concentrated under reduced pressure, to obtain a solid. To the resultant solid were added toluene and activated carbon (1.4 g), and the mixture was stirred at room temperature for 1 hour, then, filtrated through a filter paved with Celite. The resultant filtrate was concentrated, to obtain a white solid. The resultant white solid was crystallized using toluene and acetonitrile, then, the resultant solid was dried at 50°C under reduced pressure, to obtain a compound 5d (4.5 g, white solid).

The measurement results of ¹H-NMR of the compound 5d were as described below.

¹H-NMR (CD₂Cl₂, 400 MHz) δ (ppm) = 1.33 (12H, m), 6.64 (4H, m), 7.06-7.23 (3H, m), 7.35 (3H, t), 7.51 (1H, d), 7.86 (2H, d), 7.91 (1H, d), 8.26 (1H, s).

An argon gas atmosphere was prepared in a reaction vessel, then, the compound 5c (1.7 g), the compound 5d (2.0 g), 40% by mass tetrabutylammonium hydroxide aqueous solution (5.9 g), ion exchanged water (5.9 g) and toluene (19.9 g) were added, and the mixture was stirred at room temperature. Thereafter, to this was added bis(di-tert-butyl(4-dimethylaminobiphenyl)phosphine)dichloropallad ium (0.03 g), then, the mixture was stirred at 80°C for 19 hours. Thereafter, the reaction vessel was cooled down to room temperature, then, the resultant reaction liquid was liquid-separated. The resultant organic layer was washed with ion exchanged water (27.0 g) twice. Thereafter, the resultant organic layer was dried over magnesium sulfate, then, filtrated. To the resultant filtrate was added activated carbon (0.5 g), and the mixture was stirred at room temperature for 1 hour, then, filtrated through a filter paved with Celite. The resultant filtrate was concentrated under reduced pressure, to obtain a solid. The resultant solid was purified by silica gel column chromatography (a mixed solvent of hexane and ethyl acetate), to obtain a solid. The resultant solid was crystallized several times using a mixed solvent of toluene and heptane, and a mixed solvent of toluene and acetonitrile. Thereafter, the resultant solid was dried at 50°C under reduced pressure. The above-described operation was repeated, to obtain a compound 5e (2.6 g, white solid). The HPLC area percentage value of the compound 5e was 99.5% or more.

The measurement results of ¹H-NMR of the compound 5e were as described below.

¹H-NMR (CD₂Cl₂, 400 MHz) δ (ppm) = 7.89-7.85 (m, 2H), 7.84-7.80 (m, 1H), 7.60-7.57 (m, 1H), 7.40-7.35 (m, 3H), 7.30-7.26 (m, 2H), 7.23 (d, 1H), 7.18-7.08 (m, 5H), 7.05 (br, 1H), 6.82 (dd, 1H), 6.74-6.63 (m, 4H), 2.32 (s, 3H), 2.27 (s, 3H), 1.76 (s, 3H), 1.69-1.59 (m, 1H), 1.44-1.37 (m, 1H), 1.32 (s, 3H), 1.29-1.15 (m, 4H), 1.09 (s, 3H), 0.85 (t, 3H).

An argon gas atmosphere was prepared in a reaction vessel, then, trisacetylacetonatoiridium (0.5 g), the compound 5e (2.5 g) and pentadecane (7.2 g) were added, and the mixture was stirred under reflux with heating for 46 hours. Thereafter, to this was added toluene (9.0 g) and the mixture was filtrated through a filter paved with silica gel (22.6 g), then, from the resultant silica gel, a yellow solution containing a metal complex B5 was extracted using a mixed solvent of toluene and ethyl acetate. The resultant solution was concentrated under reduced pressure, to obtain a solid, then, the resultant solid was purified by silica gel column chromatography (a mixed solvent of toluene and ethyl acetate), to obtain a solid. The resultant solid was crystallized using a mixed solvent of toluene and acetonitrile, then, dried at 50°C under reduced pressure, to obtain a metal complex B5 (0.7 g, yellow solid). The HPLC area percentage value of the metal complex B5 was 99.0%.

The measurement results of LC/MS and ¹H-NMR of the metal complex B5 were as described below.

LC/MS (APCI, positive): m/z = 2218 [M+H]⁺

¹H-NMR (CD₂Cl₂, 400 MHz) δ (ppm) = 7.90-7.82 (m, 9H), 7.51-7.34 (m, 15H), 7.27-7.09 (m, 15H), 6.90-6.78 (m, 3H), 6.75-6.59 (m, 12H), 6.57-6.51 (m, 3H), 5.88-5.78 (m, 3H), 2.25-2.05 (m, 27H), 2.01-1.83 (m, 6H), 1.47-1.06 (m, 30H), 0.89-0.72 (m, 9H).

The maximum peak wavelength of the emission spectrum of the metal complex B5 was 467 nm.

### <Synthesis Example B6> Synthesis of metal complex B6

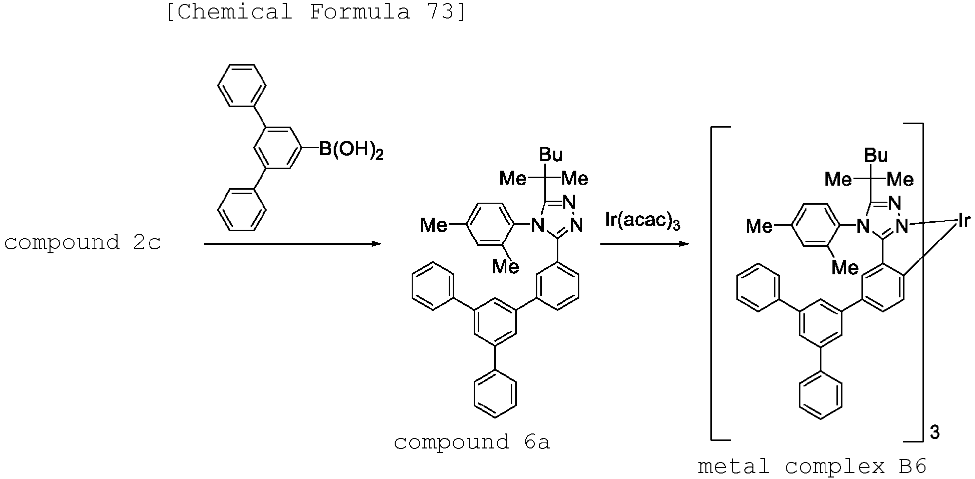

An argon gas atmosphere was prepared in a reaction vessel, then, the compound 2c (13.0 g), 5'-m-terphenylboronic acid (9.2 g), bis(di-t-butyl(4-dimethylaminobiphenyl)phosphine)dichloropalladium (0.1 g) and toluene (100 mL) were added, and the mixture was stirred at room temperature. Thereafter, to this was added a 40% by mass tetrabutylammonium hydroxide aqueous solution (49 mL), then, the mixture was stirred at 90°C for 21 hours. Thereafter, the reaction vessel was cooled down to room temperature, then, the resultant reaction liquid was liquid-separated. The resultant organic layer was washed with ion exchanged water. Thereafter, the resultant organic layer was dried over magnesium sulfate, then, filtrated. To the resultant filtrate was added activated carbon (3.0 g), and the mixture was stirred at room temperature for 1 hour, then, filtrated through a filter paved with Celite. The resultant filtrate was concentrated under reduced pressure, to obtain a coarse product. The resultant coarse product was purified by silica gel column chromatography (a mixed solvent of chloroform and ethanol), to obtain an oil. To the resultant oil were added methanol and activated carbon, and the mixture was stirred at room temperature for 1 hour, then, filtrated through a filter paved with Celite. The resultant filtrate was concentrated under reduced pressure, to obtain a white solid. The resultant solid was crystallized using a mixed solvent of heptane and 2-propanol, and the resultant solid was dried at 50°C under reduced pressure, to obtain a compound 6a (11.3 g, white solid). The HPLC area percentage value of the compound 6a was 99.5% or more.

The measurement results of ¹H-NMR of the compound 6a were as described below.

¹H-NMR (400 MHz, CD₂Cl₂) δ (ppm) = 7.80-7.25 (m, 18H), 7.20-7.07 (m, 1H), 7.01 (t, 1H), 2.19-2.09 (t, 3H), 1.84-1.56 (m, 5H), 1.45-1.06 (m, 10H), 0.94-0.86 (m, 3H).

An argon gas atmosphere was prepared in a reaction vessel, then, trisacetylacetonatoiridium (2.1 g), the compound 6a (10 g) and pentadecane (50 mL) were added, then, the mixture was stirred for 63 hours under reflux with heating. Thereafter, the reaction vessel was cooled down to room temperature, to this was added 2-propanol (100 mL), and the deposited solid was collected by filtration. The resultant solid was washed with a mixed solvent of dichloromethane and acetonitrile, to obtain a yellow solid (5.5 g). The resultant solid was purified by silica gel column chromatography (a mixed solvent of toluene and ethyl acetate), then, crystallized using a mixed solvent of dichloromethane and ethanol, a mixed solvent of toluene and acetonitrile, and a mixed solvent of toluene and heptane. Further, the resultant solid was purified by reverse phase silica gel column chromatography (a mixed solvent of methylene chloride and acetonitrile), then, crystallized using a mixed solvent of toluene and ethanol. Thereafter, the resultant solid was dried at 50°C under reduced pressure, to obtain a metal complex B6 (3.0 g, yellow solid). The HPLC area percentage value of the metal complex B6 was 99.5% or more.

The measurement results of ¹H-NMR of the metal complex B6 were as described below.

¹H-NMR (400 MHz, CD₂Cl₂) δ (ppm) = 7.66-7.56 (m, 15H), 7.51-7.19 (m, 27H), 7.17-6.80 (m, 12H), 6.41-6.26 (m, 3H), 2.34-2.49 (m, 6H), 1.96-1.80 (m, 12H), 1.63-1.00 (m, 36H), 0.89-0.65 (m, 9H).

The maximum peak wavelength of the emission spectrum of the metal complex B6 was 477 nm.

### <Synthesis Example B7> Synthesis of metal complex B7

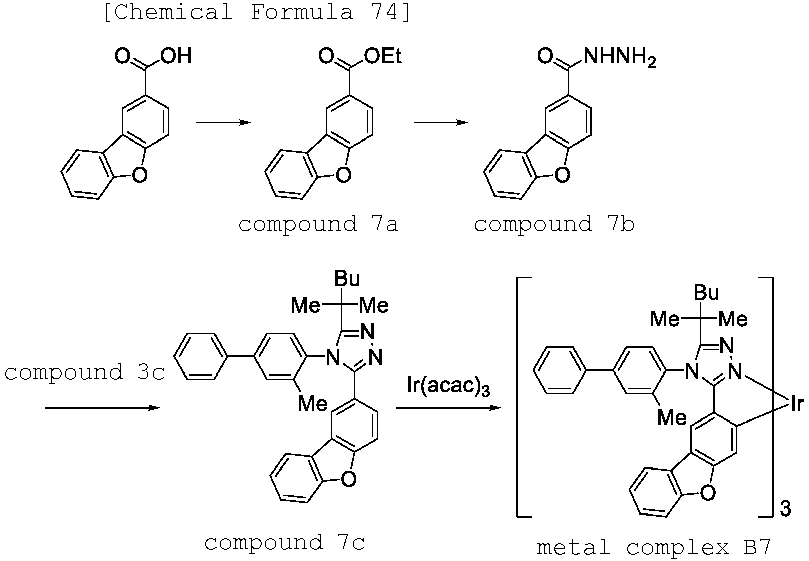

An argon gas atmosphere was prepared in a reaction vessel, then, 2-dibenzofurancarboxylic acid (20.0 g), sulfuric acid (1.8 g) and ethanol (600 mL) were added, the mixture was stirred at 80°C for 45 hours, then, the resultant reaction liquid was adjusted to room temperature. The above-described operation was repeated twice, then, the resultant two reaction liquids were combined. The resultant combined reaction liquid was concentrated, then, to this was added ethyl acetate (400 mL), and the solution was concentrated. To the resultant condensate were added ethyl acetate (200 mL) and ion exchanged water (200 mL), and an organic layer was extracted. The resultant organic layer was washed with a sodium carbonate aqueous solution (200 mL), then, the resultant organic layer was washed with ion exchanged water (200 mL). Thereafter, the resultant organic layer was dried over magnesium sulfate, then, filtrated through a filter paved with Celite and silica gel. The resultant filtrate was concentrated under reduced pressure, to obtain an oil. Thereafter, the resultant oil was dried at 50°C under reduced pressure, to obtain a compound 7a (39.4 g) as a pale yellow oil. The HPLC area percentage value of the compound 7a was 99.0%.

The measurement results of ¹H-NMR of the compound 7a were as described below.

¹H-NMR (400 MHz, CD₂Cl₂) δ (ppm) = 1.40 (3H, t), 4.39 (2H, q), 7.38 (1H, dt), 7.50 (1H, dt), 7.59 (2H, d), 8.02 (1H, dd), 8.16 (1H, dd), 8.67 (1H, d).

Argon gas atmosphere was prepared in a reaction vessel, then, the compound 7a (40.0 g), ethanol (360 mL), ion exchanged water (40 mL) and hydrazine monohydrate (125.0 g) were added, then, the mixture was stirred at 80°C for 6 hours. Thereafter, the reaction liquid was cooled down to room temperature, then, to this was added ion exchanged water (300 mL), and the mixture was stirred at 0°C for 1 hour, to generate a solid. The resultant solid was collected by filtration, then, the resultant solid was washed with ion exchanged water (200 mL) twice, and further, washed with 50% ethanol water (200 mL) once. To the resultant solid was added 2-propanol (565 mL), then, the mixture was suspended by stirring. Thereafter, the solid was collected by filtration, and the resultant solid was dried at 50°C under reduced pressure, to obtain a compound 7b (34.5 g) as a white solid. The HPLC area percentage value of the compound 7b was 97.1%,

The measurement results of ¹H-NMR of the compound 7b were as described below.

¹H-NMR (400 MHz, CD₃OD) δ (ppm) = 4.84 (2H, s), 7.39 (1H, dt), 7.52 (1H, dt), 7.60 (1H, dd), 7.64 (1H, d), 7.93 (1H, dd), 8.07 (1H, dd), 8.48 (1H, d).

Argon gas atmosphere was prepared in a reaction vessel, then, the compound 3c (22.0 g), monochlorobenzene (220 mL), 2-fluoropyridine (6.7 mL) and trifluoromethanesulfonic anhydride (12.8 mL) were added, and the mixture was stirred at room temperature. Thereafter, to this was added the compound 7b (17.7 g), then, the mixture was stirred at 85°C for 3 hours. Thereafter, the resultant reaction liquid was cooled down to room temperature, then, to this was added a sodium hydrogen carbonate aqueous solution (78 mL), and an organic layer was extracted. The resultant organic layer was washed with ion exchanged water (88 mL). Thereafter, the resultant organic layer was dried over magnesium sulfate, then, filtrated. The resultant filtrate was concentrated under reduced pressure, then, the resultant solid was washed with hexane. Thereafter, the resultant solid was crystallized using acetonitrile, then, further, dried at 50°C under reduced pressure, to obtain a compound 7c (28.2 g) as a white solid. The HPLC area percentage value of the compound 7c was 99.5% or more.

The measurement results of ¹H-NMR of the compound 7c were as described below.

¹H-NMR (400 MHz, CD₂Cl₂) δ (ppm) = 0.89 (3H, t), 1.18 (3H, s), 1.20-1.35 (3H, m), 1.39 (3H, m), 1.46 (1H, dt), 1.63 (1H, m), 1.66-1.75 (1H, m), 1.83-(3H, s), 7.29 (1H, dt), 7.34-7.66 (12H, m), 7.80 (1H, dd), 8.02 (1H, d).

An argon gas atmosphere was prepared in a reaction vessel, then, trisacetylacetonatoiridium (4.4 g), the compound 7c (18.0 g) and pentadecane (90 mL) were added, and the mixture was stirred for 66 hours under reflux with heating. Thereafter, the resultant reaction liquid was cooled down to room temperature, then, to this was added 2-propanol (90 mL), to generate a solid. The resultant solid was collected by filtration, then, to the resultant solid was added toluene (15 mL) and the mixture was filtrated through a filter paved with silica gel (76 g). Thereafter, from the resultant silica gel, a yellow solution containing a metal complex B7 was extracted using a mixed solvent of toluene and ethyl acetate. The resultant solution was concentrated under reduced pressure, then, the resultant solid was purified by silica gel column chromatography (a mixed solvent of toluene and ethyl acetate), to obtain a solid. The resultant solid was crystallized with a mixed solvent of toluene and ethanol, then, further, dried at 50°C under reduced pressure, to obtain a metal complex B7 (7.0 g, yellow solid). The HPLC area percentage value of the metal complex B7 was 98.3%.

The measurement results of LC/MS and ¹H-NMR of the metal complex B7 were as described below.

LC/MS (APCI, positive): m/z = 1688.8 [M+H]⁺
¹H-NMR (400 MHz, CD₂Cl₂) δ (ppm) = 0.49-0.86 (10H, m), 0.94-1.70 (35H, m), 1.81-1.91 (4H, m), 2.23-2.32 (5H, m), 6.51-6.59 (3H, m), 6.78-7.27 (15H, m), 7.43-7.81 (24H, m).

The maximum peak wavelength of the emission spectrum of the metal complex B7 was 452 nm.

### <Synthesis Example B8> Synthesis of metal complex B8

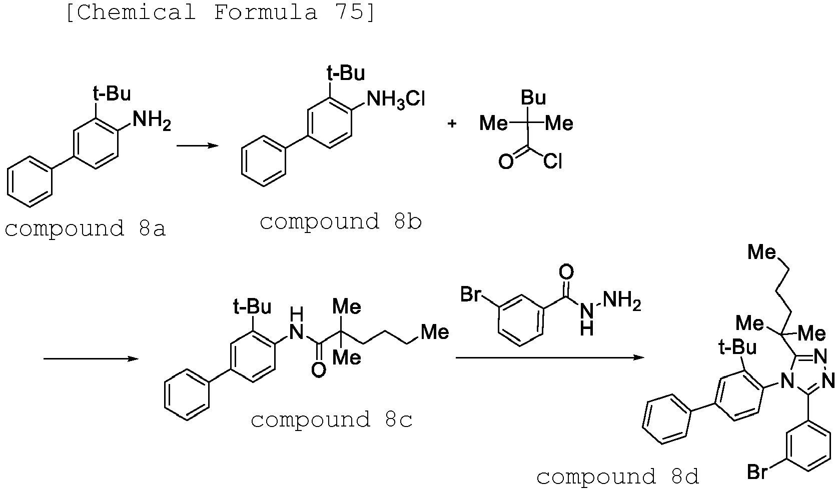

A nitrogen gas atmosphere was prepared in a reaction vessel, then, the compound 8a (27.5 g) and cyclopentyl methyl ether (55 g) were added, and the mixture was stirred. Thereafter, the reaction vessel was cooled using an ice bath, then, a 16% by mass hydrogen chloride cyclopentyl methyl ether solution (27.8 g) was dropped into this. Thereafter, heptane (110 g) was dropped into this, then, stirring at room temperature was continued for 1 hour, and the deposited solid was collected by filtration. The resultant solid was washed with heptane and cyclopentyl methyl ether, then, further, dried under reduced pressure, to obtain a compound 8b (29 g).

A nitrogen gas atmosphere was prepared in a reaction vessel, then, 2,2'-dimethylhexanoic acid (17.3 g), chloroform (114 g) and N,N'-dimethylformamide (0.04 g) were added, and the mixture was stirred at 50°C. Thereafter, thionyl chloride (15.0 g) was dropped into this, then, the mixture was stirred at 40°C for 3 hours, to generate 2,2'-dimethylhexanoyl chloride. Thereafter, the reaction vessel was cooled using a water bath, to obtain a reaction liquid containing 2,2'-dimethylhexanoyl chloride.

A nitrogen gas atmosphere was prepared in a reaction vessel separately prepared, then, the compound 8b (28.5 g), chloroform (114 g) and triethylamine (39.7 g) were added, and the mixture was stirred. Thereafter, the reaction vessel was cooled using an ice bath, then, the reaction liquid containing 2,2'-dimethylhexanoyl chloride prepared above was dropped into this, then, the mixture was stirred at 40°C for 5 hours. Thereafter, the resultant reaction liquid was cooled down to room temperature, then, ion exchanged water was dropped into this. Thereafter, an aqueous layer was removed, then, the resultant organic layer was washed with ion exchanged water, and further, concentrated under reduced pressure, to obtain a coarse product. The resultant coarse product was purified by silica gel column chromatography (a mixed solvent of toluene and ethyl acetate), then, further, crystallized using heptane. Thereafter, the resultant solid was dried at 50°C under reduced pressure, to obtain a compound 8c (26.4 g). The HPLC area percentage value of the compound 8c was 99.5% or more.

The measurement results of NMR of the compound 8c were as described below.

¹H-NMR (CD₂Cl₂, 400 MHz) δ (ppm) = 7.64-7.60 (m, 2H), 7.59-7.55 (m, 2H), 7.44-7.39 (m, 3H), 7.36 (br, 1H), 7.34-7.29 (m, 1H), 1.65-1.57 (m, 2H), 1.43 (s, 9H), 1.36-1.27 (m, 10H), 0.92-0.87 (m, 3H).

An argon gas atmosphere was prepared in a reaction vessel, then, the compound 8c (5.5 g), monochlorobenzene (28 g), 2-fluoropyridine (1.7 g) and trifluoromethanesulfonic anhydride (4.9 g) were added, and the mixture was stirred at room temperature for 1 hour. Thereafter, to this was added 3-bromobenzhydrazide (3.7 g), then, the mixture was stirred at 110°C for 17 hours. Thereafter, the resultant reaction liquid was cooled down to room temperature, then, to this was added a 2 mol/L sodium hydrogen carbonate aqueous solution (30 g). Thereafter, an aqueous layer was removed, then, the resultant organic layer was washed with ion exchanged water, and further, concentrated under reduced pressure, to obtain a coarse product. The resultant coarse product was purified by silica gel column chromatography (a mixed solvent of hexane and ethyl acetate), then, further, dried at 50°C under reduced pressure, to obtain a compound 8d (5.3 g). The HPLC area percentage value of the compound 8d was 99.1%.

The measurement results of NMR of the compound 8d were as described below.

¹H-NMR (CD₂Cl₂, 400 MHz) δ (ppm) = 7.79 (d, 1H), 7.69-7.64 (m, 2H), 7.61 (dd, 1H), 7.55 (dd, 1H), 7.53-7.47 (m, 2H), 7.46-7.39 (m, 2H), 7.35 (d, 1H), 7.34-7.27 (m, 1H), 7.12 (t, 1H), 2.00-1.86 (m, 1H), 1.59-1.50 (m, 1H), 1.44-1.26 (m, 6H), 1.25-1.13 (m, 4H), 0.99-0.88 (m, 12H).

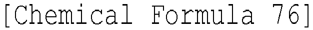

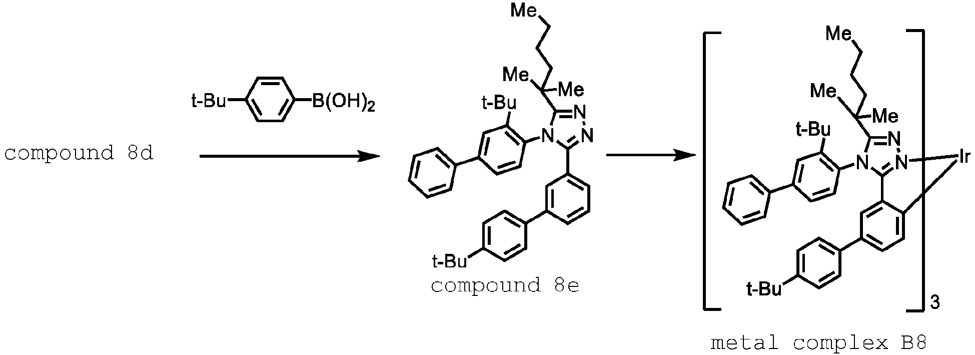

An argon gas atmosphere was prepared in a reaction vessel, then, the compound 8d (5.2 g), 4-tert-butylphenylboronic acid (2.1 g), toluene (52 g) and (di-tert-butyl(4-dimethylaminophenyl)phosphine)dichloropalladium(II) (67 mg) were added, and the mixture was heated up to 80°C. Thereafter, to this was added a 20% by mass tetrabutylammonium hydroxide aqueous solution (30 mL), then, the mixture was stirred for 70 hours under reflux with heating. Thereafter, the resultant reaction liquid was cooled down to room temperature, then, to this was added toluene and the mixture was filtrated through a filter paved with silica gel and Celite. The resultant filtrate was concentrated under reduced pressure, to obtain a solid. The resultant solid was purified by silica gel column chromatography (a mixed solvent of hexane and chloroform), and further, crystallized using a mixed solvent of toluene and heptane, then, the resultant solid was dried at 50°C under reduced pressure, to obtain a compound 8e (3.9 g). The HPLC area percentage value of the compound 8e was 99.5% or more.

The measurement results of NMR of the compound 8e were as described below.

¹H-NMR (CD₂Cl₂, 400 MHz) δ (ppm) = 7.82 (d, 1H), 7.73-7.66 (m, 3H), 7.64 (dd, 1H), 7.55-7.47 (m, 3H), 7.47-7.35 (m, 3H), 7.23-7.16 (m, 3H), 7.09-7.03 (m, 2H), 2.01-1.90 (m, 1H), 1.60-1.50 (m, 1H), 1.44-1.16 (m, 19H), 0.95-0.84 (m, 12H).

An argon gas atmosphere was prepared in a reaction vessel, then, trisacetylacetonatoiridium (0.86 g), the compound 8e (3.6 g) and pentadecane (10 g) were added, and the mixture was stirred for 67 hours under reflux with heating. Thereafter, the resultant reaction liquid was cooled down to room temperature, then, to this was added toluene and the mixture was filtrated through a filter paved with silica gel. The resultant filtrate was concentrated under reduced pressure, to obtain a solid. The resultant solid was purified by silica gel column chromatography (a mixed solvent of toluene and ethyl acetate), and further, crystallized using a mixed solvent of toluene and acetonitrile, then, dried at 50°C under reduced pressure, to obtain a metal complex B8 (1.0 g). The HPLC area percentage value of the metal complex B8 was 95.3%.

The measurement results of LC-MS and NMR of the metal complex B8 were as described below.

LC-MS (APCI, positive): m/z = 1941 [M+H]⁺

¹H-NMR (CD₂Cl₂, 400 MHz) δ (ppm) = 8.05-7.93 (m, 3H), 7.77-7.31 (m, 21H), 7.17-6.81 (m, 18H), 6.29-6.16 (m, 3H), 2.00-1.77 (m, 2H), 1.75-1.52 (m, 2H), 1.50-1.15 (m, 64H), 1.12-0.80 (m, 28H), 0.54-0.42 (m, 3H).

The maximum peak wavelength of the emission spectrum of the metal complex B8 was 479 nm.

### <Synthesis Example B9> Synthesis of metal complex B9

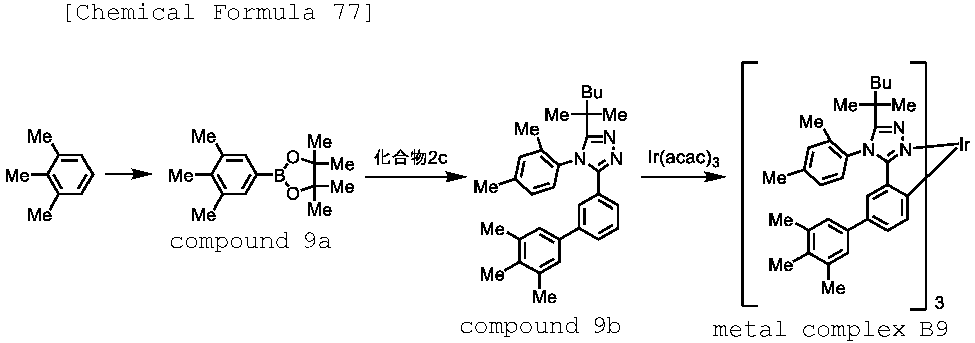

A nitrogen gas atmosphere was prepared in a reaction vessel, then, 1,2,3-trimethylbenzene (168 g), bispinacolatodiboron (384 g), (1,5-cyclooctadiene)(methoxy)iridium (I) (dimer) (8 g) and cyclopentyl methyl ether (1681 mL) were added, and the mixture was stirred. Thereafter, to this was added (1,5-cyclooctadiene)(methoxy)iridium (I) (dimer) (10 g), then, stirring at 95°C was continued for 6 hours. Thereafter, the reaction vessel was cooled down to room temperature, to obtain a reaction mixture.

A reaction vessel containing a nitrogen gas atmosphere was separately prepared, into this was added methanol (2391 g), and it was cooled by an ice bath, and stirred. Thereafter, the reaction mixture obtained above was slowly added to this. Thereafter, to this was added activated white earth (336 g), and the mixture was stirred for 30 minutes, then, filtrated through a filter. The resultant filtrate was concentrated, to obtain a solid. The resultant solid was purified by silica gel column chromatography (a mixed solvent of toluene and hexane), and further, crystallized using acetonitrile. Thereafter, the resultant solid was dried at 50°C under reduced pressure, to obtain a compound 9a (165 g, white solid).

The measurement results of ¹H-NMR of the compound 9a were as described below.
¹H-NMR (400 MHz, CDCl₃) δ (ppm) = 7.46 (s, 2H), 2.29 (s, 6H), 2.19 (s, 3H), 1.34 (s, 12H).

An argon gas atmosphere was prepared in a reaction vessel, then, the compound 2c (9.0 g), the compound 9a (6.2 g), a 40% by mass tetrabutylammonium hydroxide aqueous solution (32.9 g), ion exchanged water (32.9 g) and toluene (108.0 g) were added, and the mixture was stirred at room temperature. Thereafter, to this was added bis(di-tert-butyl(4-dimethylaminobiphenyl)phosphine)dichloropallad ium (0.2 g), then, the mixture was stirred at 80°C for 2 hours. Thereafter, the reaction vessel was cooled down to room temperature, then, the resultant reaction liquid was liquid-separated. The resultant organic layer was washed with ion exchanged water (91.0 g) twice. Thereafter, the resultant organic layer was dried over magnesium sulfate, then, filtrated. To the resultant filtrate was added activated carbon (1.6 g), and the mixture was stirred at room temperature for 1 hour, then, filtrated through a filter paved with Celite. The resultant filtrate was concentrated under reduced pressure, to obtain a toluene solution.

An argon gas atmosphere was prepared in a reaction vessel, then, the toluene solution obtained above (49.9 g), the compound 9a (5.2 g), a 40% by mass tetrabutylammonium hydroxide aqueous solution (32.9 g), ion exchanged water (32.9 g) and toluene (108.0 g) were added, and the mixture was stirred at room temperature. Thereafter, to this was added bis(di-tert-butyl(2-butenyl)phosphine)dichloropalladium (0.2 g), then, the mixture was stirred at 80°C for 27 hours. Thereafter, the reaction vessel was cooled down to room temperature, then, the resultant reaction liquid was liquid-separated. The resultant organic layer was washed with ion exchanged water twice. Thereafter, the resultant organic layer was dried over magnesium sulfate, then, filtrated. To the resultant filtrate was added activated carbon, and the mixture was stirred for 1 hour at room temperature, then, filtrated through a filter paved with Celite. The resultant filtrate was concentrated, then, to this was added heptane and the mixture was stirred for 1 hour, then, a solid was collected by filtration. The resultant solid was crystallized using a mixed solvent of toluene and heptane, and further, was dried at 50°C under reduced pressure, to obtain a compound 9b (6.2 g, white solid). The HPLC area percentage value of the compound 9b was 99.5% or more.

The measurement results of LC/MS and ¹H-NMR of the compound 9b were as described below.

LC/MS (APCI, positive): m/z = 466 [M+H]⁺

¹H-NMR (CD₂Cl₂, 400 MHz) δ (ppm) = 7.51-7.45 (m, 2H), 7.40 (t, 1H), 7.35-7.28 (m, 2H), 7.24-7.19 (m, 1H), 7.09-7.06 (m, 1H), 6.91 (s, 2H), 2.40 (s, 3H), 2.28 (s, 6H), 2.16 (s, 3H), 1.75 (s, 3H), 1.70-1.61 (m, 1H), 1.45-1.35 (m, 1H), 1.33 (s, 3H), 1.30-1.16 (m, 4H), 1.11 (s, 3H), 0.89-0.83 (m, 3H).

An argon gas atmosphere was prepared in a reaction vessel, then, trisacetylacetonatoiridium (1.6 g), the compound 9b (6.0 g) and pentadecane (14.2 g) were added, and the mixture was stirred for 45 hours under reflux with heating. Thereafter, to this was added toluene (31.6 g) and the mixture was filtrated through a filter paved with silica gel (18.9 g), then, from the resultant silica gel, a yellow solution containing a metal complex B9 was extracted using a mixed solvent of toluene and ethyl acetate. The resultant solution was concentrated under reduced pressure, to obtain a solid, then, the resultant solid was purified by silica gel column chromatography (a mixed solvent of toluene and ethyl acetate), to obtain a solid. The resultant solid was crystallized using a mixed solvent of toluene and acetonitrile, and further, dried at 50°C under reduced pressure, to obtain a metal complex B9 (3.2 g, yellow solid). The HPLC area percentage value of the metal complex B9 was 99.1%.

The measurement results of LC/MS and ¹H-NMR of the metal complex B9 were as described below.

LC/MS (APCI, positive): m/z = 1585 [M+H]⁺

¹H-NMR (CD₂Cl₂, 400 MHz) δ (ppm) = 7.42-7.16 (m, 9H), 6.99-6.62 (m, 12H), 6.31-6.12 (m, 3H), 2.53-2.41 (m, 9H), 2.31-2.00 (m, 36H), 1.86-1.77 (m, 3H), 1.44-0.98 (m, 33H), 0.85-0.62 (m, 9H).

The maximum peak wavelength of the emission spectrum of the metal complex B9 was 478 nm.

### <Synthesis Example B10> Synthesis of metal complex B10

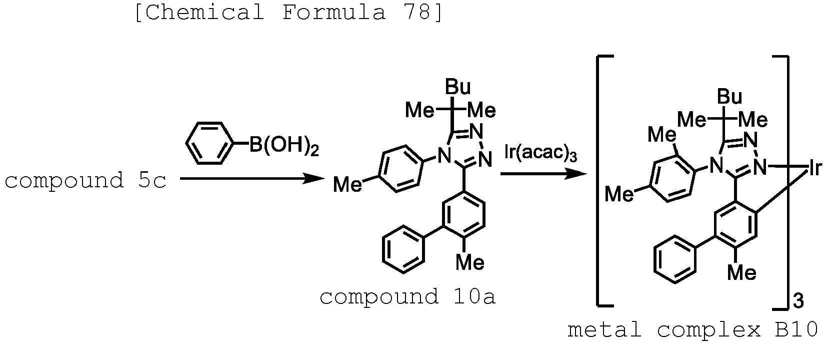

An argon gas atmosphere was prepared in a reaction vessel, then, the compound 5c (15.0 g), phenylboric acid (4.4 g), bis(di-tert-butyl(4-dimethylaminobiphenyl)phosphine)dichloropalladium (0.1 g) and toluene (75 mL) were added, and the mixture was stirred at 80°C. Thereafter, to this was added a 40% by mass tetrabutylammonium hydroxide aqueous solution (55 mL), then, the mixture was stirred at 80°C for 40 hours. Thereafter, the reaction vessel was cooled down to room temperature, then, the resultant reaction liquid was liquid-separated. The resultant organic layer was washed with ion exchanged water (75 mL) twice, then, the resultant organic layer was dried over magnesium sulfate. Thereafter, to the dried organic layer was added activated carbon (15.0 g), and the mixture was stirred at room temperature for 1 hour, then, filtrated through a filter paved with Celite. The resultant filtrate was concentrated under reduced pressure, to obtain an oil. The resultant oil was purified by silica gel column chromatography (a mixed solvent of chloroform and ethanol), to obtain a solid. The resultant solid was crystallized using a mixed solvent of heptane and 2-propanol, and further, dried at 50°C under reduced pressure, to obtain a compound 10a (4.0 g, white solid). The HPLC area percentage value of the compound 10a was 99.5% or more.

The measurement results of ¹H-NMR of the compound 10a were as described below.

¹H-NMR (400 MHz, CD₂Cl₂) δ (ppm) = 7.40-6.94 (m, 11H), 2.42-2.34 (m, 3H), 2.23-2.15 (m, 3H), 1.78-1.48 (m, 6H), 1.42-1.16 (m, 6H), 1.13-1.06 (m, 3H), 0.92-0.77 (m, 3H).

An argon gas atmosphere was prepared in a reaction vessel, then, trisacetylacetonatoiridium (1.1 g), the compound 10a (4.0 g) and pentadecane (50 mL) were added, and the mixture was stirred for 52 hours under reflux with heating. Thereafter, to this was added toluene (32 mL) and the mixture was filtrated through a filter paved with silica gel (16.0 g), then, from the resultant silica gel, a yellow solution containing a metal complex B10 was extracted using a mixed solvent of toluene and ethyl acetate. The resultant solution was concentrated under reduced pressure, to obtain a solid, then, the resultant solid was purified by silica gel column chromatography (a mixed solvent of toluene and ethyl acetate), and further, the resultant solid was washed with ethanol. Then, the resultant solid was and purified by reverse phase silica gel column chromatography (a mixed solvent of methylene chloride and acetonitrile), and further, the resultant solid was washed with acetonitrile. Thereafter, the resultant solid was crystallized using a mixed solvent of toluene and ethanol, and further, dried at 50°C under reduced pressure, to obtain a metal complex B10 (1.5 g, yellow solid). The HPLC area percentage value of the metal complex B10 was 99.4%.

The measurement results of ¹H-NMR of the metal complex B10 were as described below.

¹H-NMR (400 MHz, CD₂Cl₂) δ (ppm) = 7.33-7.08 (m, 18H), 7.02-6.93 (m, 6H), 6.73-6.48 (m, 3H), 5.81-5.71 (m, 3H), 2.43-2.32 (m, 9H), 2.16-1.97 (m, 15H), 1.91-1.79 (m, 3H), 1.58-1.03 (m, 36H), 0.84-0.67 (m, 9H).

The maximum peak wavelength of the emission spectrum of the metal complex B10 was 466 nm.

### <Synthesis Example B11> Synthesis of metal complex B11

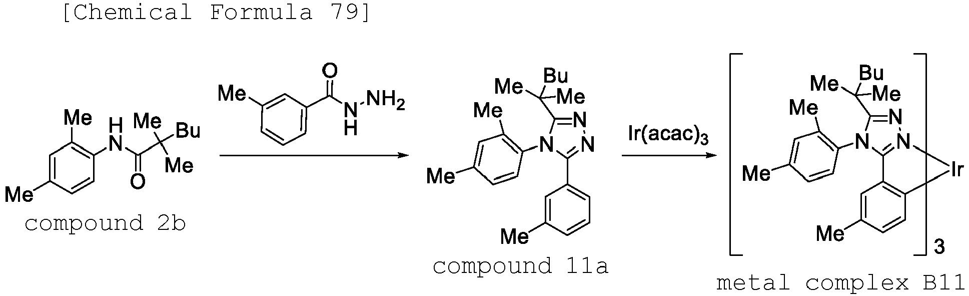

An argon gas atmosphere was prepared in a reaction vessel, then, the compound 2b (10.0 g), monochlorobutane (80 mL), 2-fluoropyridine (4 mL) and trifluoromethanesulfonic anhydride (7 mL) were added, and the mixture was stirred at room temperature for 30 minutes. Thereafter, to this was added 3-methylbenzhydrazide (6.4 g), then, the mixture was stirred at 85°C for 5 hours. Thereafter, the resultant reaction liquid was cooled down to room temperature, then, to this was added a 2 mol/L sodium hydrogen carbonate aqueous solution (43 mL), and the mixture was stirred. Thereafter, an organic layer was extracted, then, the resultant organic layer was washed with ion exchanged water. The resultant organic layer was concentrated under reduced pressure, to obtain an oil. The resultant oil was purified by silica gel column chromatography (a mixed solvent of chloroform and ethanol), to obtain a solid. The resultant solid was crystallized using heptane, then, the resultant solid was dried at 50°C under reduced pressure, to obtain a compound 11a (5.5 g) as a white solid. The HPLC area percentage value of the compound 11a was 99.5% or more.

The measurement results of LC-MS and NMR of the compound 11a were as described below.

LC/MS (APPI, positive): m/z = 362 [M+H]⁺

¹H-NMR (400 MHz, CD₂Cl₂) δ (ppm) = 7.28-7.22 (m, 2H), 7.16-6.95 (m, 5H), 2.34 (s, 3H), 2.22 (s, 3H), 1.71 (s, 3H), 1.68-1.57 (m, 1H), 1.43-1.33 (m, 1H), 1.32-1.07 (m, 10H), 0.86 (t, 3H).

An argon gas atmosphere was prepared in a reaction vessel, then, trisacetylacetonatoiridium (1.9 g), the compound 11a (5.0 g) and pentadecane (10 mL) were added, and the mixture was stirred for 36 hours under reflux with heating. Thereafter, to this was added toluene and the mixture was filtrated through a filter paved with silica gel, then, the resultant filtrate was concentrated under reduced pressure, to obtain a solid. The resultant solid was purified by silica gel column chromatography (a mixed solvent of toluene and ethyl acetate), then, crystallized using a mixed solvent of toluene and acetonitrile. Thereafter, the resultant solid was dried at 50°C under reduced pressure, to obtain a metal complex B11 (2.4 g) as a yellow solid. The HPLC area percentage value of the metal complex B11 was 98.8%.

The measurement results of LC-MS and NMR of the metal complex B11 were as described below.

LC-MS (APCI, positive): m/z = 1629 [M+H]⁺

¹H-NMR (400 MHz, CD₂Cl₂) δ (ppm) = 7.33-7.01 (m, 9H), 6.75-6.31 (m, 6H), 5.80-5.59 (m, 3H), 2.50-2.39 (m, 9H), 2.13-1.72 (m, 18H), 1.61-0.90 (m, 36H), 0.85-0.62 (m, 9H).

The maximum peak wavelength of the emission spectrum of the metal complex B11 was 476 nm.

### <Synthesis Example B12> Synthesis of metal complex B12

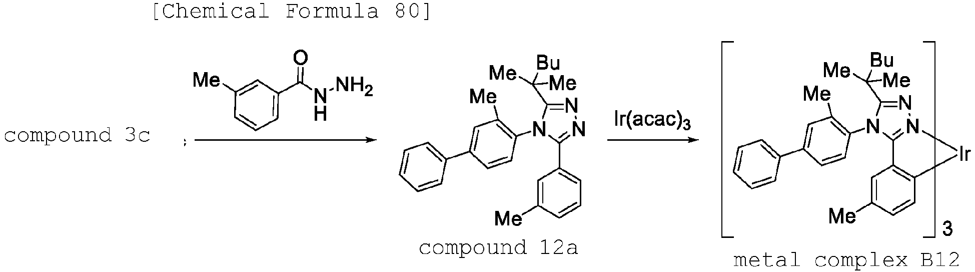

An argon gas atmosphere was prepared in a reaction vessel, then, the compound 3c (8.5 g), chlorobenzene (85 mL), 2-fluoropyridine (2.6 mL) and trifluoromethanesulfonic anhydride (5.1 mL) were added, and the mixture was stirred at room temperature for 30 minutes. Thereafter, to this was added 3-methylbenzhydrazide (4.5 g), then, the mixture was stirred at 90°C for 2 hours. Thereafter, the resultant reaction liquid was cooled down to room temperature, then, to this was added a sodium hydrogen carbonate aqueous solution, and the mixture was stirred. Thereafter, an organic layer was extracted, then, the resultant organic layer was washed with ion exchanged water. The resultant organic layer was dried over magnesium sulfate, then, filtrated. The resultant filtrate was concentrated under reduced pressure, to obtain a solid. The resultant solid was crystallized using a mixed solvent of heptane and 2-propanol, then, further, crystallized using acetonitrile. The resultant solid was dried at 50°C under reduced pressure, to obtain a compound 12a (4.9 g). The HPLC area percentage value of the compound 12a was 99.5% or more.

An argon gas atmosphere was prepared in a reaction vessel, then, trisacetylacetonatoiridium (1.3 g), the compound 12a (1.3 g) and pentadecane (10 mL) were added, and the mixture was stirred for 50 hours under reflux with heating. Thereafter, to this was added toluene and the mixture was filtrated through a filter paved with silica gel, then, the resultant filtrate was concentrated under reduced pressure, to obtain a solid. The resultant solid was purified by silica gel column chromatography (a mixed solvent of toluene and ethyl acetate), then, crystallized using a mixed solvent of heptane, toluene and 2-propanol. Thereafter, the resultant solid was dried at 50°C under reduced pressure, to obtain a metal complex B12 (1.2 g). The HPLC area percentage value of the metal complex B12 was 99.5% or more.

The measurement results of LC-MS and NMR of the metal complex B12 were as described below.

LC-MS (APCI, positive): m/z = 1460.8 [M+H]⁺

¹H-NMR (400 MHz, CD₂Cl₂) δ (ppm) = 0.69-0.91 (m, 9H), 1.07-1.99 (m, 48H), 2.14-2.36 (m, 6H), 5.73-5.81 (m, 3H), 6.40-6.81 (m, 6H), 7.28-7.75 (m, 24H).

The maximum peak wavelength of the emission spectrum of the metal complex B12 was 477 nm.

### <Synthesis Example B13> Synthesis of metal complex B13

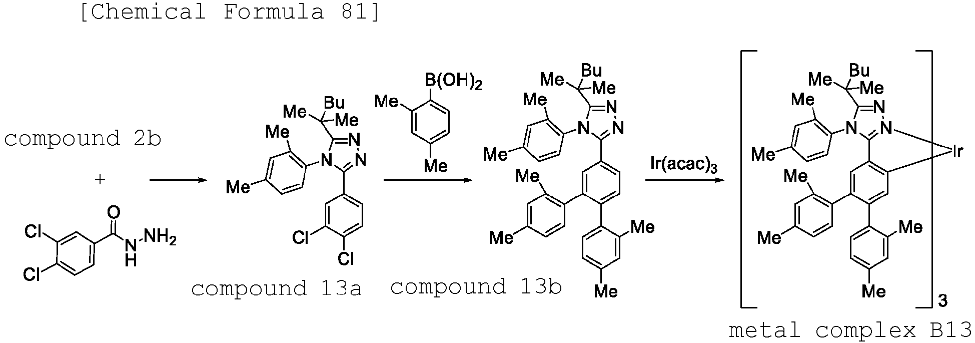

An argon gas atmosphere was prepared in a reaction vessel, then, the compound 2b (28.0 g), chlorobenzene (360 mL), 2-fluoropyridine (11 mL) and trifluoromethanesulfonic anhydride (21 mL) were added, and the mixture was stirred at 90°C. Thereafter, to this was added 3,4-dichlorobenzenecarbohydrazide (25.5 g), then, the mixture was stirred at 90°C for 9 hours. Thereafter, the resultant reaction liquid was cooled down to room temperature, then, to this was added a sodium hydrogen carbonate aqueous solution, and an organic layer was extracted. The resultant organic layer was washed with ion exchanged water (100 mL). The resultant organic layer was dried over magnesium sulfate, then, filtrated, and the resultant filtrate was concentrated under reduced pressure, to obtain a solid. The resultant solid was washed with hexane, then, crystallized using acetonitrile. Thereafter, the resultant solid was dried at 50°C under reduced pressure, to obtain a compound 13a (37.8 g) as a white solid. The HPLC area percentage value of the compound 13a was 99.5% or more.

The measurement results of ¹H-NMR of the compound 13a were as described below.

¹H-NMR (400 MHz, CDCl₃) δ (ppm) = 0.86 (t, 3H), 1.04-1.50 (m, 11H), 1.58-1.90 (m, 4H), 2.40 (s, 3H), 6.98-7.36 (m, 5H), 7.50 (s, 1H).

An argon gas atmosphere was prepared in a reaction vessel, then, the compound 13a (35.0 g), 2,4-dimethylphenylboronic acid (26.0 g), toluene (700 mL), tris(dibenzylideneacetone)dipalladium (2.3 g) and 2-dicyclohexylphosphino-2',4',6'-triisopropylbiphenyl (2.8 g) were added, and the mixture was stirred with heating at 90°C. Thereafter, to this was added a 40% by mass tetrabutylammonium hydroxide aqueous solution (409 mL), then, the mixture was stirred at 90°C for 9 hours. Thereafter, the reaction vessel was cooled down to room temperature, then, the resultant reaction mixture was liquid-separated. The resultant organic layer was washed with ion exchanged water (150 mL) twice. Thereafter, the resultant organic layer was dried over magnesium sulfate, then, filtrated. To the resultant filtrate was added activated carbon (4.0 g), and the mixture was stirred at room temperature for 1 hour, then, filtrated through a filter paved with Celite. The resultant filtrate was concentrated under reduced pressure, and further, purified by silica gel column chromatography (a mixed solvent of hexane and ethyl acetate), to obtain an oil.

An argon gas atmosphere was prepared in a reaction vessel separately prepared, then, the oil obtained above (30.0 g), 2,4-dimethylphenylboronic acid (2.2 g), toluene (450 mL), tris(dibenzylideneacetone)dipalladium (1.0 g) and 2-dicyclohexylphosphino-2',4',6'-triisopropylbiphenyl (1.2 g) were added, and the mixture was stirred with heating at 90°C. Thereafter, to this was added a 40% by mass tetrabutylammonium hydroxide aqueous solution (234 mL), then, the mixture was stirred at 90°C for 5 hours. Thereafter, the reaction vessel was cooled down to room temperature, then, the resultant reaction mixture was liquid-separated. The resultant organic layer was washed with ion exchanged water (150 mL) twice. Thereafter, the resultant organic layer was dried over magnesium sulfate, then, filtrated. To the resultant filtrate was added activated carbon (4.0 g), and the mixture was stirred at room temperature for 1 hour, then, filtrated through a filter paved with Celite. The resultant filtrate was concentrated, to obtain a reddish brown oil. The resultant reddish brown oil was purified by reverse phase silica gel column chromatography (acetonitrile), then, the resultant oil was purified by silica gel column chromatography (a mixed solvent of chloroform and ethanol). Thereafter, the resultant oil was purified by recycling preparative GPC. Thereafter, the resultant oil was dried at 50°C under reduced pressure, to obtain a compound 13b (2.2 g, colorless transparent oil). The HPLC area percentage value of the compound 13b was 99.5% or more.

The measurement results of LC/MS and ¹H-NMR of the compound 13b were as described below.

LC/MS (APCI, positive): m/z = 556 [M+H]⁺

¹H-NMR (400 MHz, CD₂Cl₂) δ (ppm) = 0.86 (t, 3H), 1.12-1.44 (m, 11H), 1.58-2.04 (m, 10H), 2.20 (s, 6H), 2.37 (s, 3H), 6.46-7.25 (m, 12H).

An argon gas atmosphere was prepared in a reaction vessel, then, trisacetylacetonatoiridium (0.4 g), the compound 13b (2.0 g) and pentadecane (6 mL) were added, and the mixture was stirred for 54 hours under reflux with heating. Thereafter, to this was added toluene (30 mL), and the mixture was filtrated through a filter paved with silica gel (20.0 g), then, from the resultant silica gel, a yellow solution containing a metal complex B13 was extracted using a mixed solvent of toluene and ethyl acetate. The resultant solution was concentrated under reduced pressure, to obtain an oil. The resultant oil was purified by silica gel column chromatography (a mixed solvent of toluene and ethyl acetate), to obtain a solid. The resultant solid was purified by reverse phase silica gel column chromatography (a mixed solvent of acetonitrile and ethyl acetate), and further, the resultant solid was crystallized with a mixed solvent of toluene and ethanol. Thereafter, the resultant solid was dried at 50°C under reduced pressure, to obtain a metal complex B13 (0.6 g, yellow solid). The HPLC area percentage value of the metal complex B13 was 99.5% or more.

The measurement results of LC/MS and ¹H-NMR of the metal complex B13 were as described below.

LC/MS (APCI, positive): m/z = 1858 [M+H]⁺

¹H-NMR (400 MHz, CDCl₃) δ (ppm) = 0.82-2.30 (m, 99H), 5.69-7.27 (m, 33H).

The maximum peak wavelength of the emission spectrum of the metal complex B13 was 487 nm.

### <Synthesis Example G1> Synthesis and acquisition of metal complexes G1 to G5 and GC1

A metal complex G1 was synthesized according to a method described in JP-A No. 2013-237789.

A metal complex G2 was synthesized with reference to a method described in International Publication WO 2009/131255.

A metal complex G3 was synthesized with reference to a method described in JP-A No. 2014-224101.

A metal complex G4 was synthesized according to a method described in International Publication WO 2017/099013.

A metal complex G5 was synthesized according to a method described in JP-A No. 2014-224101.

A metal complex GC1 was purchased from Luminescence Technology Corp.

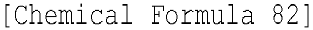

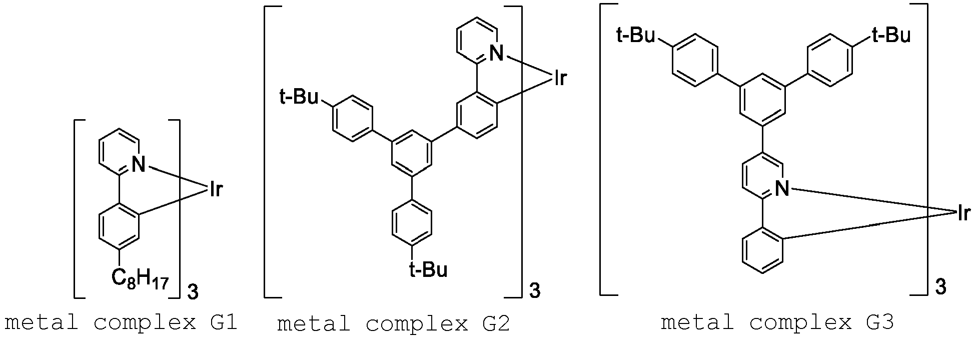

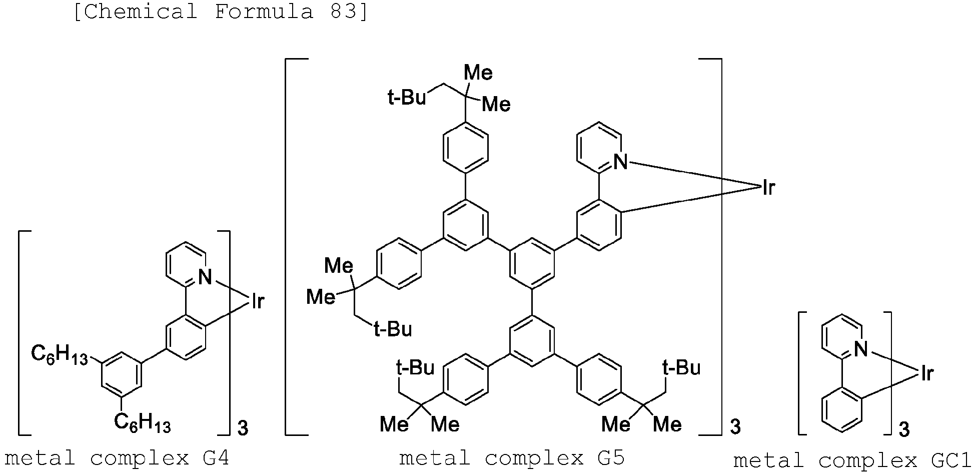

The maximum peak wavelength of the emission spectrum of the metal complex G1 was 508 nm.

The maximum peak wavelength of the emission spectrum of the metal complex G2 was 514 nm.

The maximum peak wavelength of the emission spectrum of the metal complex G3 was 544 nm.

The maximum peak wavelength of the emission spectrum of the metal complex G4 was 517 nm.

The maximum peak wavelength of the emission spectrum of the metal complex G5 was 514 nm.

The maximum peak wavelength of the emission spectrum of the metal complex GC1 was 510 nm.

### <Synthesis Example R1> Synthesis and acquisition of metal complexes R1 to R5 and RC1

A metal complex R1 was synthesized with reference to a method described in International Publication WO 2003/040256.

A metal complex R2 was synthesized with reference to a method described in JP-A No. 2006-188673.

A metal complex R3 was synthesized according to a method described in JP-A No. 2008-179617.

A metal complex R4 was synthesized according to a method described in JP-A No. 2011-105701.

A metal complex R5 was purchased from Luminescence Technology Corp.

A metal complex RC1 was purchased from American Dye Source, Inc.

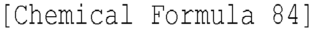

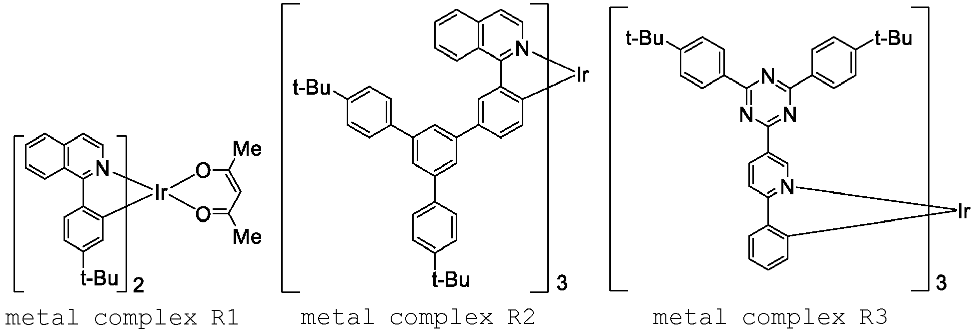

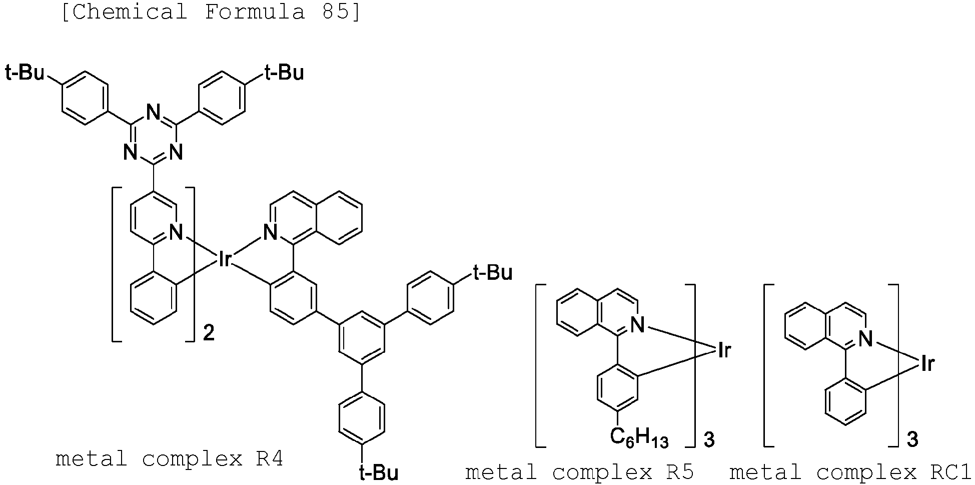

The maximum peak wavelength of the emission spectrum of the metal complex R1 was 632 nm.

The maximum peak wavelength of the emission spectrum of the metal complex R2 was 619 nm.

The maximum peak wavelength of the emission spectrum of the metal complex R3 was 594 nm.

The maximum peak wavelength of the emission spectrum of the metal complex R4 was 611 nm.

The maximum peak wavelength of the emission spectrum of the metal complex R5 was 620 nm.

The maximum peak wavelength of the emission spectrum of the metal complex RC1 was 618 nm.

### <Compound HM-1>

A compound HM-1 was purchased from Luminescence Technology Corp..

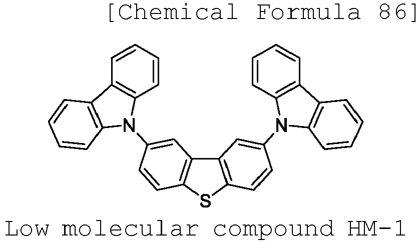

### <Example D1> Fabrication and evaluation of light emitting device D1

### (Formation of anode and hole injection layer)

An ITO film was deposited with a thickness of 45 nm on a glass substrate by a sputtering method, to form an anode. A polythiophene-sulfonic acid type hole injection agent AQ-1200 (manufactured by Plextronics) was spin-coated on the anode, to form a film with a thickness of 35 nm, and the film was heated on a hot plate at 170°C for 15 minutes under an air atmosphere, to form a hole injection layer.

### (Formation of hole transporting layer)

The polymer compound HTL-1 was dissolved at a concentration of 0.7% by mass in xylene. The resultant xylene solution was spin-coated on the hole injection layer to form a film with a thickness of 20 nm, and the film was heated on a hot plate at 180°C for 60 minutes under a nitrogen gas atmosphere, to form a hole transporting layer.

### (Formation of light emitting layer)

The compound HM-1, the metal complex B1, the metal complex G2 and the metal complex R2 (compound HM-1/metal complex B1/metal complex G2/metal complex R2 = 73.9% by mass/25% by mass/1% by mass/0.1% by mass) were dissolved at a concentration of 2% by mass in toluene. The resultant toluene solution was spin-coated on the hole transporting layer to form a film with a thickness of 75 nm, and the film was heated at 130°C for 10 minutes under a nitrogen gas atmosphere, to form a light emitting layer.

### (Formation of electron transporting layer)

The polymer compound ET1 was dissolved at a concentration of 0.25% by mass in 2,2,3,3,4,4,5,5-octafluoro-1-pentanol. The resultant 2,2,3,3,4,4,5,5-octafluoro-1-pentanol solution was spin-coated on the light emitting layer to form a film with a thickness of 10 nm, and the film was heated at 130°C for 10 minutes under a nitrogen gas atmosphere, to form an electron transporting layer.

### (Formation of cathode)

The substrate carrying the electron transporting layer formed thereon was placed in a vapor deposition machine, the pressure in the machine was reduced to 1.0×10⁻⁴ Pa or less, then, sodium fluoride was vapor-deposited with a thickness of about 4 nm on the electron transporting layer, then, aluminum was vapor-deposited with a thickness of about 80 nm on the sodium fluoride layer, as a cathode. After vapor deposition, sealing with a glass substrate was performed, to fabricate a light emitting device D1.

### (Evaluation of light emitting device)

Voltage was applied to the light emitting device D1, to observe EL emission. The CIE chromaticity coordinate (x,y) at 3000 cd/m² was measured, and the current value was set so that the initial luminance was 3000 cd/m², then, the device was driven at constant current, and the time until the luminance reached 90% of the initial luminance (hereinafter, referred to as "LT90") was measured. The results are shown in Table 1.

### <Example D2, Comparative Example CD1> Fabrication and evaluation of light emitting devices D2 and CD1

Light emitting devices D2 and CD1 were fabricated in the same manner as in Example D1, except that materials described in Table 1 were used instead of "the compound HM-1, the metal complex B1, the metal complex G2 and the metal complex R2" in (Formation of light emitting layer) of Example D1.

Voltage was applied to the light emitting devices D2 and CD1, to observe EL emission. The CIE chromaticity coordinate (x,y) at 3000 cd/m² and the measurement results of LT90 are shown in Table 1.

**[Table 1]**

| | light emitting device | light emitting layer | | LT90 (hrs) | CIE chromaticity coordinate (x, y) |
|---|---|---|---|---|---|
| | | material | composition ratio (% by mass) | | |
| Example D1 | D1 | HM-1/B1/G2/R2 | 73.9/25/1/0.1 | 9.5 | (0.28,0.49) |
| Example D2 | D2 | HM-1/B1/G1/R1 | 73.9/25/1/0.1 | 5.9 | (0.30,0.48) |
| Comparative Example CD1 | CD1 | HM-1/BC1/G2/R2 | 73.9/25/1/0.1 | 1.4 | (0.29,0.48) |

### <Example D3> Fabrication and evaluation of light emitting device D3

A light emitting device D3 was fabricated in the same manner as in Example D1.

Voltage was applied to the light emitting device D3, to observe EL emission. The CIE chromaticity coordinate (x,y) at 3000 cd/m² was measured, and the current value was set so that the initial luminance was 3000 cd/m², then, the device was driven at constant current, and the time until the luminance reached 50% of the initial luminance (hereinafter, referred to as "LT50") was measured. The results are shown in Table 2.

### <Examples D4 to D20 and Comparative Example CD2>

Fabrication and evaluation of light emitting devices D4 to D20 and CD2

Light emitting devices D4 to D20 and CD2 were fabricated in the same manner as in Example D1, except that materials described in Table 2 were used instead of "the compound HM-1, the metal complex B1, the metal complex G2 and the metal complex R2" in (Formation of light emitting layer) of Example D1.

Voltage was applied to the light emitting devices D4 to D20 and CD2, to observe EL emission. The CIE chromaticity coordinate (x,y) at 3000 cd/m² and the measurement results of LT50 are shown in Table 2.

**[Table 2]**

| | light emitting device | light emitting layer | | LT50 (hrs) | CIE chromaticity coordinate (x, y) |
|---|---|---|---|---|---|
| | | material | composition ratio (% by mass) | | |
| Example D3 | D3 | HM-1/B1/G2/R2 | 73.9/25/1/0.1 | 81.1 | (0.28,0.49) |
| Example D4 | D4 | HM-1/B1/G2/R3 | 73.9/25/1/0.1 | 150.7 | (0.35,0.48) |
| Example D5 | D5 | HM-1/B1/G2/R4 | 73.9/25/1/0.1 | 143.7 | (0.31,0.47) |
| Example D6 | D6 | HM-1/B1/G3/R2 | 73.9/25/1/0.1 | 138.6 | (0.36,0.49) |
| Example D7 | D7 | HM-1/B2/G2/R2 | 73.9/25/1/0.1 | 151.8 | (0.28,0.50) |
| Example D8 | D8 | HM-1/B3/G2/R2 | 73.9/25/1/0.1 | 179.8 | (0.29,0.51) |
| Example D9 | D9 | HM-1/B4/G2/R2 | 73.9/25/1/0.1 | 146.7 | (0.29,0.50) |
| Example D10 | D10 | HM-1/B6/G2/R2 | 73.9/25/1/0.1 | 191.8 | (0.27,0.51) |
| Example D11 | D11 | HM-1/B7/G2/R2 | 73.9/25/1/0.1 | 71.4 | (0.30,0.50) |
| Example D12 | D12 | HM-1/B8/G2/R2 | 73.9/25/1/0.1 | 131.2 | (0.28,0.50) |
| Example D13 | D13 | HM-1/B9/G2/R2 | 73.9/25/1/0.1 | 122.1 | (0.30,0.51) |
| Example D14 | D14 | HM-1/B10/G2/R2 | 73.9/25/1/0.1 | 128.6 | (0.28,0.48) |
| Example D15 | D15 | HM-1/B11/G2/R2 | 73.9/25/1/0.1 | 139.8 | (0.28,0.51) |
| Example D16 | D16 | HM-1/B12/G2/R2 | 73.9/25/1/0.1 | 188.8 | (0.28,0.52) |
| Example D17 | D17 | HM-1/B13/G2/R2 | 73.9/25/1/0.1 | 204.8 | (0.29,0.53) |
| Example D18 | D18 | HM-1/B1/R2 | 74/25/1 | 28.9 | (0.48,0.33) |
| Example D19 | D19 | HM-1/B1/R3 | 74/25/1 | 63.0 | (0.52,0.40) |
| Example D20 | D20 | HM-1/B1/R4 | 74/25/1 | 49.4 | (0.52,0.36) |
| Comparative Example CD2 | CD2 | HM-1/BC1/G2/R2 | 73.9/25/1/0.1 | 21.2 | (0.29,0.48) |

### <Examples D21 to D24 and Comparative Example CD3>

Fabrication and evaluation of light emitting devices D21 to D24 and CD3
Light emitting devices D21 to D24 and CD3 were fabricated in the same manner as in Example D1, except that materials described in Table 3 were used instead of "the compound HM-1, the metal complex B1, the metal complex G2 and the metal complex R2" in (Formation of light emitting layer) of Example D1.

Voltage was applied to the light emitting devices D21 to D24 and CD3 , to observe EL emission. The CIE chromaticity coordinate (x,y) at 3000 cd/m² was measured, and the current value was set so that the initial luminance was 3000 cd/m², then, the device was driven at constant current, and the time until the luminance reached 95% of the initial luminance (hereinafter, referred to as "LT95") was measured. The results are shown in Table 3.

**[Table 3]**

| | light emitting device | light emitting layer | | LT95 (hrs) | CIE chromaticity coordinate (x, y) |
|---|---|---|---|---|---|
| | | material | composition ratio (% by mass) | | |
| Example D21 | D21 | HM-1/B2/G1/R5 | 73.9/25/1/0.1 | 14.4 | (0.30,0.50) |
| Example D22 | D22 | HM-1/B2/G2/R5 | 73.9/25/1/0.1 | 11.5 | (0.30,0.48) |
| Example D23 | D23 | HM-1/B2/G4/R2 | 73.9/25/1/0.1 | 5.2 | (0.29,0.50) |
| Example D24 | D24 | HM-1/B2/G5/R2 | 73.9/25/1/0.1 | 26.2 | (0.26,0.43) |
| Comparative Example CD3 | CD3 | HM-1/B2/GC1/RC1 | 73.9/25/1/0.1 | 2.7 | (0.30,0.48) |

### <Example D25> Fabrication and evaluation of light emitting device D25

### (Formation of anode and hole injection layer)

An ITO film was deposited with a thickness of 45 nm on a glass substrate by a sputtering method, to form an anode. A polythiophene-sulfonic acid type hole injection agent AQ-1200 (manufactured by Plextronics) was spin-coated on the anode, to form a film with a thickness of 35 nm, and the film was heated on a hot plate at 170°C for 15 minutes under an air atmosphere, to form a hole injection layer.

### (Formation of second light emitting layer)

The polymer compound HTL-2 was dissolved at a concentration of 0.7% by mass in xylene. The resultant xylene solution was spin-coated on the hole injection layer to form a film with a thickness of 20 nm, and the film was heated on a hot plate at 180°C for 60 minutes under a nitrogen gas atmosphere, to form a second light emitting layer.

### (Formation of first light emitting layer)

The compound HM-1, the metal complex B1 and the metal complex G2 (compound HM-1/metal complex B1/metal complex G2 = 74% by mass/25% by mass/1% by mass) were dissolved at a concentration of 2% by mass in toluene. The resultant toluene solution was spin-coated on the second light emitting layer to form a film with a thickness of 75 nm, and the film was heated at 130°C for 10 minutes under a nitrogen gas atmosphere, to form a first light emitting layer.

### (Formation of electron transporting layer)

The polymer compound ET1 was dissolved at a concentration of 0.25% by mass in 2,2,3,3,4,4,5,5-octafluoro-1-pentanol. The resultant 2,2,3,3,4,4,5,5-octafluoro-1-pentanol solution was spin-coated on the first light emitting layer to form a film with a thickness of 10 nm, and the film was heated at 130°C for 10 minutes under a nitrogen gas atmosphere, to form an electron transporting layer.

### (Formation of cathode)

The substrate carrying the electron transporting layer formed thereon was placed in a vapor deposition machine, the pressure in the machine was reduced to 1.0×10⁻⁴ Pa or less, then, sodium fluoride was vapor-deposited with a thickness of about 4 nm on the electron transporting layer, then, aluminum was vapor-deposited with a thickness of about 80 nm on the sodium fluoride layer, as a cathode. After vapor deposition, sealing with a glass substrate was performed, to fabricate a light emitting device D25.

### (Evaluation of light emitting device)

Voltage was applied to the light emitting device D25, to observe EL emission. The CIE chromaticity coordinate (x,y) at 3000 cd/m² was measured, and the current value was set so that the initial luminance was 3000 cd/m², then, the device was driven at constant current, and the time until the luminance reached 70% of the initial luminance (hereinafter, referred to as "LT70") was measured. The results are shown in Table 4.

### <Examples D26 to D35 and Comparative Example CD4>

Fabrication and evaluation of light emitting devices D26 to D35 and CD4
Light emitting devices D26 to D35 and CD4 were fabricated in the same manner as in Example D25, except that materials described in Table 4 were used instead of "the compound HM-1, the metal complex B1 and the metal complex G2 (compound HM-1/metal complex B1/metal complex G2 = 74% by mass/25% by mass/1% by mass)" in (Formation of first light emitting layer) of Example D25.

Voltage was applied to the light emitting devices D26 to D35 and CD4, to observe EL emission. The CIE chromaticity coordinate (x,y) at 3000 cd/m² and the measurement results of LT70 are shown in Table 4.

**[Table 4]**

| | Light emitting device | first light emitting layer | | LT70 (hrs) | CIE chromaticity coordinate (x, y) |
|---|---|---|---|---|---|
| | | material | Composition ratio (% by mass) | | |
| Example D25 | D25 | HM-1/B1/G2 | 74/25/1 | 5.9 | (0.42,0.46) |
| Example D26 | D26 | HM-1/B2/G2 | 74/25/1 | 127.6 | (0.41,0.47) |
| Example D27 | D27 | HM-1/B3/G2 | 74/25/1 | 128.2 | (0.40,0.47) |
| Example D28 | D28 | HM-1/B4/G2 | 74/25/1 | 120.1 | (0.40,0.47) |
| Example D29 | D29 | HM-1/B5/G2 | 74/25/1 | 4.6 | (0.40,0.45) |
| Example D30 | D30 | HM-1/B6/G2 | 74/25/1 | 139.8 | (0.41,0.47) |
| Example D31 | D31 | HM-1/B7/G2 | 74/25/1 | 43.0 | (0.42,0.47) |
| Example D32 | D32 | HM-1/B8/G2 | 74/25/1 | 91.7 | (0.39,0.47) |
| Example D33 | D33 | HM-1/B9/G2 | 74/25/1 | 126.2 | (0.40,0.48) |
| Example D34 | D34 | HM-1/B10/G2 | 74/25/1 | 119.7 | (0.42,0.45) |
| Example D35 | D35 | HM-1/B11/G2 | 74/25/1 | 141.7 | (0.45,0.46) |
| Comparative Example CD4 | CD4 | HM-1/BC2/G2 | 74/25/1 | 0.5 | (0.42,0.45) |

### Industrial Applicability

According to the present invention, a composition which is useful for production of a light emitting device excellent in luminance life can be provided. Further, according to the present invention, a light emitting device comprising this composition can be provided.

## Claims

1. A composition comprising a metal complex represented by the formula (1) and a metal complex represented by the formula (2): 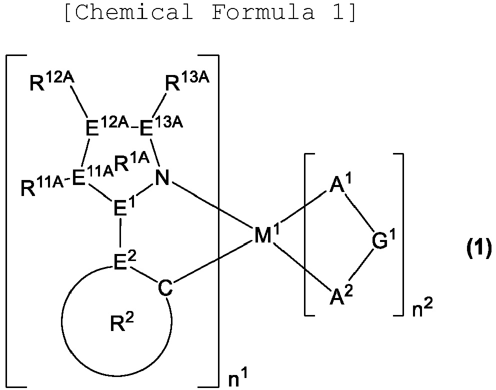 wherein,
M¹ represents a rhodium atom, a palladium atom, an iridium atom or a platinum atom,
n¹ represents an integer of 1 or more and n² represents an integer of 0 or more, provided that n¹ + n² is 3 when M¹ is a rhodium atom or an iridium atom, while n¹ + n² = 2 when M¹ is a palladium atom or a platinum atom,
Ring R^{1A} represents a diazole ring, a triazole ring or a tetrazole ring,
Ring R² represents an aromatic hydrocarbon ring or an aromatic hetero ring, and the foregoing rings optionally have a substituent, and when a plurality of said substituents are present, they may be combined together to form a ring together with atoms to which they are attached, and when a plurality of Ring R² are present, they may be the same or different,
E¹, E², E^{11A}, E^{12A} and E^{13A} each independently represent a nitrogen atom or a carbon atom, and when a plurality of E¹, E², E^{11A}, E^{12A} and E^{13A} are present, they may be the same or different at each occurrence, at least one of E¹ and E² is a carbon atom,
R^{11A}, R^{12A} and R^{13A} each independently represent a hydrogen atom, an alkyl group, a cycloalkyl group, an alkoxy group, a cycloalkoxy group, an aryl group, an aryloxy group, a monovalent hetero ring group, a substituted amino group or a halogen atom, and the foregoing groups optionally have a substituent, and when a plurality of R^{11A}, R^{12A} and R^{13A} are present, they may be the same or different at each occurrence,
at least one of E^{11A}, E^{12A} and E^{13A} is a nitrogen atom, and at least one of R^{11A}, R^{12A} and R^{13A} bonding to the nitrogen atom is a group represented by the formula (Ar-1A),
R^{11A} and R^{12A} may be combined together to form a ring together with atoms to which they are attached, R^{12A} and R^{13A} may be combined together to form a ring together with atoms to which they are attached, and a substituent which Ring R² optionally has and R^{11A} may be combined together to form a ring together with atoms to which they are attached,
when E^{11A} is a nitrogen atom, R^{11A} may be present or absent, when E^{12A} is a nitrogen atom, R^{12A} may be present or absent, and when E^{13A} is a nitrogen atom, R^{13A} may be present or absent,
A¹-G¹-A² represents an anionic bidentate ligand, A¹ and A² each independently represent a carbon atom, an oxygen atom or a nitrogen atom, and these atoms may be ring-constituent atoms, G¹ represents a single bond or an atomic group constituting a bidentate ligand together with A¹ and A², and when a plurality of A¹-G¹-A² are present, they may be the same or different, 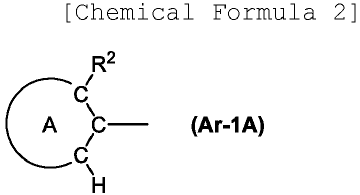
wherein,
Ring A represents an aromatic hydrocarbon ring or an aromatic hetero ring, and the foregoing rings optionally have a substituent, and when a plurality of said substituents are present, they may be combined together to form a ring together with atoms to which they are attached,
R² represents an alkyl group, a cycloalkyl group, an alkoxy group, a cycloalkoxy group, an aryl group, an aryloxy group, a monovalent hetero ring group, a substituted amino group or a halogen atom, and the foregoing groups optionally have a substituent, 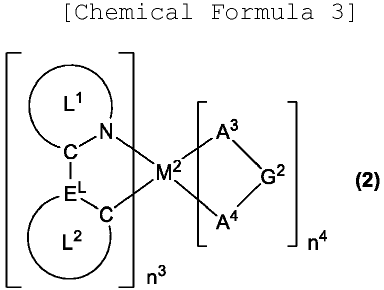
wherein,
M² represents a rhodium atom, a palladium atom, an iridium atom or a platinum atom,
n³ represents an integer of 1 or more and n⁴ represents an integer of 0 or more, provided that n³ + n⁴ = 3 when M² is a rhodium atom or an iridium atom, while n³ + n⁴ is 2 when M² is a palladium atom or a platinum atom,
E^{L} represents a carbon atom or a nitrogen atom, and when a plurality of E^{L} are present, they may be the same or different at each occurrence,
Ring L¹ represents a 6-membered aromatic hetero ring, and this ring optionally has a substituent, and when a plurality of said substituents are present, they may be combined together to form a ring together with atoms to which they are attached, and when a plurality of Ring L¹ are present, they may be the same or different,
Ring L² represents an aromatic hydrocarbon ring or an aromatic hetero ring, and the foregoing rings optionally have a substituent, and when a plurality of said substituents are present, they may be combined together to form a ring together with atoms to which they are attached, and when a plurality of Ring L² are present, they may be the same or different,
the substituent which Ring L¹ optionally has and the substituent which Ring L² optionally has may be combined together to form a ring together with atoms to which they are attached,
at least one of Ring L¹ and Ring L² has a group represented by the formula (1-T), and when a plurality of the groups represented by the formula (1-T) are present, they may be the same or different,
A³-G²-A⁴ represents an anionic bidentate ligand, A³ and A⁴ each independently represent a carbon atom, an oxygen atom or a nitrogen atom, and these atoms may be ring-constituent atoms, G² represents a single bond or an atomic group constituting a bidentate ligand together with A³ and A⁴, and when a plurality of A³-G²-A⁴ are present, they may be the same or different,
[Chemical Formula 4] **-R^{1T} (1-T)**
wherein, R^{1T} represents an alkyl group, a cycloalkyl group, an alkoxy group, a cycloalkoxy group, an aryloxy group, an aryl group, a monovalent hetero ring group, a substituted amino group or a halogen atom, and the foregoing groups optionally have a substituent.

2. The composition according to Claim 1, wherein said metal complex represented by the formula (1) is a metal complex represented by the formula (1-A1) or the formula (1-A2): 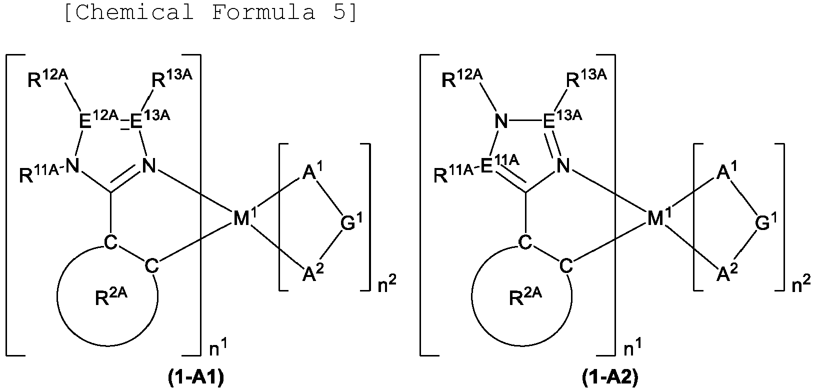
wherein, M¹, n¹, n², R^{11A}, R^{12A}, R^{13A}, E^{11A}, E^{12A}, E^{13A} and A¹-G¹-A² represent the same meaning as described above,
Ring R^{2A} represents a benzene ring, a fluorene ring, a spirobifluorene ring, a dihydrophenanthrene ring, a pyridine ring, a diazabenzene ring, a carbazole ring, a dibenzofuran ring or a dibenzothiophene ring, and the foregoing rings optionally have a substituent, and when a plurality of said substituents are present, they may be combined together to form a ring together with atoms to which they are attached, and when a plurality of Ring R^{2A} are present, they may be the same or different,
the substituent which Ring R^{2A} optionally has and R^{11A} may be combined together to form a ring together with atoms to which they are attached,
in the formula (1-A1), at least one of R^{11A} is said group represented by the formula (Ar-1A), and in the formula (1-A2), at least one of R^{12A} is said group represented by the formula (Ar-1A).

3. The composition according to Claim 2, wherein said metal complex represented by the formula (1-A1) is a metal complex represented by the formula (1-A1-1), the formula (1-A1-2) or the formula (1-A1-3): 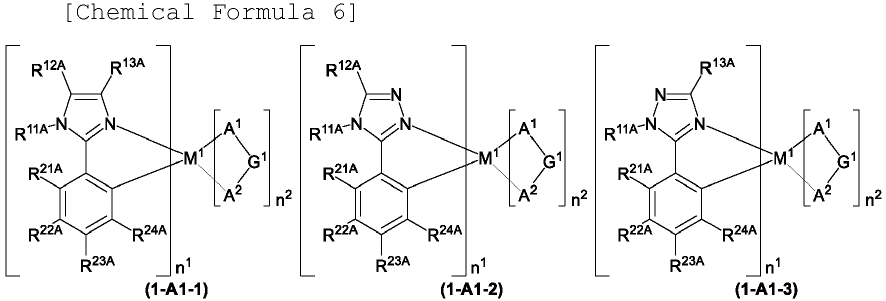
wherein, M¹, n¹, n², R^{11A}, R^{12A}, R^{13A} and A¹-G¹-A² represent the same meaning as described above,
R^{21A}, R^{22A}, R^{23A} and R^{24A} each independently represent a hydrogen atom, an alkyl group, a cycloalkyl group, an alkoxy group, a cycloalkoxy group, an aryl group, an aryloxy group, a monovalent hetero ring group, a substituted amino group or a halogen atom, and the foregoing groups optionally have a substituent, and when a plurality of R^{21A}, R^{22A}, R^{23A} and R^{24A} are present, they may be the same or different at each occurrence, R^{21A} and R^{22A}, R^{22A} and R^{23A}, R^{23A} and R^{24A}, and, R^{11A} and R^{21A} each may be combined together to form a ring together with atoms to which they are attached.

4. The composition according to Claim 2, wherein said metal complex represented by the formula (1-A2) is a metal complex represented by the formula (1-A2-1) or the formula (1-A2-2): 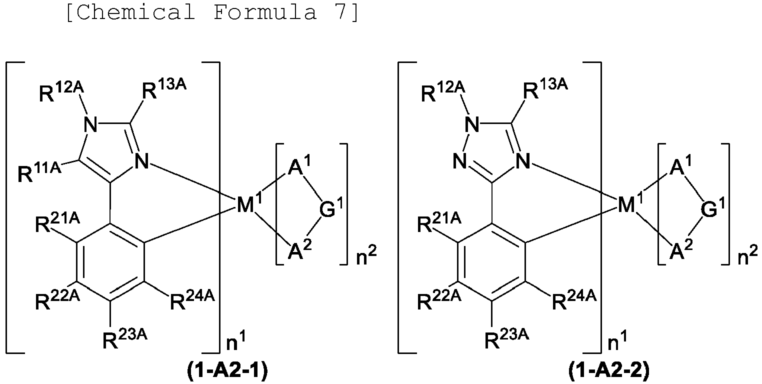
wherein, M¹, n¹, n², R^{11A}, R^{12A}, R^{13A} and A¹-G¹-A² represent the same meaning as described above,
R^{21A}, R^{22A}, R^{23A} and R^{24A} each independently represent a hydrogen atom, an alkyl group, a cycloalkyl group, an alkoxy group, a cycloalkoxy group, an aryl group, an aryloxy group, a monovalent hetero ring group, a substituted amino group or a halogen atom, and the foregoing groups optionally have a substituent, and when a plurality of R^{21A}, R^{22A}, R^{23A} and R^{24A} are present, they may be the same or different at each occurrence, R^{21A} and R^{22A}, R^{22A} and R^{23A}, R^{23A} and R^{24A}, and, R^{11A} and R^{21A} each may be combined together to form a ring together with atoms to which they are attached.

5. The light emitting device according to any one of Claims 1 to 4, wherein said group represented by the formula (Ar-1A) is a group represented by the formula (Ar-2A) : 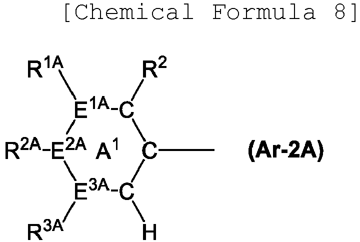
wherein, R² represents the same meaning as described above,
Ring A¹ represents a benzene ring, a pyridine ring or a diazabenzene ring,
E^{1A}, E^{2A} and E^{3A} each independently represent a nitrogen atom or a carbon atom, when E^{1A} is a nitrogen atom, R^{1A} is absent, when E^{2A} is a nitrogen atom, R^{2A} is absent, and when E^{3A} is a nitrogen atom, R^{3A} is absent,
R^{1A}, R^{2A} and R^{3A} each independently represent a hydrogen atom, an alkyl group, a cycloalkyl group, an alkoxy group, a cycloalkoxy group, an aryl group, an aryloxy group, a monovalent hetero ring group, a substituted amino group or a halogen atom, and the foregoing groups optionally have a substituent,
R^{1A} and R^{2A}, and, R^{2A} and R^{3A} each may be combined together to form a ring together with atoms to which they are attached.

6. The light emitting device according to Claim 5, wherein said group represented by formula (Ar-2A) is a group represented by the formula (Ar-3A): 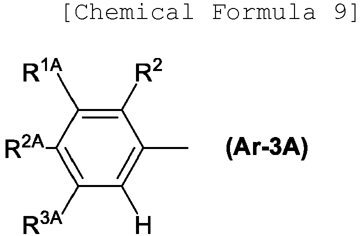 wherein, R², R^{1A}, R^{2A} and R^{3A} represent the same meaning as described above.

7. The composition according to any one of Claims 1 to 6, wherein said metal complex represented by the formula (2) is a metal complex represented by the formula (2-B): 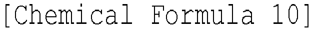 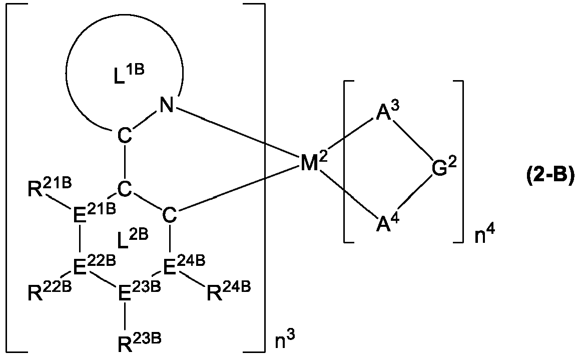 wherein,
M², n³, n⁴ and A³-G²-A⁴ represent the same meaning as described above,
Ring L^{1B} represents a pyridine ring, a diazabenzene ring, an azanaphthalene ring or a diazanaphthalene ring, and the foregoing rings optionally have a substituent, and when a plurality of said substituents are present, they may be combined together to form a ring together with atoms to which they are attached, and when a plurality of Ring L^{1B} are present, they may be the same or different,
E^{21B}, E^{22B}, E^{23B} and E^{24B} each independently represent a nitrogen atom or a carbon atom, and when a plurality of E^{21B}, E^{22B}, E^{23B} and E^{24B} are present, they may be the same or different at each occurrence, when E^{21B} is a nitrogen atom, R^{21B} is absent, when E^{22B} is a nitrogen atom, R^{22B} is absent, when E^{23B} is a nitrogen atom, R^{23B} is absent, and when E^{24B} is a nitrogen atom, R^{24B} is absent,
R^{21B}, R^{22B}, R^{23B} and R^{24B} each independently represent a hydrogen atom or said group represented by the formula (1-T), and when a plurality of R^{21B}, R^{22B}, R^{23B} and R^{24B} are present, they may be the same or different at each occurrence, R^{21B} and R^{22B}, R^{22B} and R^{23B}, R^{23B} and R^{24B}, and, a substituent which Ring L^{1B} optionally has and R^{21B} each may be combined together to form a ring together with atoms to which they are attached, at least one of Ring L^{1B} has the group represented by the formula (1-T), or, at least one of R^{21B}, R^{22B}, R^{23B} and R^{24B} is said group represented by the formula (1-T),
Ring L^{2B} represents a benzene ring, a pyridine ring or a diazabenzene ring.

8. The composition according to Claim 7, wherein said metal complex represented by the formula (2-B) is a metal complex represented by the formula (2-B1), the formula (2-B2), the formula (2-B3), the formula (2-B4) or the formula (2-B5): 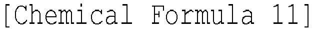 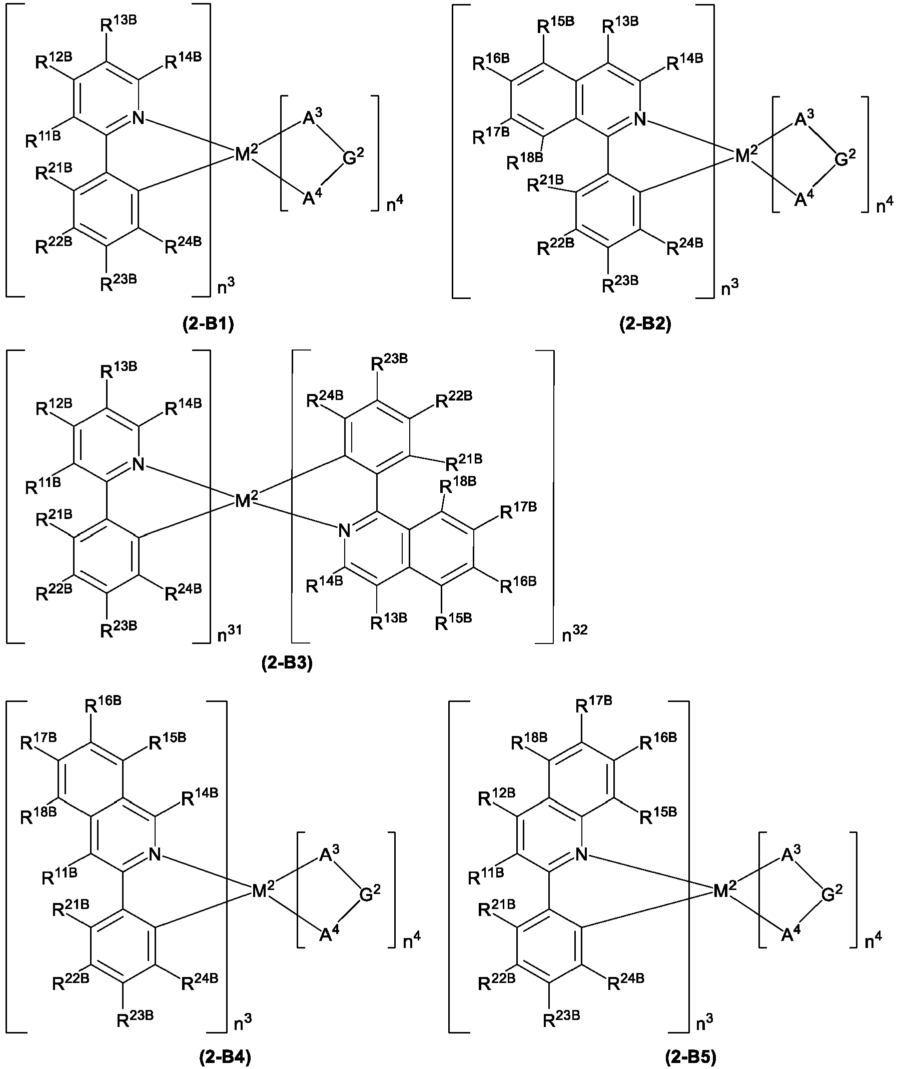 wherein,
M², n³, n⁴, R^{21B}, R^{22B}, R^{23B}, R^{24B} and A³-G²-A⁴ represent the same meaning as described above,
n³¹ and n³² each independently represent an integer of 1 or more, provided that n³¹+n³² is 3 when M² is a rhodium atom or an iridium atom, while n³¹+n³² is 2 when M² is a palladium atom or a platinum atom,
R^{11B}, R^{12B}, R^{13B}, R^{14B}, R^{15B}, R^{16B}, R^{17B} and R^{18B} each independently represent a hydrogen atom or said group represented by the formula (1-T), and when a plurality of R^{11B}, R^{12B}, R^{13B}, R^{14B}, R^{15B}, R^{16B}, R^{17B} and R^{18B} are present, they may be the same or different at each occurrence, at least one of R^{11B}, R^{12B}, R^{13B}, R^{14B}, R^{15B}, R^{16B}, R^{17B}, R^{18B}, R^{21B}, R^{22B}, R^{23B} and R^{24B} is said group represented by the formula (1-T),
in the formula (2-B1) and the formula (2-B3), R^{11B} and R^{12B}, R^{12B} and R^{13B}, R^{13B} and R^{14B}, and, R^{11B} and R^{21B} each may be combined together to form a ring together with atoms to which they are attached, in the formula (2-B2) and the formula (2-B3), R^{13B} and R^{14B}, R^{13B} and R^{15B}, R^{15B} and R^{16B}, R^{16B} and R^{17B}, R^{17B} and R^{18B}, and, R^{18B} and R^{21B} each may be combined together to form a ring together with atoms to which they are attached, in the formula (2-B4), R^{11B} and R^{18B}, R^{14B} and R^{15B}, R^{15B} and R^{16B}, R^{16B} and R^{17B}, R^{17B} and R^{18B}, and, R^{11B} and R^{21B} each may be combined together to form a ring together with atoms to which they are attached, and in the formula (2-B5), R^{11B} and R^{12B}, R^{12B} and R^{18B}, R^{15B} and R^{16B}, R^{16B} and R^{17B}, R^{17B} and R^{18B}, and, R^{11B} and R^{21B} each may be combined together to form a ring together with atoms to which they are attached.

9. The composition according to any one of Claims 1 to 8, wherein said R^{1T} is an alkyl group optionally having a substituent, a cycloalkyl group optionally having a substituent, a group represented by the formula (D-A), a group represented by the formula (D-B) or a group represented by the formula (D-C): 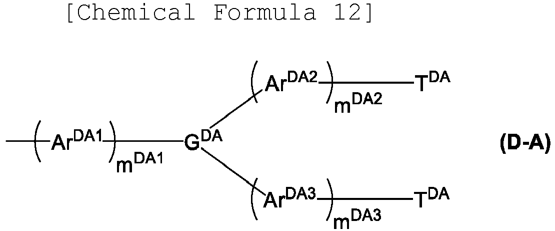 wherein,
m^{DA1}, m^{DA2} and m^{DA3} each independently represent an integer of 0 or more,
G^{DA} represents a nitrogen atom, an aromatic hydrocarbon group or a hetero ring group, and the foregoing groups optionally have a substituent,
Ar^{DA1}, Ar^{DA2} and Ar^{DA3} each independently represent an arylene group or a divalent hetero ring group, and the foregoing groups optionally have a substituent, and when a plurality of Ar^{DA1}, Ar^{DA2} and Ar^{DA3} are present, they may be the same or different at each occurrence,
T^{DA} represents an aryl group or a monovalent hetero ring group, and the foregoing groups optionally have a substituent, a plurality of T^{DA} may be the same or different, 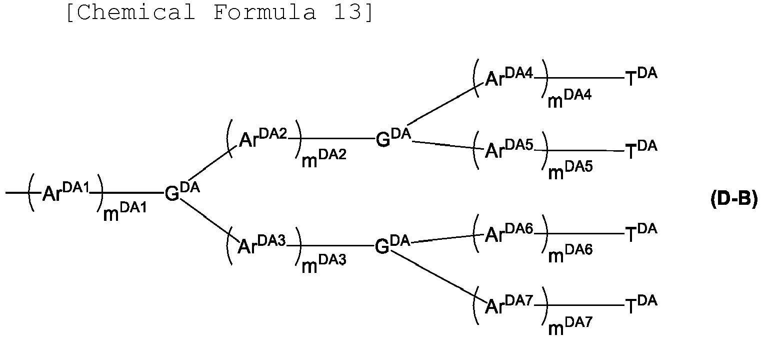
wherein,
m^{DA1}, m^{DA2}, m^{DA3}, m^{DA4}, m^{DA5}, m^{DA6} and m^{DA7} each independently represent an integer of 0 or more,
G^{DA} represents a nitrogen atom, an aromatic hydrocarbon group or a hetero ring group, and the foregoing groups optionally have a substituent, a plurality of G^{DA} may be the same or different,
Ar^{DA1}, Ar^{DA2}, Ar^{DA3}, Ar^{DA4}, Ar^{DA5}, Ar^{DA6} and Ar^{DA7} each independently represent an arylene group or a divalent hetero ring group, and the foregoing groups optionally have a substituent, and when a plurality of Ar^{DA1}, Ar^{DA2}, Ar^{DA3}, Ar^{DA4}, Ar^{DA5}, Ar^{DA6} and Ar^{DA7} are present, they may be the same or different at each occurrence,
T^{DA} represents an aryl group or a monovalent hetero ring group, and the foregoing groups optionally have a substituent, a plurality of T^{DA} may be the same or different, 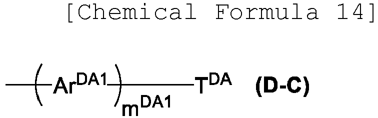
wherein,
m^{DA1} represents an integer of 0 or more,
Ar^{DA1} represents an arylene group or a divalent hetero ring group, and the foregoing groups optionally have a substituent, and when a plurality of Ar^{DA1} are present, they may be the same or different,
T^{DA} represents an aryl group or a monovalent hetero ring group, and the foregoing groups optionally have a substituent.

10. The composition according to any one of Claims 1 to 9, wherein the maximum peak wavelength of the emission spectrum of said metal complex represented by the formula (1) is 380 nm or more and less than 495 nm, and the maximum peak wavelength of the emission spectrum of said metal complex represented by the formula (2) is 495 nm or more and less than 750 nm.

11. The composition according to any one of Claims 1 to 10, comprising two or more of said metal complexes represented by the formula (2).

12. The composition according to any one of Claims 1 to 11, wherein the total content of said metal complexes represented by the formula (2) is 0.01 part by mass or more and 50 parts by mass or less when the total content of said metal complexes represented by the formula (1) is taken as 100 parts by mass.

13. The composition according to any one of Claims 1 to 12, further comprising a compound represented by the formula (H-1): 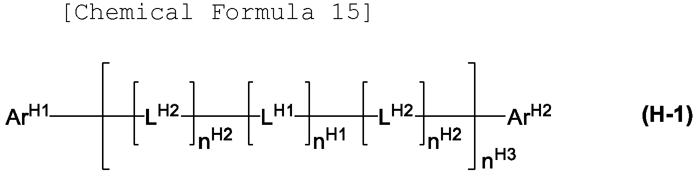 wherein,
Ar^{H1} and Ar^{H2} each independently represent an aryl group or a monovalent hetero ring group, and the foregoing groups optionally have a substituent,
n^{H1} and n^{H2} each independently represent 0 or 1, and when a plurality of n^{H1} are present, they may be the same or different, a plurality of n^{H2} may be the same or different,
n^{H3} represents an integer of 0 or more and 10 or less,
L^{H1} represents an arylene group, a divalent hetero ring group or a group represented by -[C(R^{H11})₂]n^{H11}-, and the foregoing groups optionally have a substituent, and when a plurality of L^{H1} are present, they may be the same or different, n^{H11} represents an integer of 1 or more and 10 or less, R^{H11} represents a hydrogen atom, an alkyl group, a cycloalkyl group, an alkoxy group, a cycloalkoxy group, an aryl group or a monovalent hetero ring group, and the foregoing groups optionally have a substituent, a plurality of R^{H11} may be the same or different, and they may be combined together to form a ring together with carbon atoms to which they are attached,
L^{H2} represents a group represented by -N(-L^{H21}-R^{H21})-, and when a plurality of L^{H2} are present, they may be the same or different, L^{H21} represents a single bond, an arylene group or a divalent hetero ring group, and the foregoing groups optionally have a substituent, R^{H21} represents a hydrogen atom, an alkyl group, a cycloalkyl group, an aryl group or a monovalent hetero ring group, and the foregoing groups optionally have a substituent.

14. The composition according to any one of Claims 1 to 13, further comprising at least one selected from group consisting of a hole transporting material, a hole injection material, an electron transporting material, electron an injection material, a light emitting material, an antioxidant and a solvent.

15. A light emitting device comprising the composition according to any one of Claims 1 to 13.
